# EUROPEAN PATENT APPLICATION

(11) **EP 4 734 719 A1**
(43) Date of publication of application: **29.04.2026**
(21) Application number: 24208375.6
(22) Date of filing: 23.10.2024
(51) Int. Cl.: H10K 39/34, H10K 85/60

(54) **DISPLAY COMPRISING AN ORGANIC PHOTODETECTOR AND AN ORGANIC LIGHT EMITTING DEVICE**

(71) Applicant: Novaled GmbH, 01099 Dresden (DE)
(72) Inventor: Werner, Ansgar, 01099 Dresden (DE); Runge, Steffen, 01099 Dresden (DE); Cheng, Huan, 01099 Dresden (DE)
(74) Representative: Michalski Hüttermann & Partner Patentanwälte mbB

(57) **Abstract**

The present invention relates to a display comprising an organic photodetector and an organic light emitting device as well as to uses and methods of operating said display.

## Description

### Technical Field

The present invention relates to a display comprising an organic photodetector and an organic light emitting device as well as to uses and methods of operating said display.

### Background Art

Modern displays of touch-sensitive devices (such as smartphone or tablets) can contain pixels made of organic light-emitting devices for displaying a picture. Further, the display may comprise an organic photodetector in order to measure e.g. a finger print and/or the pulse, so that the functionality of the display is enhanced.

In such displays in general but in particular when containing an organic photodetector in addition to an organic light-emitting device, there is a high lateral leakage, and thus a high cross-talk between the organic light-emitting devices and/ or organic photodetector devices. A cross-talk between the devices in a display results a reduced resolution of the display or a distortion of color representation especially at low brightness. The sensitivity of organic photodetector devices is also reduced.

Thus there is the need to provide improved displays, especially concerning one or more of the following: low dark current density, a high photocurrent density when exposed to light or irradiation, high signal to noise ratio, a low lateral leakage and/or a low cross-talk.

### DISCLOSURE

An aspect of the present invention provides a display comprising a substrate, a first pixel, and a second pixel,
wherein the first pixel comprises an organic photodetector,
wherein the second pixel comprises an organic light-emitting device;
wherein the organic photodetector is disposed directly on the substrate and the organic light-emitting device is disposed directly on the substrate;
wherein the organic photodetector comprises comprising a first semiconductor layer, a second semiconductor layer; a intermediate layer system; a substrate, a first electrode; and a second electrode;
wherein the intermediate layer system is arranged between the first semiconductor layer and the second semiconductor layer and comprises one or more layers.
wherein the first semiconductor layer is arranged closer to first electrode than the second semiconductor layer;
wherein the first semiconductor layer is arranged between the first electrode and the intermediate layer system, and in direct contact to the intermediate layer system;
wherein the second semiconductor layer is arranged between the second electrode and the intermediate layer system, and in direct contact to the intermediate layer system;
wherein the first semiconductor layer comprises a first compound which comprises an arylamine moiety;
wherein the second semiconductor layer comprises a second compound different from the first compound which comprises a mono-6-membered heteroaryl;
wherein the mono-6-membered heteroaryl comprises one, two, three or more nitrogen atoms;
wherein the intermediate layer system comprises a third compound different from the first compound and which is either a donor or acceptor compound.
wherein the intermediate layer system comprises a fourth compound different from the second and third compound, is in direct contact to the second semiconductor layer and comprises an arylamine moiety;
wherein the intermediate layer system comprises a photoconversion unit,
wherein the photoconversion unit comprises an electron donor compound and an electron acceptor compound in direct contact to each other, wherein the LUMO energy level of the electron donor compound is larger than the LUMO energy level of the electron acceptor compound;
wherein the electron donor compound or the electron acceptor compound absorbs light in the visible and/or in the near-infrared region.

It should be noted that throughout the application and the claims any R^{k} etc. always refer to the same moieties, unless otherwise noted.

It should be noted that throughout the application and the claims the term "substituents", unless otherwise noted, are meant to be selected from H, D, halogen, Cl, F, CN, NO₂, C₁ to C₁₂ alkyl, C₁ to C₁₂ alkoxy, partially or perfluorinated C₁ to C₁₂ alkyl, CF₃, CF₂H, partially or perfluorinated C₁ to C₁₂ alkoxy, or a combination thereof.

Throughout the applications and the claims the term "ring system" shall especially mean that adjacent rings share two common atoms.

In the present specification, when a definition is not otherwise provided, "partially fluorinated" refers to an alkyl group or an alkoxy group in which only part of the hydrogen atoms are replaced by fluorine atoms.

In the present specification, when a definition is not otherwise provided, "perfluorinated" refers to an alkyl group or an alkoxy group in which all hydrogen atoms are replaced by fluorine atoms.

In the present specification, when a definition is not otherwise provided, "substituted" refers to one substituted with a deuterium, C₁ to C₁₂ alkyl and C₁ to C₁₂ alkoxy.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a C₁ to C₁₂ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an iso-propyl group, a butyl group, an iso-butyl group, a tert-butyl group, a pentyl group, a hexyl group.

In the context of the present invention, "ⁱCₙH₍₂ₙ₊₁₎" denotes an iso-alkyl group and "ⁱCₙF₍₂ₙ₊₁₎" denotes a perfluorinated iso-alkyl group.

The term "cycloalkyl" refers to saturated hydrocarbyl groups derived from a cycloalkane by formal abstraction of one hydrogen atom from an atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

For the purposes of this invention, an aromatic or heteroaromatic ring system is intended to be taken to mean a system which does not necessarily contain only one aryl or one heteroaryl group or only aryl or heteroaryl groups, but instead in which a plurality of aryl or heteroaryl groups may also be interrupted by a short non-aromatic unit (preferably less than 10 percent of the atoms other than H), such as, for example, an sp³-hybridised C, N or O atom. Thus, for example, systems such as 9,9'-spirobifluorene, 9,9-diarylfluorene, triarylamine, diaryl ether, stilbene, benzophenone, etc., are also intended to be taken to mean aromatic ring systems for the purposes of this invention. Likewise, an aromatic or heteroaromatic ring system is taken to mean systems in which a plurality of aryl or heteroaryl groups are linked to one another by single bonds, for example biphenyl, terphenyl or bipyridine.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphthyl or fluorenyl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated heterocycloalkane ring in a compound comprising at least one such ring.

The term "fused aryl rings" or "condensed aryl rings" is understood the way that two aryl rings are considered fused or condensed when they share at least two common sp²-hybridized carbon atoms

In the present specification, the single bond refers to a direct bond.

In the context of the present invention, "different" means that the compounds do not have an identical chemical structure.

The term "free of", "does not contain", "does not comprise" does not exclude impurities which may be present in the compounds prior to deposition. Impurities have no technical effect with respect to the object achieved by the present invention.

The term "consisting essentially of' especially means and/or includes at least 90% (wt/wt), more preferred at least 95% (wt/wt) and most preferred at least 98% (wt/wt).

The term "contacting sandwiched" refers to an arrangement of three layers whereby the layer in the middle is in direct contact with the two adjacent layers.

The term "adjacent" in the context of layers especially means that one or two layers may be present between the adjacent layers.

The term "shared" and/or "common" in the context of layers especially means that the layer that is "shared" or "common" forms part of the device(s) that share the layer.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms anode, anode layer and anode electrode are used synonymously.

The terms cathode, cathode layer and cathode electrode are used synonymously.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

The term "LUMO level" is understood to mean the lowest unoccupied molecular orbital and is determined in eV (electron volt). The LUMO level may also be named "LUMO" or "LUMO energy level".

The term "LUMO level further away from vacuum level" is understood to mean that the absolute value of the LUMO level is higher than the absolute value of the LUMO level of the reference compound.

The term "HOMO level" is understood to mean the highest occupied molecular orbital and is determined in eV (electron volt). The HOMO level may also be named "HOMO" or "HOMO energy level". The term "HOMO level further away from vacuum level" is understood to mean that the absolute value of the HOMO level is higher than the absolute value of the HOMO level of the reference compound. For example, the term "HOMO level of the matrix compound of the hole injection layer" further away from vacuum level than the HOMO level of N2,N2,N2',N2',N7,N7,N7',N7'-octakis(4-methoxyphenyl)-9,9'-spirobi[fluorene]-2,2',7,7'-tetraamine" is understood to mean that the absolute value of the HOMO level of the matrix compound of the hole injection layer is higher than the HOMO level of N2,N2,N2',N2', N7,N7, N7',N7'-octakis(4-methoxyphenyl)-9,9'-spirobi[fluorene]-2,2',7,7'-tetraamine.

The term "absolute value" is understood to mean the value without the "- "symbol if present. According to one embodiment of the present invention, the HOMO level of the matrix compound of the hole injection layer may be calculated by quantum mechanical methods.

The term "hole blocking properties" especially relates to a property to reduce the movement of holes into the photoconversion unit.

The term "electron blocking properties" especially relates to a property to reduce the movement of electrons into the photoconversion unit. The term "visible light" especially means the wavelength area of 400nm to 750nm

The term "near-infrared" especially means the wavelength area of 750nm to 3000nm,.

### Advantageous Effects

Surprisingly, it was found that many displays falling under the present invention can be driven by applying a positive voltage with a low dark current, a high photocurrent density when exposed to light, and a high signal to noise ratio.

Also, it has been found out - and this is an embodiment of the present invention - that with a display according to the invention in operation a positive voltage is applied both on the organic photodetector and on the organic light-emitting device.

This shall be explained a bit more in detail:
For an organic photodetector, the application of a positive voltage or a negative voltage is conceivable.

When applying a positive voltage the electrons are forced to flow from the cathode to the anode, i.e. electrons from the cathode flow in the direction of the photoconversion layer and electrons will flow from the photoconversion layer to the anode.

When applying a negative voltage the electrons are forced to flow from the anode to the cathode, i.e. electrons from the anode will flow in the direction of the photoconversion layer and electrons will flow from the photoconversion layer to the cathode.

In an OLED display, the work function of anode is typically higher than the work function of cathode. When applying positive voltage to the conventional organic photodetector, electrons and holes are injected easily from cathode and anode, respectively. The electrons and holes can pass through the layers of the conventional organic photodetector easily. A high current is flowing already in the absence of light, i.e. the conventional organic photodetector has high dark current and low signal-to-noise ratio when operated with a positive voltage.

Thus, a negative voltage will usually be applied on an organic photodetector in particular on an organic photodetector included in a display.

As a result in a display device usually a positive voltage is applied on the organic light-emitting device and a negative voltage is applied on the organic photodetector for the reasons as mentioned above. However, due to the application of a positive voltage and a negative voltage to devices which have a close spatial arrangement, a high voltage difference is generated which in many cases results in a high electrical field between neighboring OLED and organic photodetector pixels. The high electric field induces current flowing from OLED pixel to organic photodetector pixel. This current can lead to high dark current in the organic photodetector pixel even in the absence of light. Thus, signal to noise ratio of the organic photodetector pixel is reduced. A cross-talk between the devices in a display can lead to a reduced resolution of the display or a distortion of color representation especially at low brightness.

The present invention allows, however, for many displays the operation of positive voltage both on the organic photodetector, and on the organic light-emitting device, thus at least partly avoiding such drawbacks.

According to an embodiment, the display further comprises one or more voltage source, wherein the one or more voltage source is adapted as such that a positive voltage can be generated, wherein one of one or more voltage source is connected to the organic photodetector, and wherein one of the one or more voltage source is connected to the organic light-emitting device.

According to an embodiment, the display further comprises one or more voltage sources, wherein the one or more voltage sources is adapted as such that a positive voltage can be generated, wherein one of one or more voltage sources is connected to the first pixel, and wherein one of the one or more voltage sources is connected to the second pixel.

According to an embodiment, the display further comprises a voltage source, wherein the voltage source is adapted as such that a positive voltage can be generated, wherein the voltage source is connected to the organic photodetector, and wherein the voltage source is connected to the organic light-emitting device.

According to an embodiment, the display further comprises a voltage source, wherein the voltage source is adapted as such that a positive voltage can be generated, wherein the voltage source is connected to the first pixel, and wherein the voltage source is connected to the second pixel.

According to an embodiment, the display further comprises only one voltage source, wherein the only one voltage source is adapted as such that a positive voltage can be generated, wherein the only one voltage source is connected to the organic photodetector, and wherein the only one voltage source is connected to the organic light-emitting device.

According to an embodiment, the display further comprises only one voltage source, wherein the only one voltage source is adapted as such that a positive voltage can be generated, wherein the only one voltage source is connected to the first pixel, and wherein the only one voltage source is connected to the second pixel.

According to an embodiment, the display further comprises a first voltage source, and a second voltage source, wherein the first voltage source is adapted as such that a positive voltage can be generated, wherein the second voltage source is adapted as such that a positive voltage can be generated, wherein the first voltage source is connected to the organic photodetector, and wherein the second voltage source is connected to the organic light-emitting device.

According to an embodiment, the display further comprises a first voltage source, and a second voltage source, wherein the first voltage source is adapted as such that a positive voltage can be generated, wherein the second voltage source is adapted as such that a positive voltage can be generated, wherein the first voltage source is connected to the first pixel, and wherein the second voltage source is connected to the second pixel.

Another aspect of the present invention is related to an electronic device comprising a display and one or more voltage sources,
wherein the display comprises a substrate, a first pixel, and a second pixel,
wherein the first pixel comprises an organic photodetector;
wherein the second pixel comprises an organic light-emitting device;
wherein the organic photodetector is disposed directly on the substrate and the organic light-emitting device is disposed directly on the substrate;
   wherein the one or more voltage sources is adapted as such that a positive voltage can be generated,
   wherein one of one or more voltage sources out of said voltage sources that are adapted that a positive voltage can be generated is connected to the first pixel, and wherein one of the one or more voltage sources out of said voltage sources that are adapted that a positive voltage can be generated is connected to the second pixel.

According to one embodiment, the display is a display as described before, whereby all limitations and embodiments apply *mutatis mutandis.*

Another aspect of the present invention is related to an electronic device comprising a display according to the present invention, one or more voltage source, wherein the one or more voltage source is adapted as such that a positive voltage can be generated, wherein one of one or more voltage source out of said voltage sources that are adapted that a positive voltage can be generated is connected to the organic photodetector, and wherein one of the one or more voltage source out of said voltage sources that are adapted that a positive voltage can be generated is connected to the organic light-emitting device.

According to an embodiment, the electronic device comprises a display according to the present invention, one or more voltage source, wherein the one or more voltage source is adapted as such that a positive voltage can be generated, wherein one of one or more voltage source out of said voltage sources that are adapted that a positive voltage can be generated is connected to the first pixel, and wherein one of the one or more voltage source out of said voltage sources that are adapted that a positive voltage can be generated is connected to the second pixel.

According to an embodiment, the electronic device comprises a display according to the present invention and a voltage source, wherein the voltage source is adapted as such that a positive voltage can be generated, wherein the voltage source is connected to the organic photodetector, and wherein voltage source is connected to the organic light-emitting device.

According to an embodiment, the electronic device comprises a display according to the present invention and a voltage source, wherein the voltage source is adapted as such that a positive voltage can be generated, wherein the voltage source is connected to the first pixel, and wherein the voltage source is connected to the second pixel.

According to an embodiment, the electronic device comprises a display according to the present invention and only one voltage source, wherein the only one voltage source is adapted as such that a positive voltage can be generated, wherein the only one voltage source is connected to the organic photodetector, and wherein the only one voltage source is connected to the organic light-emitting device.

According to an embodiment, the electronic device comprises a display according to the present invention and only a voltage source, wherein the only one voltage source is adapted as such that a positive voltage can be generated, wherein the only one voltage source is connected to the first pixel, and wherein the only one voltage source is connected to the second pixel.

According to an embodiment, the electronic device comprises a display according to the present invention, a first voltage source, and a second voltage source, wherein the first voltage source is adapted as such that a positive voltage can be generated, wherein the second voltage source is adapted as such that a positive voltage can be generated, wherein the first voltage source is connected to the organic photodetector, and wherein the second voltage source is connected to the organic light-emitting device.

According to an embodiment, the electronic device comprises the display according to the present invention, a first voltage source, and a second voltage source, wherein the first voltage source is adapted as such that a positive voltage can be generated, wherein the second voltage source is adapted as such that a positive voltage can be generated, wherein the first voltage source is connected to the first pixel, and wherein the second voltage source is connected to the second pixel.

All restrictions and/or embodiments for the display may apply *mutatis mutandis for the display of the electronic device.*

The voltage source may be implemented as DC-DC-converter, converting a fixed supply voltage into desired voltage required for OPD operation. Type of suitable DC-DC-converter depends on relation of OPD operational voltage and supply voltage. For example buck-, boost-, inverting(buck boost)- or sepic-converters may be used.

Without being bound to any theory and going too much into detail, the inventors of the present invention believe that the following may occur:
Since a compound having an arylamine moiety is used as the first compound, a difference between the HOMO energy level of the first compound and the HOMO energy level of the third compound results, which in consequence leads to a "barrier" (in the following also to be referred as "HOMO barrier") for the movement of the electrons from the photoconversion unit in the direction of the first electrode. Similarly since the second compound has an aryl moiety with more than one nitrogen, whereas the fourth compound comprises - similar as the first compound - an aryl moiety, as a result a difference between the LUMO energy level of the fourth compound and the LUMO energy level of the second compound results, which as a consequence leads to a "barrier" (in the following to be referred as "LUMO barrier") for the movement of the electrons from the second electrode in the direction to the photoconversion unit. Both barriers together may lead to a low dark current, a high photocurrent density when exposed to light, and high signal to noise ratio when applying a positive Voltage.

Thus, the following invention relates also to the use of a display according to the invention for photodetection and displaying by applying a positive voltage on the organic photodetector, and applying a positive voltage on the organic light-emitting device

Additionally, the present invention relates to a method of operating a display according to the invention, including the step of applying positive voltage both on the organic photodetector and on the organic light-emitting device.

According to an embodiment, the first and fourth compound are identical.

According to an embodiment, the first and fourth compound are different.

According to an embodiment, the second and third compound are identical.

According to an embodiment, the second and third compound are different.

According to one embodiment, the difference between the HOMO energy level of the first compound and the HOMO energy level of the third compound is at least 0.25 eV;
wherein the difference between the LUMO energy level of the fourth compound and the LUMO energy level of the second compound is at least 0.2 eV;
wherein the compound in the first semiconductor layer having the largest HOMO energy level has a larger HOMO energy level than any compound contained in the layer of the intermediate layer system that is in direct contact to the first organic semiconductor layer;
wherein the compound in the second semiconductor layer having the smallest LUMO energy level has a smaller LUMO energy level than any compound contained in the layer of the intermediate layer system that is direct contact to the second organic semiconductor layer.

According to an embodiment, the difference between the LUMO energy level of any compound contained in the first semiconductor layer and the HOMO energy level of any compound contained in the layer of the intermediate layer system that is in direct contact to the first semiconductor layer is equal or larger than -0.2 eV; preferably -0.15 eV; and more preferably -0.1 eV. By doing so, undesired doping, especially of compounds contained in the intermediate layer system, can for many applications be reduced or avoided. In particular the dark current density may be reduced.

According to an embodiment, the difference between the HOMO energy level of the first compound and the HOMO energy level of the third compound is at least 0.3 eV, more preferred at least 0.4 eV, yet more preferred at least 0.5 eV, furthermore, preferred at least 0.6 eV; still preferred at least 0.7 eV, moreover preferred at least 0.8 eV; even more preferred at least 0.9 eV or at least 1.0 eV.

According to an embodiment, the difference between the LUMO energy level of the fourth compound and the LUMO energy level of the second compound is at least 0.3 eV, more preferred at least 0.4 eV, yet more preferred at least 0.5 eV, furthermore preferred at least 0.6 eV; still preferred at least 0.7 eV, moreover preferred at least 0.8 eV; even more preferred at least 0.9 eV or at least 1.0 eV.

According to an embodiment, the difference between the HOMO energy level of the first compound and the HOMO energy level of the third compound is at least 0.3 eV, and the difference between the LUMO energy level of the fourth compound and the LUMO energy level of the second compound is at least 0.3 eV;
preferably the difference between the HOMO energy level of the first compound and the HOMO energy level of the third compound is at least 0.4 eV, and the difference between the LUMO energy level of the fourth compound and the LUMO energy level of the second compound is at least 0.4 eV;
more preferably the difference between the HOMO energy level of the first compound and the HOMO energy level of the third compound is at least 0.5 eV, and the difference between the LUMO energy level of the fourth compound and the LUMO energy level of the second compound is at least 0.5 eV;
even more preferably the difference between the HOMO energy level of the first compound and the HOMO energy level of the third compound is at least 0.6 eV, and the difference between the LUMO energy level of the fourth compound and the LUMO energy level of the second compound is at least 0.6 eV; still more preferably the difference between the HOMO energy level of the first compound and the HOMO energy level of the third compound is at least 0.7 eV, and the difference between the LUMO energy level of the fourth compound and the LUMO energy level of the second compound is at least 0.7 eV;
even more preferably the difference between the HOMO energy level of the first compound and the HOMO energy level of the third compound is at least 0.8 eV, and the difference between the LUMO energy level of the fourth compound and the LUMO energy level of the second compound is at least 0.8 eV;
even more preferably the difference between the HOMO energy level of the first compound and the HOMO energy level of the third compound is at least 0.9 eV, and the difference between the LUMO energy level of the fourth compound and the LUMO energy level of the second compound is at least 0.9 eV;
and most preferably the difference between the HOMO energy level of the first compound and the HOMO energy level of the third compound is at least 1.0 eV, and the difference between the LUMO energy level of the fourth compound and the LUMO energy level of the second compound is at least 1.0 eV.

According to an embodiment, the difference between the HOMO energy level of the first compound and the HOMO energy level of the third compound is in the range of ≥0.25 eV to 4.0 eV; preferably ≥0.3 eV to 3.5 eV; more preferably ≥0.4 eV to 3.0 eV; even more preferably ≥0.5 eV to 3.0 eV; even more preferably ≥0.6 eV to 2.9 eV; even more preferably ≥0.7 eV to 2.8 eV; even more preferably ≥0.8 eV to 2.7 eV; even more preferably ≥0.9 eV to 2.6 eV; and most preferably ≥1.0 eV to 2.5 eV.

According to an embodiment, the difference between the LUMO energy level of the fourth compound and the LUMO energy level of the second compound is in the range of ≥0.2 eV to 4.0 eV; preferably ≥0.3 eV to 3.5 eV; more preferably ≥0.4 eV to 3.0 eV; even more preferably ≥0.5 eV to 3.0 eV; even more preferably ≥0.6 eV to 2.9 eV; even more preferably ≥0.7 eV to 2.8 eV; even more preferably ≥0.8 eV to 2.7 eV; even more preferably ≥0.9 eV to 2.6 eV; and most preferably ≥1.0 eV to 2.5 eV.

According to an embodiment, the difference between the HOMO energy level of the first compound and the HOMO energy level of the third compound is in the range of ≥0.25 eV to 4.0 eV; and
the difference between the LUMO energy level of the fourth compound and the LUMO energy level of the second compound is in the range of ≥0.2 eV to 4.0 eV.

According to an embodiment, the difference between the HOMO energy level of the first compound and the HOMO energy level of the third compound is in the range ≥0.3 eV to 3.5 eV; and
the difference between the LUMO energy level of the fourth compound and the LUMO energy level of the second compound is in the range of ≥0.3 eV to 3.5 eV.

According to an embodiment, the difference between the HOMO energy level of the first compound and the HOMO energy level of the third compound is in the range of ≥0.4 eV to 3.0 eV; and
the difference between the LUMO energy level of the fourth compound and the LUMO energy level of the second compound is in the range of ≥0.4 eV to 3.0 eV; even more preferably ≥0.5 eV to 3.0 eV.

According to an embodiment, the difference between the HOMO energy level of the first compound and the HOMO energy level of the third compound is in the range of ≥0.5 eV to 3.0 eV; and
the difference between the LUMO energy level of the fourth compound and the LUMO energy level of the second compound is in the range of ≥0.5 eV to 3.0 eV.

According to an embodiment, the difference between the HOMO energy level of the first compound and the HOMO energy level of the third compound is in the range of ≥0.6 eV to 2.9 eV; and
the difference between the LUMO energy level of the fourth compound and the LUMO energy level of the second compound is in the range of ≥0.6 eV to 2.9 eV.

According to an embodiment, the difference between the HOMO energy level of the first compound and the HOMO energy level of the third compound is in the range of ≥0.7 eV to 2.8 eV; and the difference between the LUMO energy level of the fourth compound and the LUMO energy level of the second compound is in the range of ≥0.7 eV to 2.8 eV.

According to an embodiment, the difference between the HOMO energy level of the first compound and the HOMO energy level of the third compound is in the range of ≥0.8 eV to 2.7 eV; and
the difference between the LUMO energy level of the fourth compound and the LUMO energy level of the second compound is in the range of ≥0.8 eV to 2.7 eV.

According to an embodiment, the difference between the HOMO energy level of the first compound and the HOMO energy level of the third compound is in the range of ≥0.9 eV to 2.6 eV; and
the difference between the LUMO energy level of the fourth compound and the LUMO energy level of the second compound is in the range of ≥0.9 eV to 2.6 eV; and most preferably ≥1.0 eV to 2.5 eV.

According to an embodiment, the difference between the HOMO energy level of the first compound and the HOMO energy level of the third compound is in the range of ≥1.0 eV to 2.5 eV; and
the difference between the LUMO energy level of the fourth compound and the LUMO energy level of the second compound is in the range of ≥1.0 eV to 2.5 eV.

According to an embodiment, the difference between the HOMO energy level of the compound in the first semiconductor layer having the largest HOMO energy level and the HOMO energy level of any compound contained in the layer of the intermediate layer system that is in direct contact to the first organic semiconductor layer is at least 0.25 eV; at least 0.3 eV; at least 0.4 eV; at least 0.5 eV; at least 0.6 eV; at least 0.7 eV, at least 0.8 eV; at least 0.9 eV or at least 1.0 eV.

According to an embodiment, the LUMO energy level of any compound contained in the layer of the intermediate layer system which is in direct contact to the second organic semiconductor layer and the LUMO energy level of the compound in second semiconductor layer having the smallest LUMO energy level and the is at least 0.2 eV, at least 0.3 eV; at least 0.4 eV; at least 0.5 eV; at least 0.6 eV; at least 0.7 eV, at least 0.8 eV; at least 0.9 eV or at least 1.0 eV.

According to an embodiment, any compound of the first semiconductor layer has a LUMO energy level larger than the HOMO energy level of any compound contained in the layer of the intermediate layer system which is in direct contact to the first semiconductor layer; and/or
wherein any compound of the second semiconductor layer has a HOMO energy level smaller than the LUMO energy level of any compound contained in the intermediate layer system that is in direct contact to the second semiconductor layer;

According to an embodiment, wherein the difference between the HOMO energy level of any compound contained in second semiconductor layer and the LUMO energy level of any compound contained in the layer of the intermediate layer system that is in direct contact to the second semiconductor layer is equal or smaller than -0.9 eV, preferably smaller than -1.0 eV, more preferably smaller than -1.5 eV, and most preferably smaller than -2.0 eV. By doing so, undesired doping, especially of compounds contained in the intermediate layer system, can for many applications be reduced or avoided. In particular the dark current density may be reduced.

According to an embodiment, wherein the compound having the smallest LUMO energy level of the second semiconductor layer has a LUMO energy level larger than the HOMO energy level of any compound contained in the layer of the intermediate layer system that is in direct contact to the second semiconductor layer.

According to an embodiment, wherein the compound having the largest HOMO energy level of the first semiconductor layer has a HOMO energy level smaller than the LUMO energy level of any compound contained in the intermediate layer system that is in direct contact to the first semiconductor layer.

In the following some of the layers and/or materials of the display device will be described in more detail whereby all embodiments of all layers or materials can be combined *ad libitum*:

### First layer / first compound

It goes without saying that the first layer may comprise more than one compound, although it is an embodiment of the present invention that the first layer essentially consists out of the first compound.

However, in order for the "HOMO barrier" to be effective, it has been found out that for many applications of the present invention it is not necessary that the first compound is the major compound of the first layer. Yet according to an embodiment the content of the first compound in the first layer is at least 20% (wt/wt), more preferred at least 40% (wt/wt), yet more preferred at least 60% (wt/wt) and most preferred at least 80% (wt/wt).

According to an embodiment, the first layer is a hole transport layer.

According to an embodiment, the first compound has an energy gap Egap of ≥ 3.3 eV.

According to an embodiment, the first compound does not contain a metal ion.

According to an embodiment, the first compound is a compound comprising at least one arylamine moiety, diarylamine moiety, triarylamine moiety or is a compound of formula (IIIa) or a compound of formula (IIIb): 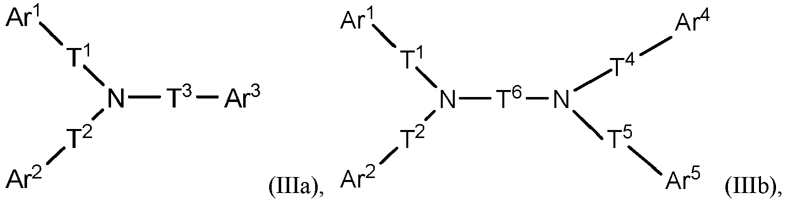 wherein:
T¹, T², T³, T⁴ and T⁵ are independently selected from a single bond, phenylene, biphenylene, terphenylene or naphthenylene, preferably a single bond or phenylene;
T⁶ is phenylene, biphenylene, terphenylene or naphthenylene;
Ar¹, Ar², Ar³, Ar⁴ and Ar⁵ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar¹, Ar², Ar³, Ar⁴ and Ar⁵ are selected the same or different from the group comprising H, D, F, C(-O)R², CN, Si(R²)₃, P(-O)(R²)₂, OR², S(-O)R², S(-O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

Preferably, the substituents of Ar¹, Ar², Ar³, Ar⁴ and Ar⁵ are selected the same or different from the group comprising H, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl, C₃ to C₁₈ heteroaryl, a fused ring system comprising 2 to 4 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; more preferred the substituents are selected the same or different from the group consisting of H, straight-chain alkyl having 1 to 4 carbon atoms, branched alkyl having 1 to 4 carbon atoms, cyclic alkyl having 3 to 4 carbon atoms and/or phenyl.
Thereby, the compound of formula (IIIa) or (IIIb) may have a rate onset temperature suitable for mass production.

According to an embodiment, the compound comprising an arylamine moiety comprises a compound of formula (IIIa) or formula (IIIb): 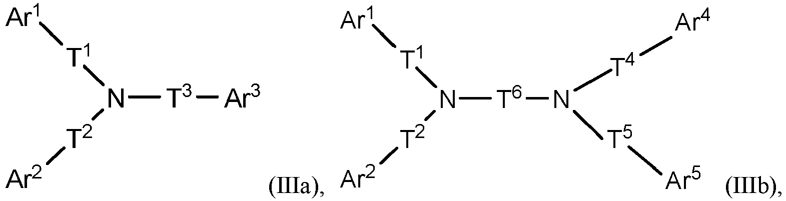 wherein
T¹, T², T³, T⁴ and T⁵ may be independently selected from a single bond, phenylene, biphenylene, terphenylene or naphthenylene, preferably a single bond or phenylene;
T⁶ is phenylene, biphenylene, terphenylene or naphthenylene;
Ar¹, Ar², Ar³, Ar⁴ and Ar⁵ may be independently selected from unsubstituted C₆ to C₂₀ aryl, or unsubstituted C₃ to C₂₀ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene], or a unsubstituted aromatic fused ring system comprising at least three unsubstituted aromatic rings selected from the group comprising unsubstituted non-hetero, unsubstituted hetero 5-member rings, unsubstituted 6-member rings and/or unsubstituted 7-member rings, unsubstituted fluorene, or a fused ring system comprising 2 to 6 unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle.

According to an embodiment, the compound comprising an arylamine moiety comprises a compound of formula (IIIa) or formula (IIIb): 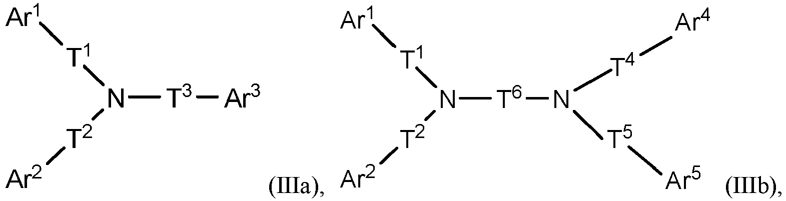 wherein
T¹, T², T³, T⁴ and T⁵ may be independently selected from a single bond, phenylene, biphenylene, terphenylene or naphthenylene, preferably a single bond or phenylene;
T⁶ is phenylene, biphenylene, terphenylene or naphthenylene;
Ar¹, Ar², Ar³, Ar⁴ and Ar⁵ may be independently selected from unsubstituted C₆ to C₂₀ aryl, or unsubstituted C₃ to C₂₀ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene].

Thereby, the compound of formula (IIIa) or (IIIb) may have a rate onset temperature suitable for mass production.

According to an embodiment T¹, T², T³, T⁴ and T⁵ may be independently selected from a single bond, phenylene, biphenylene or terphenylene.

According to an embodiment T¹, T², T³, T⁴ and T⁵ may be independently selected from phenylene, biphenylene or terphenylene and one of T¹, T², T³, T⁴ and T⁵ are a single bond. According to an embodiment T¹, T², T³, T⁴ and T⁵ may be independently selected from phenylene or biphenylene and one of T¹, T², T³, T⁴ and T⁵ are a single bond.

According to an embodiment T¹, T², T³, T⁴ and T⁵ may be independently selected from phenylene or biphenylene and two of T¹, T², T³, T⁴ and T⁵ are a single bond.

According to an embodiment T¹, T² and T³ may be independently selected from phenylene and one of T¹, T² and T³ are a single bond.

According to an embodiment T¹, T² and T³ may be independently selected from phenylene and two of T¹, T² and T³ are a single bond.

According to an embodiment T⁶ may be phenylene, biphenylene, terphenylene. According to an embodiment wherein T⁶ may be phenylene.

According to an embodiment T⁶ may be biphenylene. According to an embodiment wherein T⁶ may be terphenylene.

According to an embodiment Ar¹, Ar², Ar³, Ar⁴ and Ar⁵ may be independently selected from formulae (E1) to (E17): 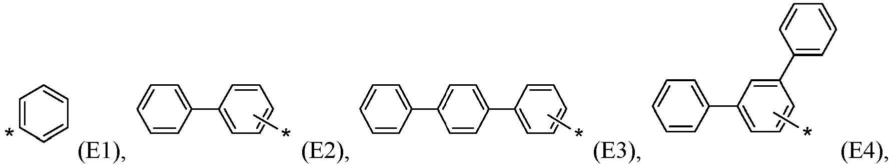 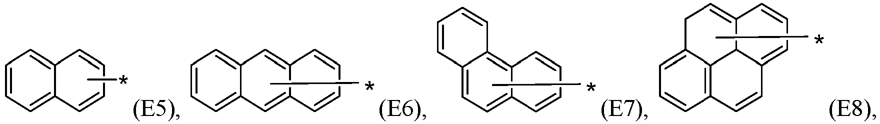 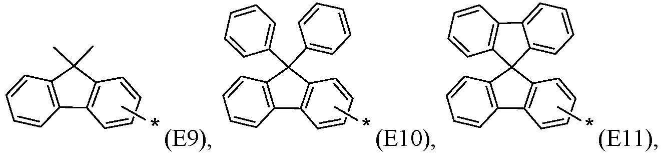 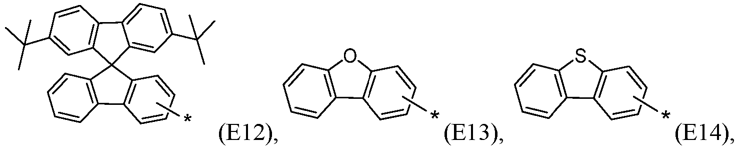 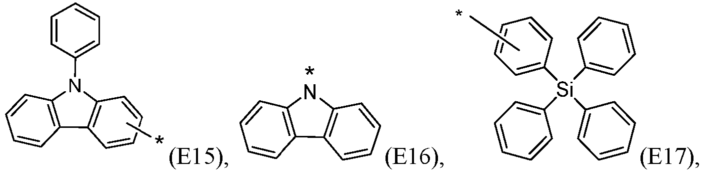 wherein the asterix "*" denotes the binding position.

According to an embodiment, Ar¹, Ar², Ar³, Ar⁴ and Ar⁵ may be independently selected from (E1) to (E15); alternatively selected from (E1) to (E10) and (E13),(E15), (E16) and (E17).

According to an embodiment, Ar¹, Ar², Ar³, Ar⁴ and Ar⁵ may be independently selected from the group consisting of (E1), (E2), (E5), (E7), (E9), (E10), (E13), (E15), (E16) and (E17).

The rate onset temperature may be in a range particularly suited to mass production, when Ar¹, Ar², Ar³, Ar⁴ and Ar⁵ are selected in this range.

The "compound of formula (IIIa) or formula (IIIb) " may be also referred to as "hole transport compound".

According to one embodiment the compound of formula (IIIa) or formula (IIIb) may comprises at least ≥ 1 to ≤ 6 substituted or unsubstituted aromatic fused ring systems comprising heteroaromatic rings; preferably ≥ 1 to ≤ 5, more preferably ≥ 1 to ≤ 4, even more preferably ≥ 1 to ≤ 3, and most preferably ≥ 1 to ≤ 2.

According to one embodiment the compound of formula (IIIa) or formula (IIIb) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle.

According to one embodiment the compound of formula (IIIa) or formula (IIIb) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 1 to ≤ 5 substituted or unsubstituted aromatic fused ring systems comprising heteroaromatic rings, and at least ≥ 1 to ≤ 3 substituted or unsubstituted unsaturated 5- to 7-member ring of a heterocycle, further preferred ≥ 1 to ≤ 4substituted or unsubstituted aromatic fused ring systems comprising heteroaromatic rings and optional at least ≥ 1 to ≤ 3 substituted or unsubstituted unsaturated 5- to 7-member ring of a heterocycle, further preferred ≥ 1 to ≤ 3 substituted or unsubstituted aromatic fused ring systems comprising heteroaromatic rings and optional at least ≥ 1 to ≤ 3 substituted or unsubstituted unsaturated 5- to 7-member ring of a heterocycle, further preferred ≥ 1 to ≤ 2 substituted or unsubstituted aromatic fused ring systems comprising heteroaromatic rings and optional at least ≥ 1 to ≤ 3 substituted or unsubstituted unsaturated 5- to 7-member ring of a heterocycle, and additional preferred wherein the aromatic fused ring systems comprising heteroaromatic rings are unsubstituted and optional at least ≥ 1 to ≤ 3 unsubstituted unsaturated 5- to 7-member ring of a heterocycle.

According to one embodiment the compound of formula (IIIa) or formula (IIIb) may comprise:
- a substituted or unsubstituted aromatic fused ring systems with at least ≥ 1 to ≤ 6, preferably ≥ 1 to ≤ 5, more preferably ≥ 1 to ≤ 4, even more preferably ≥ 1 to ≤ 3, and most preferably ≥ 1 to ≤ 2 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5- to 7- member ring of a heterocycle; or
- an unsubstituted aromatic fused ring systems with at least ≥ 1 to ≤ 6, preferably ≥ 1 to ≤ 5, more preferably ≥ 1 to ≤ 4, even more preferably ≥ 1 to ≤ 3, and most preferably ≥ 1 to ≤ 2, fused aromatic rings selected from the group comprising unsubstituted non-hetero aromatic rings, unsubstituted hetero 5-member rings, unsubstituted 6-member rings and/or unsubstituted unsaturated 5- to 7-member ring of a heterocycle.

It should be noted here that the wording "aromatic fused ring system" may include at least one aromatic ring and at least one substituted or unsubstituted unsaturated 5- to 7- member ring. It should be noted here that the substituted or unsubstituted unsaturated 5- to 7- member ring may not be an aromatic ring.

According to one embodiment, the compound comprising an arylamine moiety comprises at least one naphthyl group, carbazole group, dibenzofurane group, dibenzothiophene group and/or substituted fluorenyl group, wherein the substituents are independently selected from methyl, phenyl or fluorenyl.

According to an embodiment of the present invention, wherein the compound of formula (IIIa) or formula (IIIb) are selected from formulae (F1) to (F24): 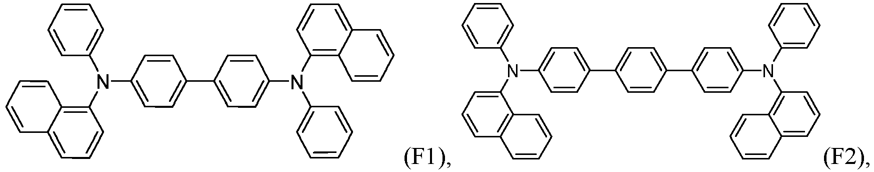 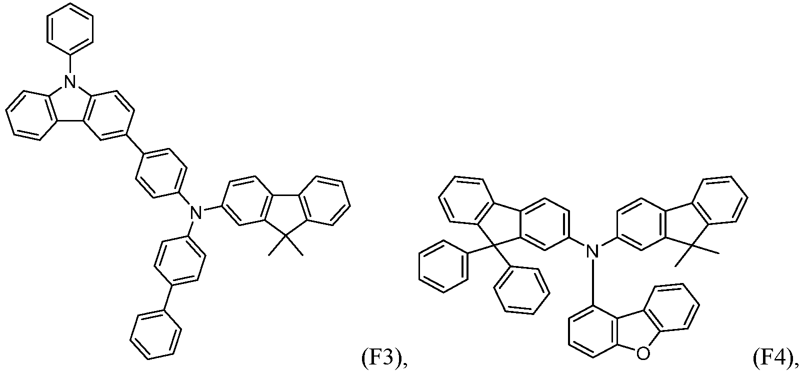 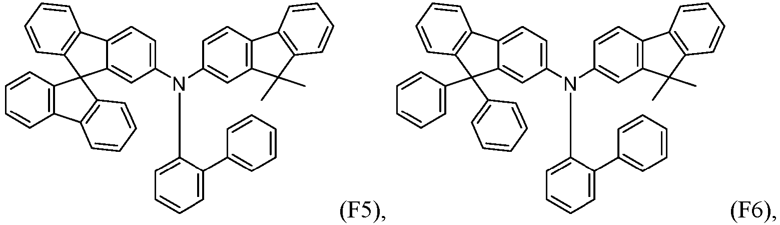 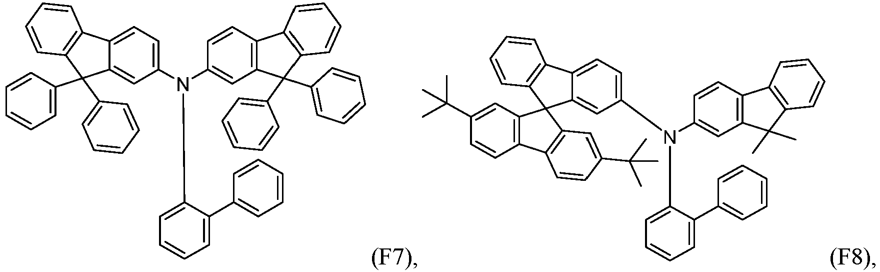 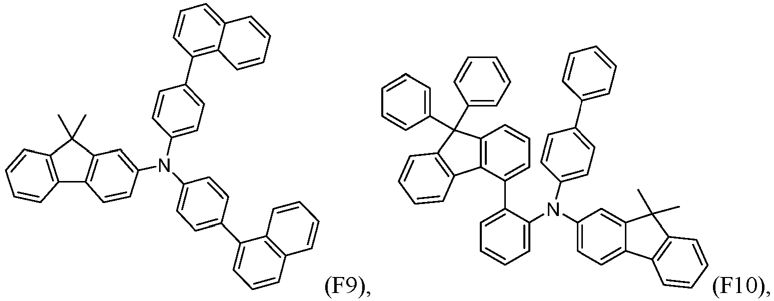 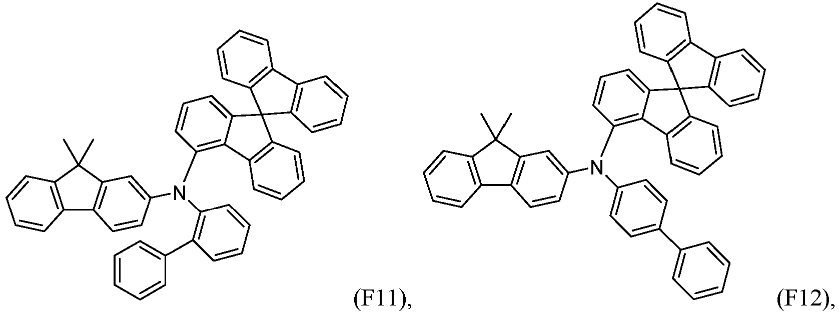 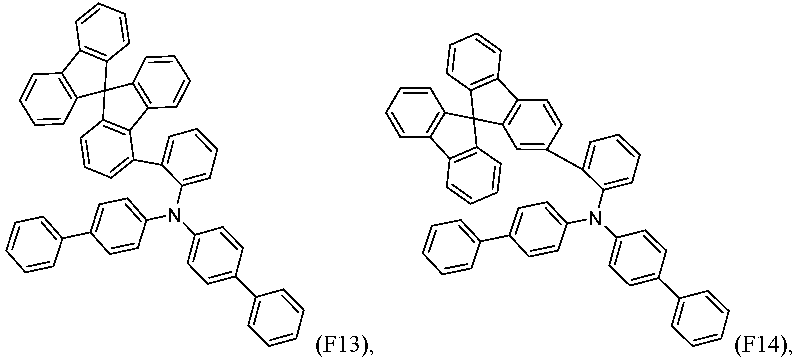 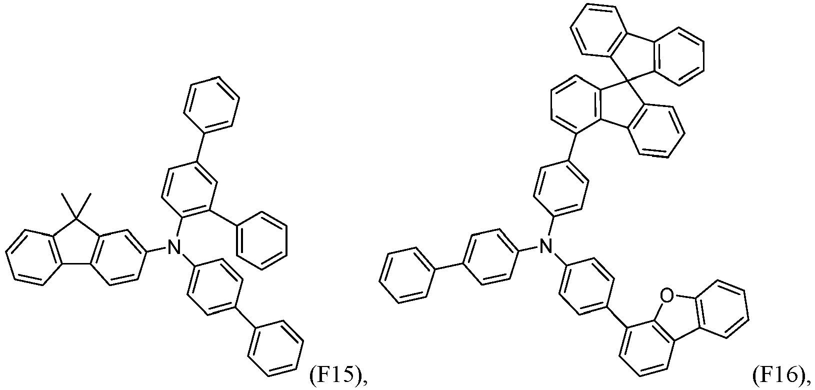 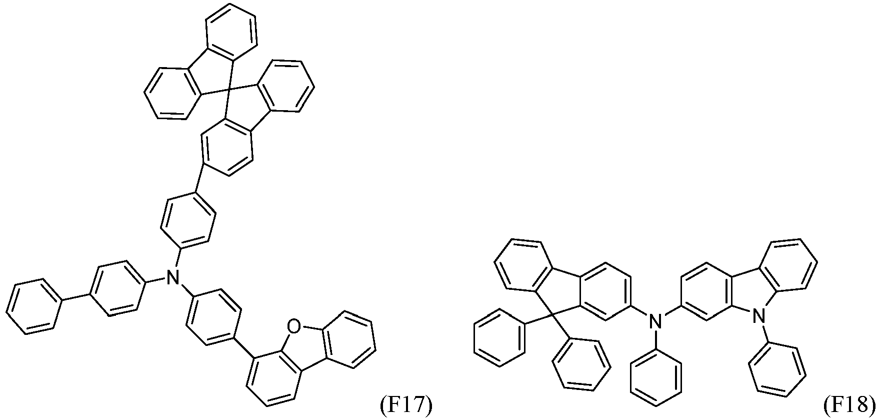 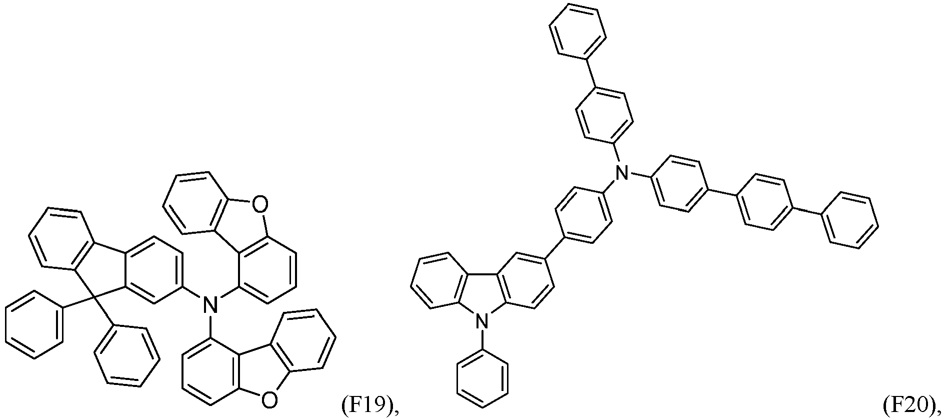 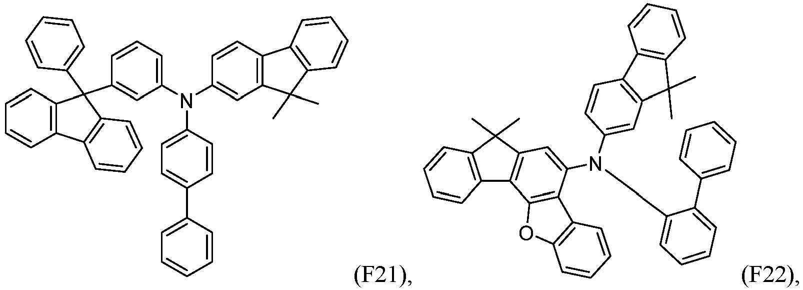 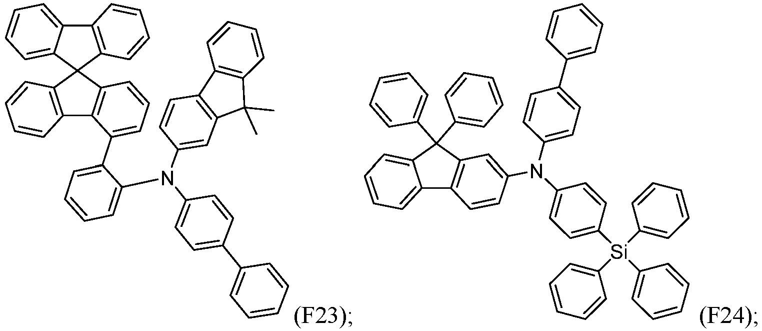 preferably the compound of formula (IIIa) or formula (IIIb) is selected from formulae (F3) to (F24), and more preferred from (F4) to (F24).

According to an embodiment, the compound comprising an aryl amine moiety, the arylamine compound, the diarylamine compound, the triarylamine compound, the compound of formula (IIIa) and/or the compound of formula (IIIb) is a covalent compound.

According to an embodiment, the compound comprising an aryl amine moiety, the arylamine compound, the diarylamine compound, the triarylamine compound, the compound of formula (IIIa) and/or the compound of formula (IIIb) has a molecular mass in the range of ≥250 g/mol and ≤1500 g/mol; preferably ≥350 g/mol and ≤1250 g/mol; more preferably ≥450 g/mol and ≤1000 g/mol, and most preferably ≥500 g/mol and ≤900 g/mol,

According to an embodiment, the first semiconductor layer further comprises a p-dopant, preferably wherein the p-dopant has a LUMO energy level in the range of ≥-7.0 eV to ≤-1.5eV; preferably ≥-6.5 eV to ≤-2.0 eV; preferably ≥-6.0 eV to ≤-2.5 eV; and most preferably ≥-5.8 eV to ≤-2.5 eV. By doing so, the dark current density may be reduced and/or the photo current density may be increased and/or the signal to noise ratio may be increased.

### Second layer and second compound.

It goes without saying that the second layer may comprise more than one compound, although it is an embodiment of the present invention that the second layer essentially consists out of the second compound.

However, in order for the "LUMO barrier" to be effective, it has been found out that for many applications of the present invention it is not necessary that the second compound is the major compound of the first layer. Yet according to an embodiment the content of the second compound in the second layer is at least 20% (wt/wt), more preferred at least 40% (wt/wt), yet more preferred at least 60% (wt/wt) and most preferred at least 80%(wt/wt).

According to an embodiment, the second layer is an electron transport layer and/or hole blocking layer.

According to an embodiment, the second compound has an energy gap Egap ≥ 3.3 eV.

If the second compound has an Egap larger or equal to 3.3 eV, then the photocurrent density under exposure of light or irradiation is higher. If the second compound absorbs light, and thus reduces the absorption of light in the photoconversion unit, the photocurrent density under exposure of light or irradiation would be lost. The absorption by a second compound does not contribute to the photocurrent density under exposure of light or irradiation since the charge carrier generated would recombine at the interface.

According to an embodiment, the second compound dooes not contain a metal ion.

According to an embodiment, the second compound is a compound comprising a mono-6-membered heteroaryl comprising one, two or three nitrogen atoms, more preferably two or three nitrogen atoms, and most preferably three nitrogen atoms.

According to an embodiment, the mono-6-membered heteroaryl comprising one, two, three or more nitrogen atoms is selected from formula (xxa) or formula (xxb)

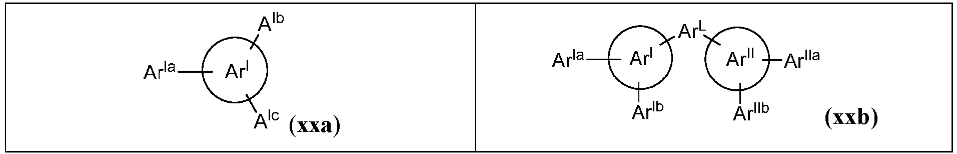

wherein Ar^{I} is a substituted or unsubstituted C₃ to C₅ heteroaromatic ring comprising at least one nitrogen atom,
wherein Ar^{II} is substituted or unsubstituted C₃ to C₄₀ heteroaromatic ring comprising at least one nitrogen atom,
wherein the substituents on Ar^{I} and Ar^{II} are, identically or differently on each occurrence, D, a monovalent aromatic or heteroaromatic ring system having 5 to 60 aromatic ring atoms, which may in each case be substituted by one or more radicals R^{a};
wherein Ar^{Ia}, Ar^{Ib}, Ar^{Ic}, Ar^{IIa}, and Ar^{IIb} are, identically or differently on each occurrence, H, D, a monovalent aromatic or heteroaromatic ring system having 5 to 60 aromatic ring atoms, which may in each case be substituted by one or more radicals R^{a};
wherein at least one of Ar^{Ia}, Ar^{Ib}, Ar^{Ic} in formula (xxa) and in case of formula (xxb) at least one of
Ar^{Ia}, Ar^{Ib}, Ar^{IIa}, and Ar^{IIb} is independently selected from a monovalent aromatic or heteroaromatic ring system having 5 to 60 aromatic ring atoms, which may in each case be substituted by one or more radicals R^{a};
wherein Ar^{L} is a divalent aromatic or heteroaromatic ring system having 5 to 60 aromatic ring atoms, which is optionally substituted by one or more radicals R^{a};
wherein R^{a} is on each occurrence, identically or differently, H, D, F, Cl, Br, I, CHO, N(R^{b})₂, N(Ar^{1s})₂, B(Ar^{1s})₂, C(=O)Ar^{1s}, P(=Y)(R^{c})₂, S(=O)Ar^{1s}, S(=O)₂Ar^{1s}, CR^{b}=CR^{b}Ar^{1s}, CN, NO₂, Si(R^{b})₃, B(OR^{b})₂, B(R^{b})₂, B(N(R^{b})₂)₂, OSO₂R^{b}, a substituted or unsubstituted straight-chain C₁ to C₂₀ alkyl, a substituted or unsubstitutedstraight-chain C₁ to C₂₀ alkenyl, a substituted or unsubstituted straight-chain C₁ to C₂₀ alkynyl, a substituted or unsubstituted straight-chain C₁ to C₂₀ alkoxy, a substituted or unsubstituted straight-chain C₁ to C₂₀ thioalkoxy, substituted or unsubstituted branched C₃ to C₂₀ alkyl, a substituted or unsubstituted branched C₃ to C₂₀ alkenyl, a substituted or unsubstituted branched C₃ to C₂₀ a substituted or unsubstituted branched C₃ to C₂₀ alkynyl, a substituted or unsubstituted branched C₃ to C₂₀ alkoxy or a substituted or unsubstituted C₃ to C₂₀ branched thioalkoxy,substituted or unsubstituted cyclic C₃ to C₄₀ alkyl, substituted or unsubstituted cyclic C₃ to C₄₀ alkenyl, substituted or unsubstituted cyclic C₃ to C₄₀ alkinyl, substituted or unsubstituted cyclic C₃ to C₄₀ alkoxy or substituted or unsubstituted cyclic C₃ to C₄₀ thioalkoxy; substituted or unsubstituted heterocyclic C₃ to C₄₀ alkyl, substituted or unsubstituted heterocyclic C₃ to C₄₀ alkenyl, substituted or unsubstituted heterocyclic C₃ to C₄₀ alkynyl, substituted or unsubstituted heterocyclic C₃ to C₄₀ alkoxy or substituted or unsubstituted heterocyclic C₃ to C₄₀ thioalkoxy; wherein the one or more substituents, if present, is selected from R^{b}, where one or more non-adjacent CH₂ groups is optionally replaced by R^{b}C=CR^{b}, C=C, Si(R^{b})₂, Ge(R^{b})₂, Sn(R^{b})₂, C=O, C=S, C=Se, C=NR^{b}, P(=O)(R^{b}), SO, SO₂, NR^{b}, O, S or CONR^{b} and where one or more H atoms is optionally replaced by D, F, Cl, Br, I, CN or NO₂, or an aromatic or heteroaromatic ring system having 5 to 60 aromatic ring atoms, which may in each case be substituted by one or more radicals R^{b}, or an aryloxy or heteroaryloxy group having 5 to 60 aromatic ring atoms, which is optionally substituted by one or more radicals R^{b}, or a combination of these systems; two or more adjacent substituents R^{a} here optionally forms a mono- or polycyclic, aliphatic or aromatic ring system with one another;
wherein Ar^{1s} is on each occurrence, identically or differently, an aromatic or heteroaromatic ring system having 5 to 30 aromatic ring atoms, which is optionally substituted by one or more radicals R^{b}; two radicals Ar^{1s} here which are bonded to the same nitrogen, phosphorus or boron atom may also be linked to one another by a single bond or a bridge selected from B(R^{b}), C(R^{b})₂, Si(R^{b})₂, C=O, C=NR^{b}, C=C(R^{b})₂, O, S, S=O, SO₂, N(R^{b}), P(R^{b}) and P(=Y)R^{c};
wherein R^{b} is on each occurrence, identically or differently, H, D or a C₁ to C₂₀ aliphatic hydrocarbyl, a C₁ to C₂₀ aryl and/or C₁ to C₂₀ heteroaryl, in which, in addition, H atoms is optionally replaced by D or F; two or more adjacent substituents R^{b} here may also form a mono- or polycyclic, aliphatic or aromatic ring system with one another;
wherein Y is selected from O, S or Se, preferably O, and R^{c} is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy;

According to one embodiment, Ar^{I} is selected from pyrazine, pyridine, pyrimidine, or triazine, preferably triazine, pyrazine, pyrimidine, and more preferably from pyrimidine and triazine.

According to one embodiment, Ar^{II} is selected from pyrazine, pyridine, pyrimidine, or triazine, preferably triazine, pyrazine, pyrimidine, and more preferably from pyrimidine and triazine.

According to one embodiment, Ar^{I} in formula (xxa) or (xxxa) is selected from pyrazine, pyridine, pyrimidine, or triazine, preferably pyrazine, pyrimidine, triazine, and more preferably from pyrimidine and triazine; or Ar^{I} in formula (xxa) or (xxxa) and Ar^{II} in formula (xxb) or (xxxb) are independently of each other selected from pyrazine, pyridine, pyrimidine, or triazine, preferably pyrazine, pyrimidine, triazine, and more preferably from pyrimidine and triazine.

According to an embodiment, the mono-6-membered heteroaryl comprising one, two, three or more nitrogen atoms is selected from formula (xxxa) or formula (xxxb): 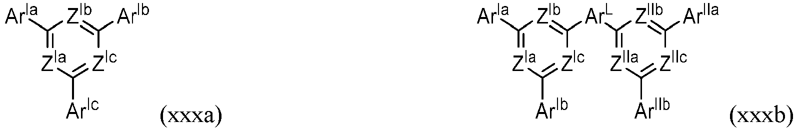 wherein
Z^{Ia} is selected from N or CH,
Z^{Ib} is selected from N or CH,
Z^{Ic} is selected from N or CH,
Z^{IIa} is selected from N or CH,
Z^{IIb} is selected from N or CH, and
Z^{IIc} is selected from N or CH,
wherein in formula (xxxa) at least one of Z^{Ia}, Z^{Ib} and Z^{Ic} is selected from N,
wherein in formula (xxxb) at least one of Z^{Ia}, Z^{ib}, Z^{Ic}, Z^{IIa}, Z^{IIb}, and Z^{IIc} is selected from N,
wherein Ar^{Ia}, Ar^{Ib}, Ar^{Ic}, Ar^{IIa} and Ar^{IIb} are identically or differently on each occurrence, a monovalent aromatic or heteroaromatic ring system having 5 to 60 aromatic ring atoms, which may in each case be substituted by one or more radicals R^{a};
wherein Ar^{L} is a divalent aromatic or heteroaromatic ring system having 5 to 60 aromatic ring atoms, which is optionally substituted by one or more radicals R^{a},
wherein R^{a} is on each occurrence, identically or differently, H, D, F, Cl, Br, I, CHO, N(R^{b})₂, N(Ar^{1s})₂, B(Ar^{1s})₂, C(=O)Ar^{1s}, P(=Y)(R^{c})₂, S(=O)Ar^{1s}, S(=O)₂Ar^{1s}, CR^{b}=CR^{b}Ar^{1s}, CN, NO₂, Si(R^{b})₃, B(OR^{b})₂, B(R^{b})₂, B(N(R^{b})₂)₂, OSO₂R^{b}, a substituted or unsubstituted straight-chain C₁ to C₂₀ alkyl, a substituted or unsubstitutedstraight-chain C₁ to C₂₀ alkenyl, a substituted or unsubstituted straight-chain C₁ to C₂₀ alkynyl, a substituted or unsubstituted straight-chain C₁ to C₂₀ alkoxy, a substituted or unsubstituted straight-chain C₁ to C₂₀ thioalkoxy, substituted or unsubstituted branched C₃ to C₂₀ alkyl, a substituted or unsubstituted branched C₃ to C₂₀ alkenyl, a substituted or unsubstituted branched C₃ to C₂₀ a substituted or unsubstituted branched C₃ to C₂₀ alkynyl, a substituted or unsubstituted branched C₃ to C₂₀ alkoxy or a substituted or unsubstituted branched C₃ to C₂₀ thioalkoxy,substituted or unsubstituted cyclic C₃ to C₄₀ alkyl, substituted or unsubstituted cyclic C₃ to C₄₀ alkenyl, substituted or unsubstituted cyclic C₃ to C₄₀ alkinyl, substituted or unsubstituted cyclic C₃ to C₄₀ alkoxy or substituted or unsubstituted cyclic C₃ to C₄₀ thioalkoxy; substituted or unsubstituted heterocyclic C₃ to C₄₀ alkyl, substituted or unsubstituted heterocyclic C₃ to C₄₀ alkenyl, substituted or unsubstituted heterocyclic C₃ to C₄₀ alkynyl, substituted or unsubstituted heterocyclic C₃ to C₄₀ alkoxy or substituted or unsubstituted heterocyclic C₃ to C₄₀ thioalkoxy;
wherein the one or more substituents, if present, is selected from R^{b}, where one or more non-adjacent CH₂ groups is optionally replaced by R^{b}C=CR^{b}, C=C, Si(R^{b})₂, Ge(R^{b})₂, Sn(R^{b})₂, C=O, C=S, C=Se, C=NR^{b}, P(=O)(R^{b}), SO, SO₂, NR^{b}, O, S or CONR^{b} and where one or more H atoms is optionally replaced by D, F, Cl, Br, I, CN or NO₂, or an aromatic or heteroaromatic ring system having 5 to 60 aromatic ring atoms, which may in each case be substituted by one or more radicals R^{b}, or an aryloxy or heteroaryloxy group having 5 to 60 aromatic ring atoms, which is optionally substituted by one or more radicals R^{b}, or a combination of these systems; two or more adjacent substituents R^{a} here optionally forms a mono- or polycyclic, aliphatic or aromatic ring system with one another;
wherein Ar^{1s} is on each occurrence, identically or differently, an aromatic or heteroaromatic ring system having 5 to 30 aromatic ring atoms, which is optionally substituted by one or more radicals R^{b}; two radicals Ar^{1s} here which are bonded to the same nitrogen, phosphorus or boron atom may also be linked to one another by a single bond or a bridge selected from B(R^{b}), C(R^{b})₂, Si(R^{b})₂, C=O, C=NR^{b}, C=C(R^{b})₂, O, S, S=O, SO₂, N(R^{b}), P(R^{b}) and P(=Y)R^{c};
wherein R^{b} is on each occurrence, identically or differently, H, D or a C₁ to C₂₀ aliphatic hydrocarbyl, a C₁ to C₂₀ aryl and/or C₁ to C₂₀ heteroaryl, in which, in addition, H atoms is optionally replaced by D or F; two or more adjacent substituents R^{b} here may also form a mono- or polycyclic, aliphatic or aromatic ring system with one another;
wherein Y is selected from O, S or Se, preferably O, and R^{c} is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy.

The mono-6-membered heteroaryl comprising one, two, three or more nitrogen atoms (and subsequently the second compound) is preferably selected from (M6MH-1) to (M6MH-19)

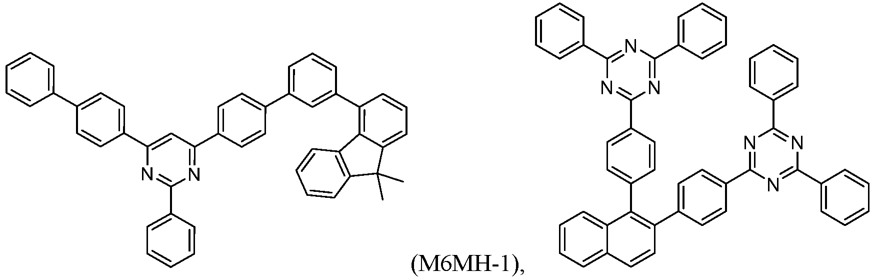

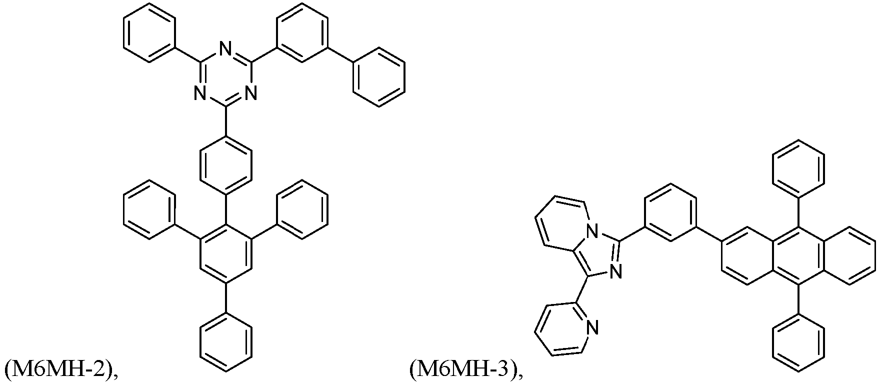

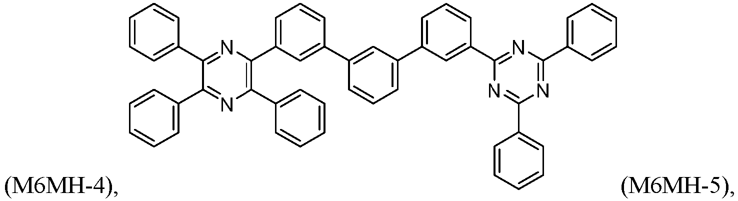

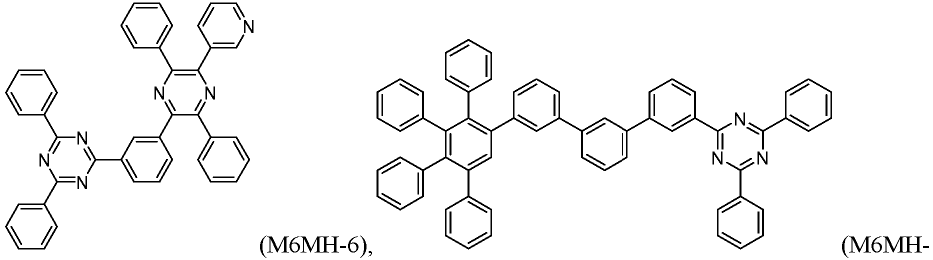

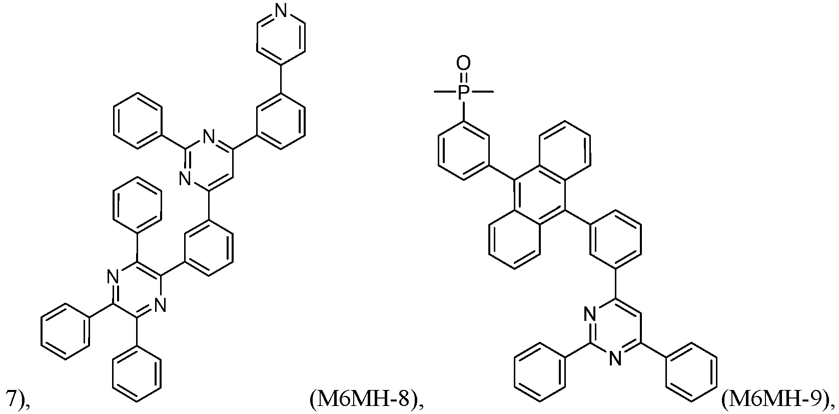

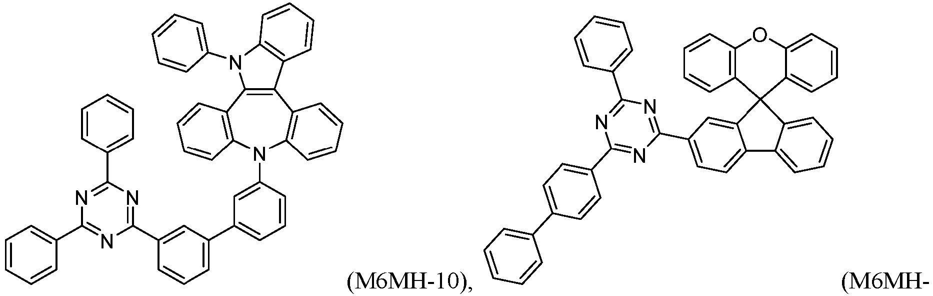

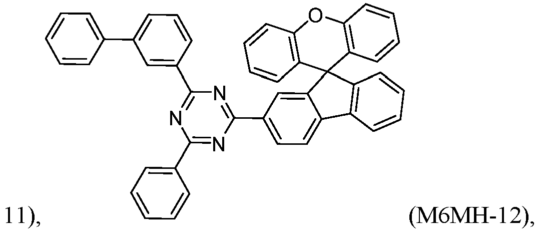

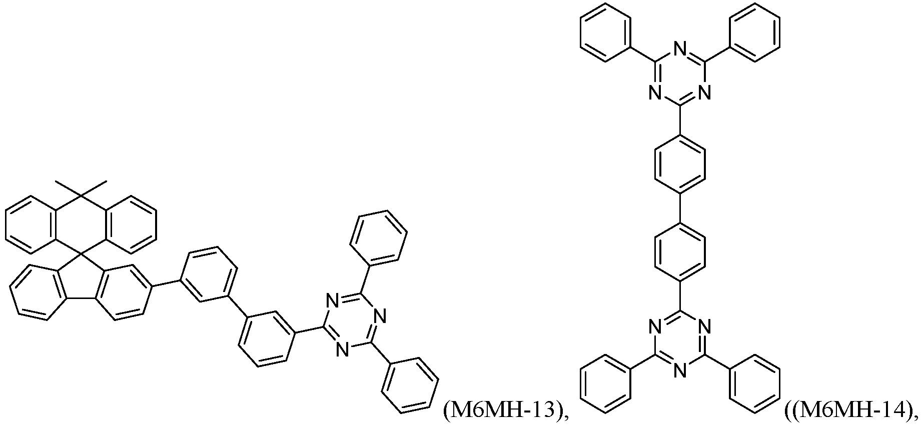

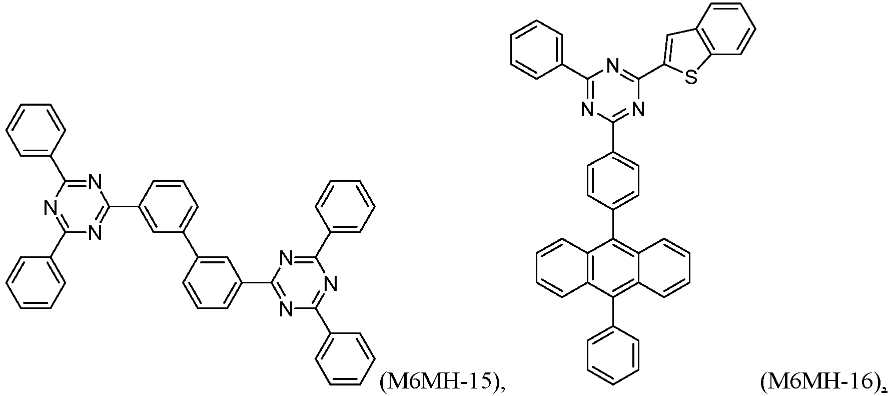

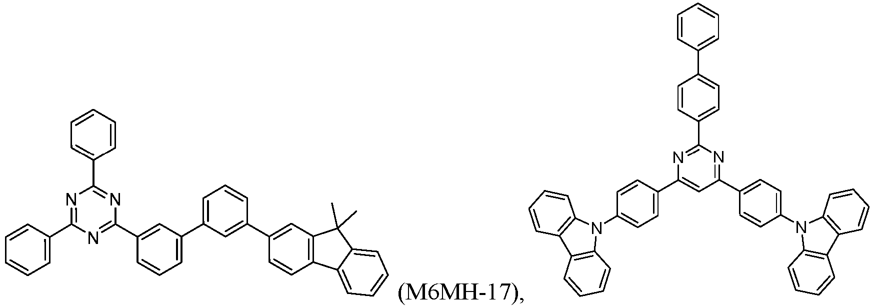

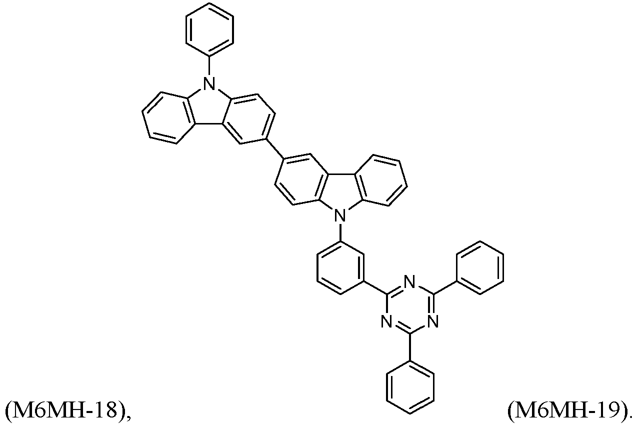

According to an embodiment, the mono-6-membered heteroaryl comprising one, two, three or more nitrogen atoms has a LUMO energy level ≥-4.0 eV; preferably from ≥-3.5 eV; more preferably ≥-3.0 eV; and most preferably ≥-2.5 eV.

According to an embodiment, the mono-6-membered heteroaryl comprising one, two, three or more nitrogen atoms has a LUMO energy level in the range of ≥-4.0 eV to ≤-1.4 eV; preferably from ≥-3.5 eV to ≤-1.5 eV; more preferably ≥-3.0 eV to ≤-1.6 eV; and most preferably ≥-2.5 eV to ≤-1.7 eV.

According to an embodiment, the mono-6-membered heteroaryl comprising one, two, three or more nitrogen atoms is an electron transport compound.

### Intermediate layer system

According to one embodiment of the present invention, the intermediate layer system consists of a single layer.

Alternatively according to one embodiment of the present invention, the intermediate layer system consists of two layers.

Yet alternatively according to one embodiment to the present invention, the intermediate layer system consists of three or more layers.

According to an embodiment, the electron acceptor compound is the third compound. Or in other words, the third compound has not only hole blocking but also electron acceptor properties.

According to an embodiment, the electron donor compound is the fourth compound. Or in other words, the fourth compound has not only hole blocking but also electron donor properties.

According to an embodiment, the electron acceptor compound is not the third compound.

According to an embodiment, the electron donor compound is not the fourth compound.

According to an embodiment, the electron acceptor compound is not the third compound, and the electron donor compound is not the fourth compound.

According to an embodiment, the photoconversion unit consists of one layer.

According to an embodiment, the photoconversion unit comprises two or more layers.

According to an embodiment, the electron acceptor compound and the electron donor compound are in the same layer.

According to an embodiment, wherein the electron acceptor compound and the electron donor compound are in different layers. In this embodiment, the electron donor compound is closer to the second electrode than the electron acceptor compound.

According to an embodiment, at least one of the following provisio (A-1) to (A-16) holds true:
(A-1) the electron acceptor compound is the third compound, and the electron donor compound is the fourth compound, and the electron acceptor compound and the electron donor compound are in the same layer;
(A-2) the electron acceptor compound is the third compound, and the electron donor compound is the fourth compound, and the photoconversion unit consists of one layer;
(A-3) the electron acceptor compound is the third compound, and the electron donor compound is not the fourth compound, and the electron acceptor compound and the electron donor compound are in the same layer;
(A-4) the electron acceptor compound is the third compound, and the electron donor compound is not the fourth compound, and the photoconversion unit consists of one layer;
(A-5) the electron acceptor compound is not the third compound, and the electron donor compound is the fourth compound, and the electron acceptor compound and the electron donor compound are in the same layer;
(A-6) the electron acceptor compound is not the third compound, and the electron donor compound is the fourth compound, and the photoconversion unit consists of one layer;
(A-7) the electron acceptor compound is not the third compound, and the electron donor compound is not the fourth compound, and the electron acceptor compound and the electron donor compound are in the same layer;
(A-8) the electron acceptor compound is not the third compound, and the electron donor compound is not the fourth compound, and the photoconversion unit consists of one layer;
(A-9) the electron acceptor compound is the third compound, and the electron donor compound is the fourth compound, and the electron acceptor compound and the electron donor compound are in different layers;
(A-10) the electron acceptor compound is the third compound, and the electron donor compound is the fourth compound, and the photoconversion unit comprises two or more layer;
(A-11) the electron acceptor compound is the third compound, and the electron donor compound is not the fourth compound, and the electron acceptor compound and the electron donor compound are in different layers;
(A-12) the electron acceptor compound is the third compound, and the electron donor compound is not the fourth compound, and the photoconversion unit comprises two or more layer;
(A-13) the electron acceptor compound is not the third compound, and the electron donor compound is the fourth compound, and the electron acceptor compound and the electron donor compound are in different layers;
(A-14) the electron acceptor compound is not the third compound, and the electron donor compound is the fourth compound, and the photoconversion unit comprises two or more layer;
(A-15) the electron acceptor compound is not the third compound, and the electron donor compound is not the fourth compound, and the electron acceptor compound and the electron donor compound are in different layers; and/or
(A-16) the electron acceptor compound is not the third compound, and the electron donor compound is not the fourth compound, and the photoconversion unit comprises two or more layer.

According to an embodiment, wherein electron acceptor compound is the third compound, and the electron donor compound is the fourth compound, and the electron acceptor compound and the electron donor compound are in the same layer, and/or
electron acceptor compound is the third compound, and the electron donor compound is the fourth compound, and the photoconversion unit consists of one layer.

According to an embodiment, the electron acceptor compound is the third compound, and the electron donor compound is not the fourth compound, and the electron acceptor compound and the electron donor compound are in the same layer, and/or
the electron acceptor compound is the third compound, and the electron donor compound is not the fourth compound, and the photoconversion unit consists of one layer.

According to an embodiment, the electron acceptor compound is not the third compound, and the electron donor compound is the fourth compound, and the electron acceptor compound and the electron donor compound are in the same layer; and/or
the electron acceptor compound is not the third compound, and the electron donor compound is the fourth compound, and the photoconversion unit consists of one layer.

According to an embodiment, the electron acceptor compound is not the third compound, and the electron donor compound is not the fourth compound, and the electron acceptor compound and the electron donor compound are in the same layer; and/or
the electron acceptor compound is not the third compound, and the electron donor compound is not the fourth compound, and the photoconversion unit consists of one layer.

According to an embodiment, the electron acceptor compound is the third compound, and the electron donor compound is the fourth compound, and the electron acceptor compound and the electron donor compound are in different layers; and/or
the electron acceptor compound is the third compound, and the electron donor compound is the fourth compound, and the photoconversion unit comprises two or more layer.

According to an embodiment, the electron acceptor compound is the third compound, and the electron donor compound is not the fourth compound, and the electron acceptor compound and the electron donor compound are in different layers; and/or
the electron acceptor compound is the third compound, and the electron donor compound is not the fourth compound, and the photoconversion unit comprises two or more layer.

According to an embodiment, the electron acceptor compound is not the third compound, and the electron donor compound is the fourth compound, and the electron acceptor compound and the electron donor compound are in different layers; and/or
the electron acceptor compound is not the third compound, and the electron donor compound is the fourth compound, and the photoconversion unit comprises two or more layer.

According to an embodiment, the electron acceptor compound is not the third compound, and the electron donor compound is not the fourth compound, and the electron acceptor compound and the electron donor compound are in different layers; and/or
the electron acceptor compound is not the third compound, and the electron donor compound is not the fourth compound, and the photoconversion unit comprises two or more layer.

According to an embodiment, if the electron acceptor compound is not the third compound and the electron acceptor compound is not in direct contact to the first semiconductor layer, then the third compound has a LUMO energy level equal or smaller than the LUMO energy level of the electron acceptor compound or the difference between LUMO energy level of the electron acceptor compound and the LUMO energy level of the third compound is equal or larger than -0.5 eV; or
if the electron acceptor compound is the third compound then the first compound has a HOMO energy level equal or smaller than the LUMO energy level of the third compound; and/or
if the electron donor compound is not the fourth compound and the electron donor compound is not in direct contact to the second semiconductor layer, then the fourth compound has a HOMO energy level equal or larger than the HOMO energy level of the electron donor compound or the difference between the HOMO energy level of the electron donor compound and the HOMO energy level of the fourth compound is equal or smaller than -0.5 eV; or
if the electron donor compound is the fourth compound, then the second compound has a LUMO energy level equal or larger than HOMO energy level of the fourth compound.

According to an embodiment, if the electron acceptor compound is not the third compound and the electron acceptor compound is not in direct contact to the first semiconductor layer, then the third compound has a LUMO energy level equal or smaller than the LUMO energy level of the electron acceptor compound or the difference between LUMO energy level of the electron acceptor compound and the LUMO energy level of the third compound is equal or larger than -0.4 eV; equal or larger than -0.3 eV; equal or larger than -0.2 eV; equal or larger than -0.1 eV; or equal or larger than -0.05 eV; or
if the electron acceptor compound is the third compound then the first compound has a HOMO energy level equal or smaller than the LUMO energy level of the third compound; and/or
if the electron donor compound is a not the fourth compound and the electron donor compound is not in direct contact to the second semiconductor layer, then the fourth compound has a HOMO energy level equal or larger than the HOMO energy level of the electron donor compound or the difference between the HOMO energy level of the electron donor compound and the HOMO energy level of the fourth compound is equal or smaller than 0.4 eV; equal or smaller than 0.3 eV; equal or smaller than 0.2 eV; equal or smaller than 0.1 eV; or equal or smalller than 0.05 eV; or
if the electron donor compound is the fourth compound, then the second compound has a LUMO energy level equal or larger than HOMO energy level of the fourth compound.

According to an embodiment, if the electron acceptor compound is not the third compound and the electron acceptor compound is not in direct contact to the first semiconductor layer, then the third compound has a LUMO energy level equal or smaller than the LUMO energy level of the electron acceptor compound or the difference between LUMO energy level of the electron acceptor compound and the LUMO energy level of the third compound is equal or larger than -0.4 eV; equal or larger than -0.3 eV; equal or larger than -0.2 eV; equal or larger than -0.1 eV; or equal or larger than -0.05 eV; or
if the electron acceptor compound is the third compound then the first compound has a HOMO energy level equal or smaller than the LUMO energy level of the third compound; and/or
if the electron donor compound is a not the fourth compound and the electron donor compound is not in direct contact to the second semiconductor layer, then the fourth compound has a HOMO energy level equal or larger than the HOMO energy level of the electron donor compound or the difference between the HOMO energy level of the electron donor compound and the HOMO energy level of the fourth compound is equal or smaller than 0.4 eV; equal or smaller than 0.3 eV; equal or smaller than 0.2 eV; equal or smaller than 0.1 eV; or equal or smalller than 0.05 eV; or
if the electron donor compound is the fourth compound, then the second compound has a LUMO energy level equal or larger than HOMO energy level of the fourth compound.

By doing so, the photocurrent density under the exposure of light or irradiation may be further improved.

According to an embodiment, if the electron acceptor compound is not the third compound and the electron acceptor compound is not in direct contact to the first semiconductor layer, then the third compound has a LUMO energy level equal or smaller than the LUMO energy level of the electron acceptor compound or the difference between LUMO energy level of the electron acceptor compound and the LUMO energy level of the third compound is equal or larger than -0.4 eV; equal or larger than -0.3 eV; equal or larger than -0.2 eV; equal or larger than -0.1 eV; or equal or larger than -0.05 eV; and/or
if the electron donor compound is a not the fourth compound and the electron donor compound is not in direct contact to the second semiconductor layer, then the fourth compound has a HOMO energy level equal or larger than the HOMO energy level of the electron donor compound or the difference between the HOMO energy level of the electron donor compound and the HOMO energy level of the fourth compound is equal or smaller than -0.4 eV; equal or smaller than -0.3 eV; equal or smaller than -0.2 eV; equal or smaller than -0.1 eV; or equal or smaller than -0.05 eV. By doing so, the photocurrent density under the exposure of light or irradiation may be further improved.

According to an embodiment, if the electron acceptor compound is not the third compound and the electron acceptor compound is not in direct contact to the first semiconductor layer, then the third compound has a LUMO energy level equal or smaller than the LUMO energy level of the electron acceptor compound or the difference between LUMO energy level of the electron acceptor compound and the LUMO energy level of the third compound is equal or larger than -0.4 eV; or
if the electron acceptor compound is the third compound then the first compound has a HOMO energy level equal or smaller than the LUMO energy level of the third compound;and/or
if the electron donor compound is a not the fourth compound and the electron donor compound is not in direct contact to the second semiconductor layer, then the fourth compound has a HOMO energy level equal or larger than the HOMO energy level of the electron donor compound or the difference between the HOMO energy level of the electron donor compound and the HOMO energy level of the fourth compound is equal or smaller than 0.4 eV. By doing so, the photocurrent density under the exposure of light or irradiation may be further improved.

According to an embodiment, if the electron acceptor compound is not the third compound and the electron acceptor compound is not in direct contact to the first semiconductor layer, then the third compound has a LUMO energy level equal or smaller than the LUMO energy level of the electron acceptor compound or the difference between LUMO energy level of the electron acceptor compound and the LUMO energy level of the third compound is equal or larger than -0.3 eV; or
if the electron acceptor compound is the third compound then the first compound has a HOMO energy level equal or smaller than the LUMO energy level of the third compound; and/or
if the electron donor compound is a not the fourth compound and the electron donor compound is not in direct contact to the second semiconductor layer, then the fourth compound has a HOMO energy level equal or larger than the HOMO energy level of the electron donor compound or the difference between the HOMO energy level of the electron donor compound and the HOMO energy level of the fourth compound is equal or smaller than 0.3 eV; or
if the electron donor compound is the fourth compound, then the second compound has a LUMO energy level equal or larger than HOMO energy level of the fourth compound.

By doing so, the photocurrent density under the exposure of light or irradiation may be further improved.

According to an embodiment, if the electron acceptor compound is not the third compound and the electron acceptor compound is not in direct contact to the first semiconductor layer, then the third compound has a LUMO energy level equal or smaller than the LUMO energy level of the electron acceptor compound or the difference between LUMO energy level of the electron acceptor compound and the LUMO energy level of the third compound is equal or larger than -0.2 eV; or
if the electron acceptor compound is the third compound then the first compound has a HOMO energy level equal or smaller than the LUMO energy level of the third compound; and/or
if the electron donor compound is a not the fourth compound and the electron donor compound is not in direct contact to the second semiconductor layer, then the fourth compound has a HOMO energy level equal or larger than the HOMO energy level of the electron donor compound or the difference between the HOMO energy level of the electron donor compound and the HOMO energy level of the fourth compound is equal or smaller 0.2 eV; or
if the electron donor compound is the fourth compound, then the second compound has a LUMO energy level equal or larger than HOMO energy level of the fourth compound.

By doing so, the photocurrent density under the exposure of light or irradiation may be further improved.

According to an embodiment, if the electron acceptor compound is not the third compound and the electron acceptor compound is not in direct contact to the first semiconductor layer, then the third compound has a LUMO energy level equal or smaller than the LUMO energy level of the electron acceptor compound or the difference between LUMO energy level of the electron acceptor compound and the LUMO energy level of the third compound is equal or larger than -0.1 eV; or
if the electron acceptor compound is the third compound then the first compound has a HOMO energy level equal or smaller than the LUMO energy level of the third compound; and/or
if the electron donor compound is a not the fourth compound and the electron donor compound is not in direct contact to the second semiconductor layer, then the fourth compound has a HOMO energy level equal or larger than the HOMO energy level of the electron donor compound or the difference between the HOMO energy level of the electron donor compound and the HOMO energy level of the fourth compound is equal or smaller 0.1 eV; or
if the electron donor compound is the fourth compound, then the second compound has a LUMO energy level equal or larger than HOMO energy level of the fourth compound.

By doing so, the photocurrent density under the exposure of light or irradiation may be further improved.

According to an embodiment, if the electron acceptor compound is not the third compound and the electron acceptor compound is not in direct contact to the first semiconductor layer, then the third compound has a LUMO energy level equal or smaller than the LUMO energy level of the electron acceptor compound or the difference between LUMO energy level of the electron acceptor compound and the LUMO energy level of the third compound is equal or larger than -0.05 eV; or
if the electron acceptor compound is the third compound then the first compound has a HOMO energy level equal or smaller than the LUMO energy level of the third compound; and/or
if the electron donor compound is a not the fourth compound and the electron donor compound is not in direct contact to the second semiconductor layer, then the fourth compound has a HOMO energy level equal or larger than the HOMO energy level of the electron donor compound or the difference between the HOMO energy level of the electron donor compound and the HOMO energy level of the fourth compound is equal or smaller 0.05 eV; or
if the electron donor compound is the fourth compound, then the second compound has a LUMO energy level equal or larger than HOMO energy level of the fourth compound.

By doing so, the photocurrent density under the exposure of light or irradiation may be further improved.

According to an embodiment, if the electron acceptor compound is not the third compound and the electron acceptor compound is not in direct contact to the first semiconductor layer, then the third compound has a LUMO energy level smaller than the LUMO energy level of the electron acceptor compound; or
if the electron acceptor compound is the third compound then the first compound has a HOMO energy level equal or smaller than the LUMO energy level of the third compound;
   and/or
if the electron donor compound is a not the fourth compound and the electron donor compound is not in direct contact to the second semiconductor layer, then the fourth compound has a HOMO energy level equal or larger than the HOMO energy level of the electron donor compound; or if the electron donor compound is the fourth compound, then the second compound has a LUMO energy level equal or larger than HOMO energy level of the fourth compound. By doing so, the photocurrent density under the exposure of light or irradiation may be further improved.

According to an embodiment, the difference between the LUMO energy level of the electron acceptor compound and the HOMO energy level of the electron donor compound is larger than 0.15 eV, preferably larger than 0.2 eV, more preferably larger than 0.5 eV, and most preferably larger than 0.7 eV. By doing so, undesired doping, especially of compounds contained in the intermediate layer system, can for many applications be reduced or avoided. In particular the dark current density may be reduced.

According to an embodiment, the difference between the LUMO energy level of the any compound in the first semiconductor layer and the HOMO energy level of any compound contained in the layer of the intermediate layer system that is in direct contact to the first semiconductor layeris preferably larger than -0.15 eV, more preferably larger than 0.5 eV, even more preferably larger than 1.0 eV, and most preferably larger than 2.0 eV. By doing so, undesired doping, especially of compounds contained in the intermediate layer system, can for many applications be reduced or avoided. In particular the dark current density may be reduced.

According to an embodiment, the third compound has hole-blocking properties.

According to an embodiment, the third compound is a donor material with a LUMO energy level in the range of ≥ -4.0 eV to ≤ -1.0 eV, preferably ≥ -4.0 eV to ≤ -2.0 eV, more preferably ≥ - 4.0 eV to ≤-2.5 eV.

According to an embodiment, the donor material comprises a phthalocyanine compound, a perylene-based compound, a squaraine dye compound, subphthalocyanine (SubPc), zinc phthalocyanine (ZnPc), ditolyaminothienyl-benzothiadiazole-dicyanovinylene (DTDCTB), lead phthalocyanine (PbPc), 5,10,15,20-Tetraphenyl bisbenz[5,6]indeno[1,2,3-cd: 1',2',3'-lm]perylene (DBP), copper phthalocyanine (CuPc), tin phthalocyanine (SnPc), quinacridone, quinacridone-derivatives

According to an embodiment, the third compound is an electron acceptor compound.

According to an embodiment, the third compound is an acceptor material with a LUMO LUMO energy level in the range of ≥ -4.5 eV to ≤ -2.5 eV, preferably ≥ -4.5 eV to ≤ -3.0 eV.

According to an embodiment, the third compound is a compound comprising a mono-6-membered heteroaryl comprising one, two, three or more nitrogen atoms, preferably one, two or three nitrogen atoms, more preferably two or three nitrogen atoms, and most preferably three nitrogen atoms, whereby all preferred embodiments as described in the context of the second compound apply *mutatis mutandis.*

According to an embodiment, the third compound comprises 2,2'-(anthracene-9,10-diylidene)dimalononitrile, Fullerene-C₇₀ [115383-22-7], Fullerence-C₆₀ [99685-96-8], [6,6]-phenyl-C₇₁-butyric acid methyl ester (abbreviation: PC₇₁BM), [6,6]-phenyl-C₆₁-butyric acid methyl ester (abbreviation: PC₆₁BM), and 1',1",4',4"-tetrahydro-di[1,4]methanonaphthaleno[1,2:2',3',56,60:2",3"][5,6]fullerene-C₆₀ (abbreviation: ICBA), a fullerene derivative, a perylene tetracarboxylic diimide (PTCDI) derivative, or a perylene tetracarboxylic dianhydride (PTCDA) derivative.

According to an embodiment, the fourth compound is an electron blocking compound

For the fourth compound all preferred embodiments as described in the context of the first compound apply *mutatis mutandis.*

### Single layer system

In case the intermediate layer system consists (only) out of a single layer then one or more of the following is especially preferred:
According to one embodiment, the electron acceptor compound is the third compound.

According to an embodiment, the electron donor compound is the fourth compound.

According to an embodiment, the electron acceptor compound is the third compound and the electron donor compound is the fourth compound.

According to an embodiment, the single layer forming the intermediate layer system, which automatically acts as the photoconversion unit, consists essentially out of the third and fourth compound.

### Double layer system

In case the intermediate layer system comprises two layers then especially the following setups are preferred:

### I) Double layer photoconversion unit

In one embodiment, the intermediate layer system consists of two layers which form the photoconversion unit, i.e. preferably one layer comprises the electron acceptor compound and the other the electron donor compound.

According to one embodiment, the electron acceptor compound is the third compound.

According to one embodiment, the electron donor compound is the fourth compound.

According to one embodiment, the intermediate layer system consists of two layers which each consists essentially of one compound, i.e. one being the third compound, one being the forth compound, which also act as electron acceptor and electron donor compounds, respectively.

### II) Single layer photoconversion unit and Hole Blocking layer

In one embodiment, the intermediate layer comprises a single-layer photoconversion unit (preferably as described above in "Single layer System) and further hole blocking layer.

This hole blocking layer is then preferably located between the first layer and the photoconversion unit and comprises the third compound.

The electron acceptor compound of the photoconversion unit may according to one embodiment then be identical to the third compound, however, according to an alternative embodiment it maybe different.

### III) Single layer photoconversion unit and Electron Blocking layer

In one embodiment, the intermediate layer comprises a single-layer photoconversion unit (preferably as described above in "Single layer System) and further electron blocking layer.

This hole blocking layer is then preferably located between the second layer and the photoconversion unit and comprises the third compound.

The electron donor compound of the photoconversion unit may according to one embodiment then be identical to the fourth compound, however, according to an alternative embodiment it maybe different.

### Triple and multiple layer system

It goes without saying that for the skilled person in the art further setups of the intermediate layer system are possible, e.g.
- Triple layer setup with a hole and electron blocking layer and a photoconversion unit as a single layer in between;
- Triple layer setup with a photoconversion unit as a double layer system and either a hole or an electron blocking layer.
- Quadruple layer setup with a hole and electron blocking layer and a photoconversion unit as a double layer in between.

If more intermediate layers are employed then more complex architectures are possible.

### Photoconversion unit

According to an embodiment, wherein the photoconversion unit comprises an acceptor layer and a donor layer.

According to an embodiment, the photoconversion unit comprises an acceptor layer and a donor layer; wherein the acceptor layer comprises an electron acceptor compound and the donor layer comprises an electron donor compound, or the acceptor layer comprises an electron acceptor compound and the donor layer comprises an electron donor compound and an electron acceptor compound.

According to an embodiment, the photoconversion unit comprises an acceptor layer and a donor layer; wherein the acceptor layer is closer to the first electrode in particular closer to the anode layer, and the donor layer is closer to the second electrode in particular closer to the cathode layer. By doing so, the photocurrent density under the exposure of light or irradiation may be further improved and/or the dark current density may be reduced.

According to an embodiment, wherein the photoconversion unit does **not** comprise a **perowskite** compound.

### Third semiconductor layer and fifth compound

According to an embodiment, wherein the organic photodetector further comprises a third semiconductor layer, wherein the third semiconductor layer is arranged between the first electrode and the first semiconductor layer and in direct contact to the first semiconductor layer, wherein the third semiconductor layer comprises or consists essentially of a fifth compound especially when the electron acceptor compound is the third compound; wherein the the fifth compound has a LUMO energy level lower than the HOMO energy level of the first compound, preferably wherein the first electrode of the organic photodetector is closer to the substrate than the second electrode of the organic photodetector, and the first electrode of the organic light-emitting device is closer to substrate than the second electrode of the organic light-emitting device, and/or the first electrode of organic photodetector is in direct contact to the substrate and the first electrode of the organic light-emitting device is in direct contact to the substrate. By doing so, the dark current density may be reduced and/or the photo current density may be increased and/or the signal to noise ratio may be increased.

According to an embodiment, wherein the third semiconductor layer is a charge extraction layer.

According to an embodiment, the third semiconductor layer is a charge extraction layer. The term "charge extraction layer" especially means a layer which facilitates the movement of positive or negative charge away from the photoconversion unit. By doing so, the dark current density may be reduced and/or the photo current density may be increased and/or the signal to noise ratio may be increased.

According to an embodiment, wherein the third semiconductor layer is a hole provision layer.

According to an embodiment, the third semiconductor layer is a hole provision layer. The term "hole provision layer" especially means a layer which facilitates the provision of holes to the photoconversion unit. In other words, a hole provision layer especially means a layer which facilitates the supply of an hole up to the photoconversion unit, facilitating the extraction of photoelectrons from the photoconversion unit. By doing so, the dark current density may be reduced and/or the photo current density may be increased and/or the signal to noise ratio may be increased.

According to one embodiment of the present invention, the third semiconductor layer may comprise at least about ≥ 0.5 wt.-% to about ≤ 100 wt.-%, preferably about ≥ 0.5 wt.-% to about ≤ 75 wt.-%, more preferred about ≥ 1 wt.-% to about ≤ 50 wt.-% and most preferred about ≥ 1 wt.-% to about ≤ 30 wt.-% of a fifth compound based on the total weight of the organic semiconductor layer.

According to an embodiment, the fifth compound has a LUMO energy level of ≤ -4.0 eV; preferably ≤ -4.5 eV; more preferably ≤ -4.9 eV, and most preferably ≤ -5.3 eV.

According to an embodiment, the fifth compound is a p-dopant.

The fifth compound may lead to a generation of a hole in the first semiconductor layer, and thus improves the photocurrent density under the exposure of light or irradiation and the signal to noise ratio in particular when the electron acceptor compound is the third compound.

### Fourth semiconductor layer and sixth compound

According to an embodiment, wherein the organic photodetector further comprises a fourth semiconductor layer, wherein the fourth semiconductor layer is arranged between the second electrode and the second semiconductor semiconductor layer and in direct contact to the second semiconductor layer, wherein the fourth semiconductor layer comprises or consists essentially of a sixth compound **especially** when the **electron donor compound is the fourth compound;**

wherein the sixth compound has a HOMO energy level larger than the LUMO energy level of the second compound, preferably wherein the first electrode of the organic photodetector is closer to the substrate than the second electrode of the organic photodetector, and the first electrode of the organic light-emitting device is closer to the substrate than the second electrode of the organic light-emitting device, and/or the first electrode of organic photodetector is in direct contact to the substrate and the first electrode of the organic light-emitting device is in direct contact to the substrate. By doing so, the dark current density may be reduced and/or the photo current density may be increased and/or the signal to noise ratio may be increased.

According to an embodiment, wherein the fourth semiconductor layer is a charge extraction layer.

According to an embodiment, wherein the fourth semiconductor layer is an electron provision layer.

The term "electron provision layer" especially means a layer which facilitates the provision of electrons to the photoconversion unit. In other words, the electron provision layer especially means a layer which facilitates the supply of an electron up to the photoconversion unit, facilitating the extraction holes from the photoconversion unit. By doing so, the dark current density may be reduced and/or the photo current density may be increased and/or the signal to noise ratio may be increased.

According to one embodiment of the present invention, the fourth semiconductor layer may comprise at least about ≥ 0.5 wt.-% to about ≤ 100 wt.-%, preferably about ≥ 0.5 wt.-% to about ≤ 75 wt.-%, more preferred about ≥ 1 wt.-% to about ≤ 50 wt.-% and most preferred about ≥ 1 wt.-% to about ≤ 30 wt.-% of a sixth compound based on the total weight of the organic semiconductor layer.

According to an embodiment, the sixth compound has a HOMO energy level of ≥ -4.5 eV; preferably ≥ -4.0 eV; more preferably ≥ -3.5eV, and most preferably ≥ -3.0 eV.

According to an embodiment, the sixth compound is an n-dopant.

### Organic photodetector

According to an embodiment, the organic photodetector has a dark current density of -1×10⁻⁴ mA/cm² or less when a Bias of +3V±0.05V is applied.

The dark current density of an organic photodetector may be measured in dark conditions by applying a voltage at +3V±0.05V.

The dark current density of an organic photodetector may be measured in dark conditions by applying a voltage at +3V±0.05V, wherein the positive pol of the current-voltage measurement device is connected to the anode layer of the organic photodetector, and wherein the negative pol of the current-voltage measurement device is connected to the cathode layer of the organic photodetector.

The voltage may be applied for a period of at least one second before the current is measured.

The minimum measurement time of the current is selected so that the effects of current fluctuations in the external grid on the measured value disappear.

The "dark current density" is the current density which is determined when the organic photodetector is not exposed to light.

The area size of the organic photodetector is determined by the area wherein the anode layer, cathode layer, and the layers between the anode layer and the cathode layer overlaps.

In the overlap of the area anode layer, cathode layer, and the layer between the anode layer and cathode layer are stacked on top of each other. The anode layer area may be defined by a pixel definition layer aperture like shown in the figures
For the measurement of the dark current density, the organic photodetector may be encapsulated. The encapsulation of the organic photodetector may be a thin film encapsulation or an encapsulation lid, wherein the encapsulation lid provides a cavity, which includes a getter material. In particular, the encapsulation lid is a glass lid.

The applying of the voltage and the measurement of the current may be conducted by means of a Keithley SM2635B.

When using a Keithley SM2635B, the voltage may be applied for a period of at least one second before the current is measured with a minimum measurement time of the current, wherein the minimum measurement time of the current is selected so that the effects of the current fluctuations in the external grid on the measured value disappear.

When using a Keithley SM2635B, the minimum measurement time of the current is at least 5 NPLC (Number of Power Line-Cycles).

### Organic light emitting device

According to an embodiment of the present invention, the organic light emitting device comprises a first electrode, a second electrode, a semiconductor layer, and a light-emitting layer;
wherein the semiconductor layer and light-emitting layer are arranged between the first electrode and the second electrode;
wherein the semiconductor layer is arranged between the light-emitting layer and the second electrode.

According to an embodiment, the second semiconductor layer of the organic photodetector is an electron transport layer and/or hole blocking layer, and the semiconductor layer of the organic light-emitting device is an electron transport layer and/or hole blocking layer.

According to an embodiment, the common semiconductor layer is a common electron transport layer and/or common hole blocking layer .

According to an embodiment, the common semiconductor layer is a common electron transport layer and/or hole blocking layer shared by at least one organic photodetector and at least one light-emitting device.

According to an embodiment, the second semiconductor layer of the organic photodetector is an electron transport layer and/or hole blocking layer, and semiconductor layer of the organic light-emitting device is an electron transport layer and/or hole blocking layer, wherein the common semiconductor layer is a common electron transport layer and/or hole blocking layer.

According to an embodiment, the second semiconductor layer of the organic photodetector is an electron transport layer and/or hole blocking layer, and semiconductor layer of the organic light-emitting device is an electron transport layer and/or hole blocking layer, wherein the common semiconductor layer is a common electron transport layer and/or hole blocking layer, shared by at least one organic photodetector and at least one light-emitting device.

According to an embodiment, the second semiconductor layer of the organic photodetector is an electron transport layer and/or hole blocking layer, and semiconductor layer of the organic light-emitting device is an electron transport layer and/or hole blocking layer, wherein the electron transport layer and/or hole blocking layer of the organic photodetector and the electron transport layer and/or hole blocking layer of the organic light-emitting device form a common electron transport layer and/or common hole blocking layer shared by at least one organic photodetector and at least one organic light-emitting device.

According to an embodiment, wherein the organic photodetector comprises a hole transport region, wherein the hole transport region of the organic photodetector is arranged between the photoconversion unit and the first electrode of the organic photodetector,
and
wherein the organic light-emitting device comprises a hole transport region, wherein the hole transport region of the organic light-emitting device is arranged between the light-emitting layer and the first electrode of the organic light-emitting device;
and wherein the hole transport region of the organic photodetector and the hole transport region of the organic light-emitting device form a **common hole transport region** shared by at least one organic photodetector and at least one organic light-emitting device.

According to an embodiment, wherein the hole transport region of the organic photodetector comprises a hole injection layer and/or a hole transport layer; and wherein the hole transport region of the organic light-emitting device comprises a hole injection layer and/or a hole transport layer.

According to an embodiment, wherein the hole transport region of the organic photodetector comprises a hole injection layer and/or a hole transport layer, wherein the hole injection layer of the organic photodetector is in direct contact to the first electrode; and wherein the hole transport region of the organic light-emitting device comprises a hole injection layer and/or a hole transport layer, wherein the hole injection layer of the organic photodetector is in direct to the first electrode.

According to an embodiment, wherein the common hole transport region comprises a common hole injection layer and/or a common hole transport layer.

According to an embodiment, wherein the common hole transport region comprises a common hole injection layer and/or a common hole transport layer, wherein the common hole injection layer is in direct contact to the first electrode.

According to an embodiment, the organic light-emitting device is not on top of the organic photodetector.

According to an embodiment, the first electrode of the organic photodetector and the first electrode of the organic light-emitting device are positively charged, and the second electrode of the photodetector and the second electrode of the organic light-emitting device are negatively charged.

According to an embodiment, the first electrode of organic photodetector is an anode layer, the second electrode of the organic photodetector is a cathode layer, the first electrode of the organic light-emitting device is an anode layer, and the second electrode of the organic light-emitting device is a cathode layer.

According to an embodiment, the first electrode of the organic photodetector is closer to the substrate than the second electrode of the organic photodetector, and the first electrode of the organic light-emitting device is closer to the substrate than the second electrode of the organic light-emitting device.

According to an embodiment, the first electrode of the organic photodetector is in direct contact to the substrate, and the first electrode of the organic light-emitting device is in direct contact to the substrate.

According to an embodiment, the first electrode of the organic photodetector and the first electrode of the organic light-emitting device are positively charged, and the second electrode of the photodetector and the second electrode of the organic light-emitting device are negatively charged, wherein the first electrode of the organic photodetector is closer to the substrate than the second electrode of the organic photodetector, and the first electrode of the organic light-emitting device is closer to the substrate than the second electrode of the organic light-emitting device.

According to an embodiment, the first electrode of the organic photodetector and the first electrode of the organic light-emitting device are positively charged, and the second electrode of the photodetector and the second electrode of the organic light-emitting device are negatively charged, wherein the first electrode of the organic photodetector is in direct contact to the substrate, and the first electrode of the organic light-emitting device is in direct contact to the substrate.

According to an embodiment, the second electrode of the organic photodetector and the second electrode of the organic light-emitting device form a common second electrode shared by at least one organic photodetector and at least one organic light-emitting device.

According to an embodiment, the second electrode of the organic photodetector is a cathode layer, and the second electrode of the organic light-emitting device is cathode layer, wherein the cathode layer of the organic photodetector and the cathode layer of the organic light-emitting device form a common cathode layer shared by at least one organic photodetector and at least one organic light-emitting device.

### Further layers

In accordance with the invention, the display, the first and/or second pixel, the organic photodetector and/or the organic light-emitting device may comprise, besides the layers already mentioned above, further layers. It is noted that layers may be, depending on the actual embodiment, present in more than one or even all sub-devices of the display, especially both in the organic photodetector and the organic light-emitting device. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

### Anode layer

The anode layer, also named anode electrode, may be formed by depositing or sputtering a material that is used to form the anode layer. The material used to form the anode layer may be a high work-function material, so as to facilitate hole injection. The anode layer may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode layer. The anode layer may also be formed using metals, typically silver (Ag), gold (Au), or metal alloys.

The anode layer may comprise two or more anode sub-layers.

According to one embodiment, the anode layer comprises a first anode sub-layer and a second anode sub-layer, wherein the first anode sub-layer is arranged closer to the substrate and the second anode sub-layer is arranged closer to the cathode layer.

According to one embodiment, the anode layer may comprise a first anode sub-layer comprising or consisting of Ag or Au and a second anode-sub-layer comprising or consisting of transparent conductive oxide.

According to one embodiment, the anode layer comprises a first anode sub-layer, a second anode sub-layer and a third anode sub-layer, wherein the first anode sub-layer is arranged closer to the substrate and the second anode sub-layer is arranged closer to the cathode layer, and the third anode sub-layer is arranged between the substrate and the first anode sub-layer.

According to one embodiment, the anode layer may comprise a first anode sub-layer comprising or consisting of Ag or Au, a second anode-sub-layer comprising or consisting of transparent conductive oxide and optionally a third anode sub-layer comprising or consisting of transparent conductive oxide. Preferably the first anode sub-layer may comprise or consists of Ag, the second anode-sublayer may comprise or consists of ITO or IZO and the third anode sub-layer may comprises or consists of ITO or IZO.

Preferably the first anode sub-layer may comprise or consists of Ag, the second anode-sublayer may comprise or consists of ITO and the third anode sub-layer may comprise or consist of ITO.

Preferably, the transparent conductive oxide in the second and third anode sub-layer may be selected the same.

According to one embodiment, the anode layer may comprise a first anode sub-layer comprising Ag or Au having a thickness of 100 to 150 nm, a second anode sub-layer comprising or consisting of a transparent conductive oxide having a thickness of 3 to 20 nm and a third anode sub-layer comprising or consisting of a transparent conductive oxide having a thickness of 3 to 20 nm.

It is to be understood that the third anode layer is not part of the substrate.

### Hole injection layer

A hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

### Hole transport layer

According to one embodiment of the present invention, the display may further comprise a hole transport layer, wherein the hole transport layer is arranged between the anode layer and the cathode layer.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to a preferred embodiment of the present invention, the hole transport layer may comprise a substantially covalent matrix compound.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

### Substantially covalent matrix compound/ covalent matrix compound

According to one embodiment of the present invention, at least one of the layers of the display may comprise a substantially covalent matrix compound or a covalent matrix compound.

The substantially covalent matrix compound, also named matrix compound, may be an organic aromatic matrix compounds, which comprises organic aromatic covalent bonded carbon atoms. The substantially covalent matrix compound may be an organic compound, consisting substantially from covalently bound C, H, O, N, S, which may optionally comprise also covalently bound B, P or Si. The substantially covalent matrix compound may be an organic aromatic covalent bonded compound, which is free of metal atoms, and the majority of its skeletal atoms may be selected from C, O, S, N and preferably from C, O and N, wherein the majority of atoms are C-atoms. Alternatively, the covalent matrix compound is free of metal atoms and majority of its skeletal atoms may be selected from C and N, preferably the covalent matrix compound is free of metal atoms and majority of its skeletal atoms may be selected from C and the minority of its skeletal atoms may be N.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

In one embodiment, the HOMO level of the substantially covalent matrix compound may be more negative than the HOMO level of N2,N2,N2',N2',N7,N7,N7',N7'-octakis(4-methoxyphenyl)-9,9'-spirobi[fluorene]-2,2',7,7'-tetraamine (CAS 207739-72-8) when determined under the same conditions.

In one embodiment of the present invention, the substantially covalent matrix compound may be free of alkoxy groups.

Preferably, the substantially covalent matrix compound comprises at least one arylamine moiety, alternatively a diarylamine moiety, alternatively a triarylamine moiety.

Preferably, the substantially covalent matrix compound is free of TPD or NPB.

### Compound of formula (VIa) or a compound of formula (VIb)

According to another aspect of the present invention, the substantially covalent matrix compound or covalent matrix compound, also referred to as matrix compound herein, may comprises at least one arylamine compound, diarylamine compound, triarylamine compound, a compound of formula (VIa) or a compound of formula (VIb): 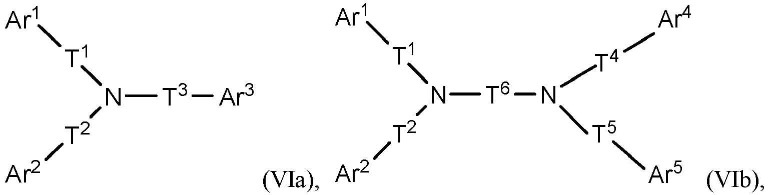 wherein:
T¹, T², T³, T⁴ and T⁵ are independently selected from a single bond, phenylene, biphenylene, terphenylene or naphthenylene, preferably a single bond or phenylene;
T⁶ is phenylene, biphenylene, terphenylene or naphthenylene;
Ar¹, Ar², Ar³, Ar⁴ and Ar⁵ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,fJazepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar¹, Ar², Ar³, Ar⁴ and Ar⁵ are selected the same or different from the group comprising H, D, F, C(-O)R², CN, Si(R²)₃, P(-O)(R²)₂, OR², S(-O)R², S(-O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic Atoms, and substituted or unsubstituted heteroaromatic ring systems having 5 to 40 aromatic Atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

Preferably, the substituents of Ar¹, Ar², Ar³, Ar⁴ and Ar⁵ are selected the same or different from the group comprising H, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl, C₃ to C₁₈ heteroaryl, a fused ring system comprising 2 to 4 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; more preferred the substituents are selected the same or different from the group consisting of H, straight-chain alkyl having 1 to 4 carbon atoms, branched alkyl having 1 to 4 carbon atoms, cyclic alkyl having 3 to 4 carbon atoms and/or phenyl.
Thereby, the compound of formula (VIa) or (VIb) may have a rate onset temperature suitable for mass production.

According to an embodiment the substantially covalent matrix compound comprises a compound of formula (VIa) or formula (VIb): 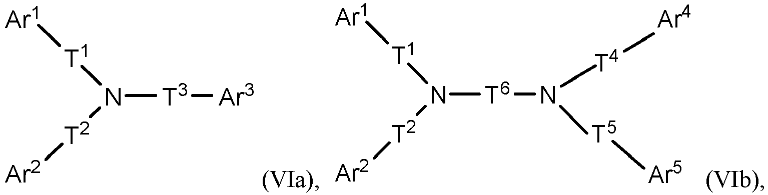 wherein
T¹, T², T³, T⁴ and T⁵ may be independently selected from a single bond, phenylene, biphenylene, terphenylene or naphthenylene, preferably a single bond or phenylene;
T⁶ is phenylene, biphenylene, terphenylene or naphthenylene;
Ar¹, Ar², Ar³, Ar⁴ and Ar⁵ may be independently selected from unsubstituted C₆ to C₂₀ aryl, or unsubstituted C₃ to C₂₀ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,fJazepine, unsubstituted 9,9'-spirobi[fluorene], unsubstituted spiro[fluorene-9,9'-xanthene], or a unsubstituted aromatic fused ring system comprising at least three unsubstituted aromatic rings selected from the group comprising unsubstituted non-hetero, unsubstituted hetero 5-member rings, unsubstituted 6-member rings and/or unsubstituted 7-member rings, unsubstituted fluorene, or a fused ring system comprising 2 to 6 unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle.

According to an embodiment, the substantially covalent matrix compound comprises a compound of formula (VIa) or formula (VIb): 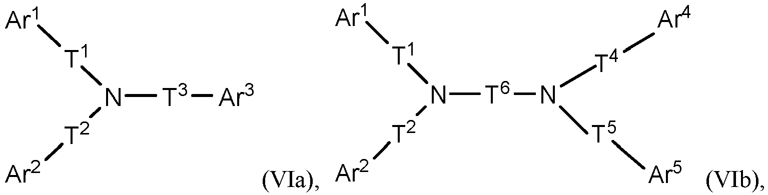 wherein
T¹, T², T³, T⁴ and T⁵ may be independently selected from a single bond, phenylene, biphenylene, terphenylene or naphthenylene, preferably a single bond or phenylene;
T⁶ is phenylene, biphenylene, terphenylene or naphthenylene;
Ar¹, Ar², Ar³, Ar⁴ and Ar⁵ may be independently selected from unsubstituted C₆ to C₂₀ aryl, or unsubstituted C₃ to C₂₀ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene].

Thereby, the compound of formula (VIa) or (VIb) may have a rate onset temperature suitable for mass production.

According to an embodiment wherein T¹, T², T³, T⁴ and T⁵ may be independently selected from a single bond, phenylene, biphenylene or terphenylene.

According to an embodiment wherein T¹, T², T³, T⁴ and T⁵ may be independently selected from phenylene, biphenylene or terphenylene and one of T¹, T², T³, T⁴ and T⁵ are a single bond. According to an embodiment wherein T¹, T², T³, T⁴ and T⁵ may be independently selected from phenylene or biphenylene and one of T¹, T², T³, T⁴ and T⁵ are a single bond.

According to an embodiment wherein T¹, T², T³, T⁴ and T⁵ may be independently selected from phenylene or biphenylene and two of T¹, T², T³, T⁴ and T⁵ are a single bond.

According to an embodiment wherein T¹, T² and T³ may be independently selected from phenylene and one of T¹, T² and T³ are a single bond.

According to an embodiment wherein T¹, T² and T³ may be independently selected from phenylene and two of T¹, T² and T³ are a single bond.

According to an embodiment wherein T⁶ may be phenylene, biphenylene, terphenylene. According to an embodiment wherein T⁶ may be phenylene.

According to an embodiment wherein T⁶ may be biphenylene. According to an embodiment wherein T⁶ may be terphenylene.

According to an embodiment wherein Ar¹, Ar², Ar³, Ar⁴ and Ar⁵ may be independently selected from formulae (G1) to (G16): 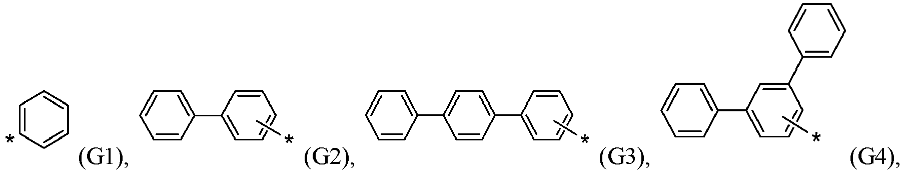 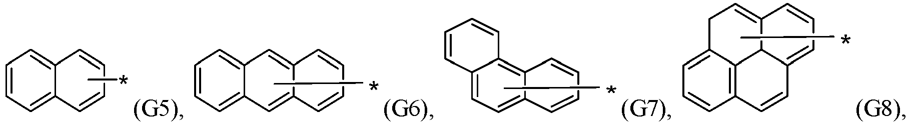 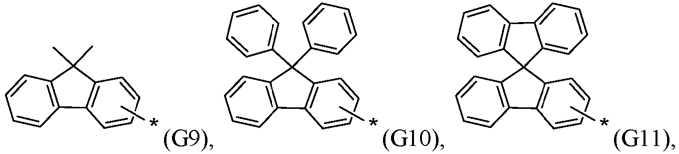 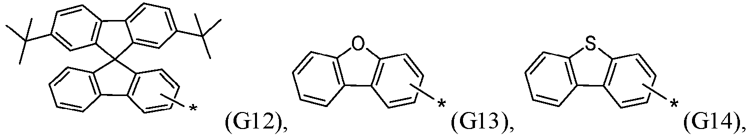 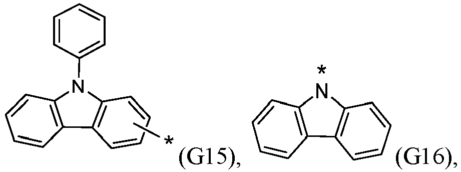 wherein the asterix "*" denotes the binding position.

According to an embodiment, Ar¹, Ar², Ar³, Ar⁴ and Ar⁵ may be independently selected from (G1) to (G15); alternatively selected from (G1) to (G10) and (G13) to (G15).

According to an embodiment, Ar¹, Ar², Ar³, Ar⁴ and Ar⁵ may be independently selected from the group consisting of (G1), (G2), (G5), (G7), (G9), (G10), (G13) to (G16).

The rate onset temperature may be in a range particularly suited to mass production, when Ar¹, Ar², Ar³, Ar⁴ and Ar⁵ are selected in this range.

The "matrix compound of formula (VIa) or formula (VIb) " may be also referred to as "hole transport compound".

According to one embodiment the compound of formula (VIa) or formula (VIb) may comprises at least ≥ 1 to ≤ 6 substituted or unsubstituted aromatic fused ring systems comprising heteroaromatic rings.

According to one embodiment the compound of formula (VIa) or formula (VIb) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings.

According to one embodiment the compound of formula (VIa) or formula (VIb) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings, and at least ≥ 1 to ≤ 3 substituted or unsubstituted unsaturated 5- to 7-member ring of a heterocycle, further preferred 3 or 4 substituted or unsubstituted aromatic fused ring systems comprising heteroaromatic rings and optional at least ≥ 1 to ≤ 3 substituted or unsubstituted unsaturated 5- to 7-member ring of a heterocycle, and additional preferred wherein the aromatic fused ring systems comprising heteroaromatic rings are unsubstituted and optional at least ≥ 1 to ≤ 3 unsubstituted unsaturated 5- to 7-member ring of a heterocycle.

According to one embodiment the compound of formula (VIa) or formula (VIb) may comprise:
- a substituted or unsubstituted aromatic fused ring systems with at least ≥ 2 to ≤ 6, preferably ≥ 3 to ≤ 5, or 4 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5-to 7- member ring of a heterocycle; or
- an unsubstituted aromatic fused ring systems with at least ≥ 2 to ≤ 6, preferably ≥ 3 to ≤ 5, or 4 fused aromatic rings selected from the group comprising unsubstituted non-hetero aromatic rings, unsubstituted hetero 5-member rings, unsubstituted 6-member rings and/or unsubstituted unsaturated 5- to 7-member ring of a heterocycle.

It should be noted here that the wording "aromatic fused ring system" may include at least one aromatic and at least one substituted or unsubstituted unsaturated 5- to 7- member ring. It should be noted here that the substituted or unsubstituted unsaturated 5- to 7- member ring may not be an aromatic ring.

According to one embodiment, the substantially covalent matrix compound comprises at least one naphthyl group, carbazole group, dibenzofurane group, dibenzothiophene group and/or substituted fluorenyl group, wherein the substituents are independently selected from methyl, phenyl or fluorenyl.

According to an embodiment of the present invention, the compound of formula (VIa) or formula (VIb) are selected from formulae (W1) to (W23): 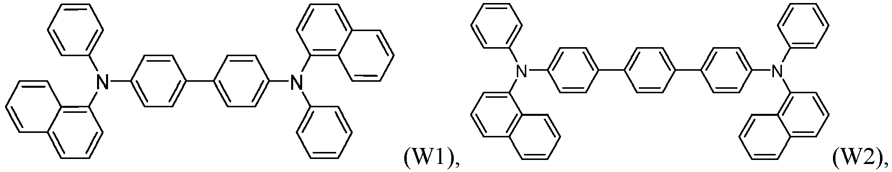 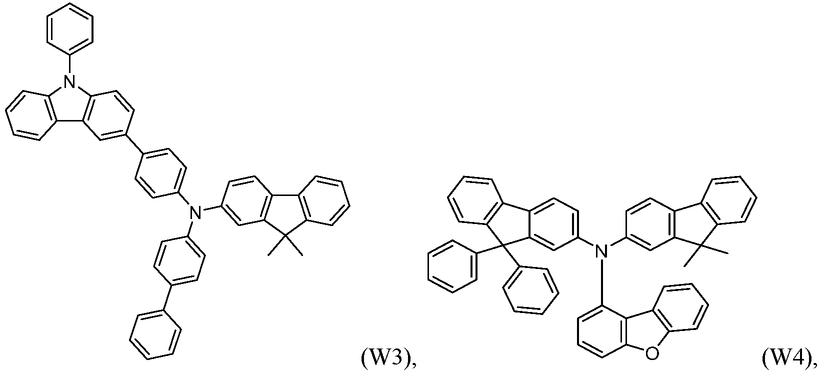 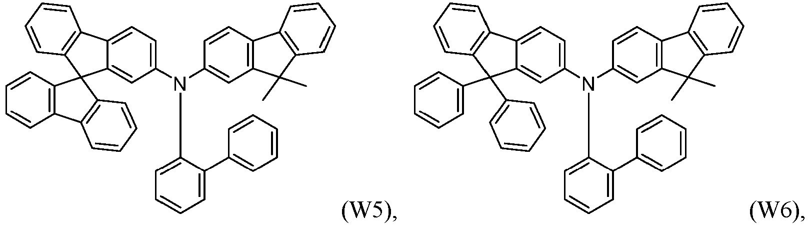 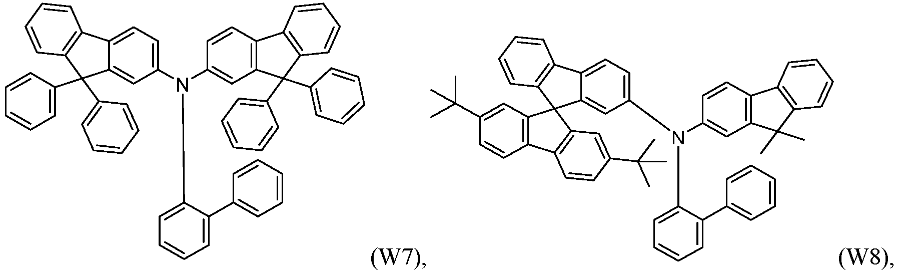 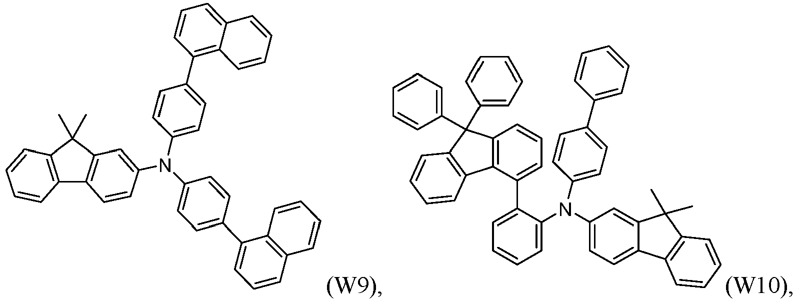 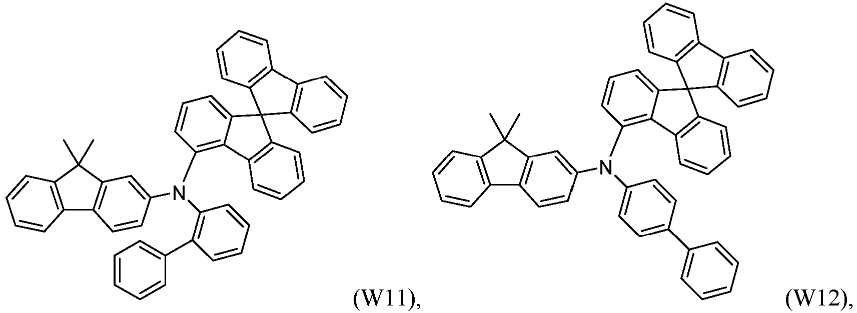 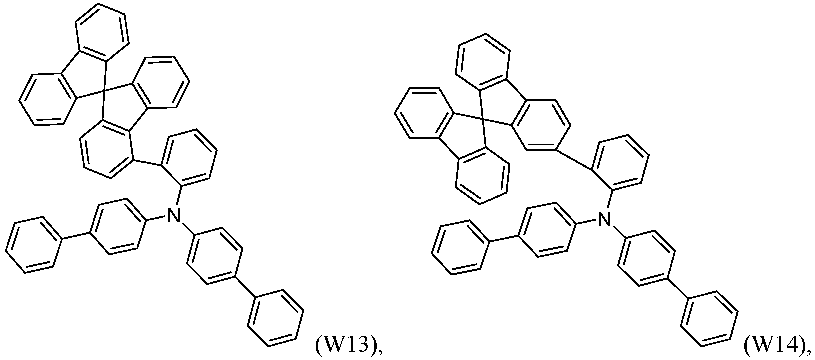 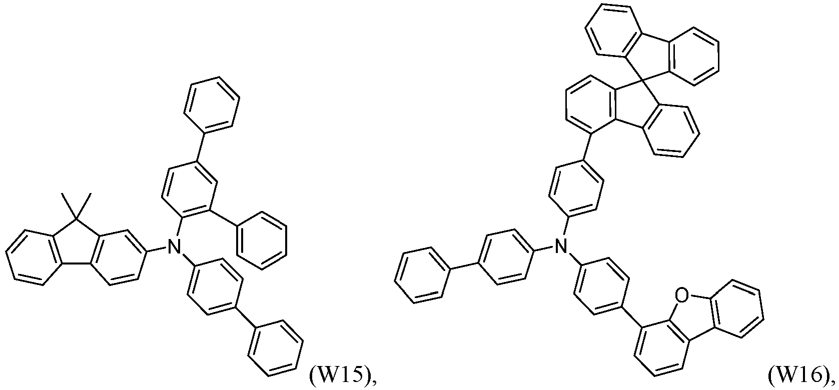 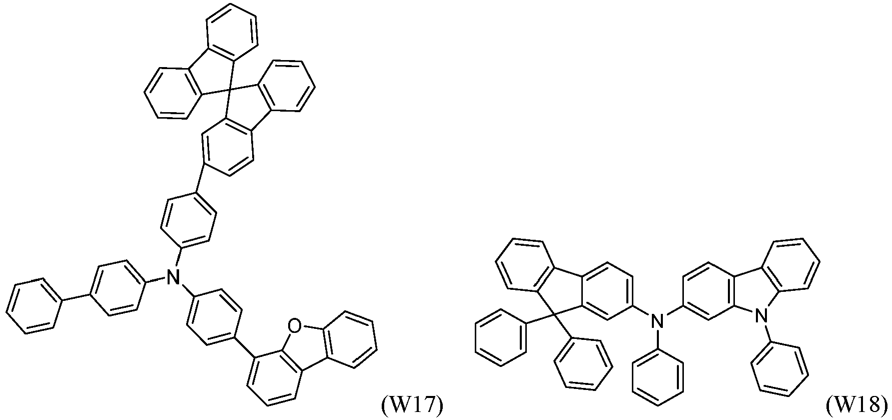 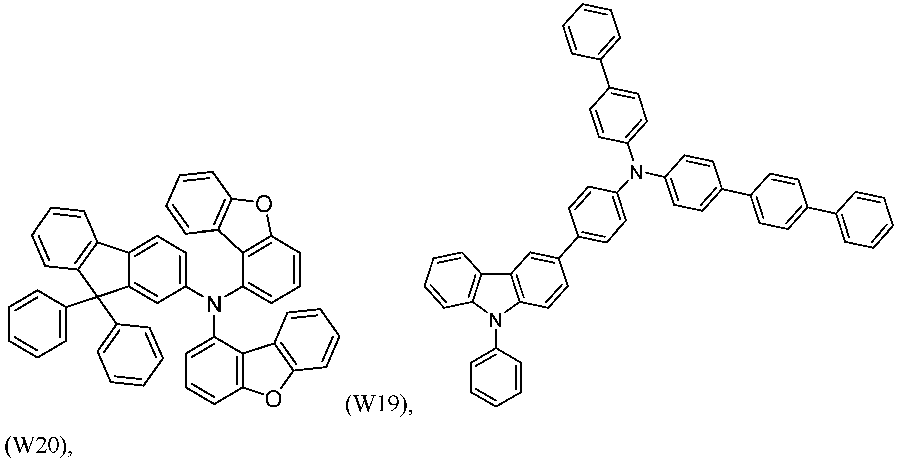 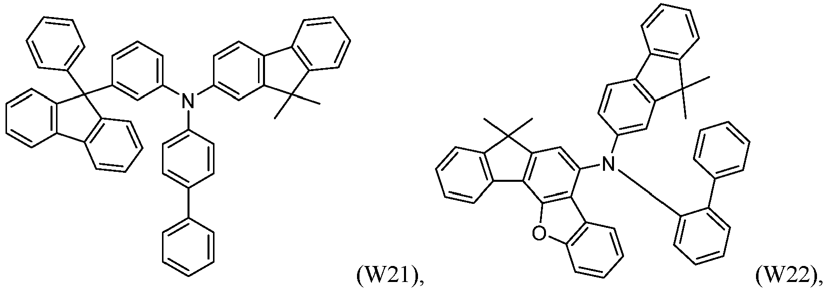 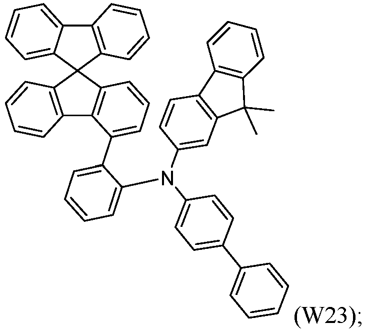 preferably the compound of formula (VIa) or formula (VIb) is selected from formulae (W3) to (W23), more preferred from (W4) to (W23), most preferred from (W18).

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime may be improved.

The electron blocking layer comprises an electron blocking compound.

Typically, the electron blocking layer comprises a triarylamine compound such as N,N-di([1,1'-biphenyl]-4-yl)-7,7-dimethyl-7H-fluoreno[4,3-b]benzofuran-10-amine ([1616706-52-5]), ]), N,N-di([1,1'-biphenyl]-4-yl)-4'-(9H-carbazol-9-yl)-[1,1'-biphenyl]-4-amine ([1069137-74-1]), N,N-di([1,1'-biphenyl]-4-yl)-9-phenyl-9H-carbazol-2-amine ([1259388-72-1]), N¹-([1,1'-biphenyl]-4-yl)-N³-(dibenzo[b,d]thiophen-2-yl)-N¹,N³-diphenyl-5-(9-phenyl-9H-carbazol-2-yl)benzene-1,3-diamine ([1869085-48-2]), N¹-([1,1'-biphenyl]-4-yl)-N³,N³-diphenyl-N¹-(8-(9-phenyl-9H-carbazol-2-yl)dibenzo[b,d]thiophen-2-yl)benzene-1,3-diamine ([2055861-88-4]), N⁷-(dibenzo[b,d]thiophen-3-yl)- N²,N²,N⁷-triphenyldibenzo[b,d]thiophene-2,7-diamine ([2033134-06-2]), 7-(4-(dibenzo[b,d]thiophen-3-yl(phenyl)amino)phenyl)-N,N-diphenyldibenzo[b,d]thiophen-2-amine ([2641671-54-5]), N-([1,1'-biphenyl]-4-yl)-9,9-dimethyl-N-(3-(9-phenyl-9H-fluoren-9-yl)phenyl)-9H-fluoren-2-amine (2226747-62-0), N-([1,1'-biphenyl]-2-yl)-N-(9,9-dimethyl-9H-fluoren-2-yl)-9,9'-spirobi[fluoren]-4-amine ([1450933-44-4]), N-([1,1'-biphenyl]-4-yl)-N-(2-(9,9-diphenyl-9H-fluoren-4-yl)phenyl)-9,9-dimethyl-9H-fluoren-2-amine ([1792219-00-1]), 2',7'-di-tert-butyl-N,N-bis(9,9-dimethyl-9H-fluoren-2-yl)-9,9'-spirobi[fluoren]-4-amine ([2379778-94-4]),
N,N-di([1,1'-biphenyl]-4-yl)-3'-(9H-carbazol-9-yl)-[1,1'-biphenyl]-4-amine ([1464822-27-2]),
N,N-bis(4-(dibenzo[b,d]furan-4-yl)phenyl)-[1,1':4',1"-terphenyl]-4-amine ([N,N-bis(4-(dibenzo[b,d]furan-4-yl)phenyl)-[1,1':4',1"-terphenyl]-4-amine]) ([1198399-61-9]),
N-(4-(naphthalen-1-yl)phenyl)-N-(3-(6-phenyldibenzo[b,d]furan-4-yl)phenyl)naphthalen-1-amine ([1868149-26-1]),
N,9,9-triphenyl-N-(4'-(triphenylsilyl)-[1,1'-biphenyl]-4-yl)-9H-fluoren-2-amine ([2209040-18-4]),
N-([1,1'-biphenyl]-4-yl)-N-(4-(phenanthren-9-yl)phenyl)-[1,1': 4',1"-terphenyl]-4-amine ([2233544-05-1]),
N-([1,1'-biphenyl]-4-yl)-9,9-diphenyl-N-(4-(triphenylsilyl)phenyl)-9H-fluoren-2-amine ([1613079-70-1]),
N-([1,1'-biphenyl]-4-yl)-3'-(9H-carbazol-9-yl)-N-(4-(dibenzo[b,d]furan-4-yl)phenyl)-[1,1'-biphenyl]-4-amine ([2245098-00-2]),
N,N-di([1,1'-biphenyl]-4-yl)-9,9'-spirobi[fluoren]-2-amine ([1364602-86-7]), N,N-di([1,1'-biphenyl]-4-yl)-3'-(dibenzo[b,d]furan-4-yl)-[1,1'-biphenyl]-4-amine ([N,N-di([1,1'-biphenyl]-4-yl)-3'-(dibenzo[b,d]furan-4-yl)-[1,1'-biphenyl]-4-amine]),
N-([1,1'-biphenyl]-4-yl)-N-(4-(9-phenyl-9H-carbazol-3-yl)phenyl)-[1,1':4',1"-terphenyl]-4-amine ([1569603-30-0]),
N-(3'-(9H-carbazol-9-yl)-[1,1'-biphenyl]-4-yl)-N-([1,1'-biphenyl]-4-yl)-[1,1':4',1"-terphenyl]-4-amine ([1887177-93-6]),
N3,N3'-di([1,1'-biphenyl]-4-yl)-N3,N3'-dimesityl-[1,1'-biphenyl]-3,3'-diamine ([1887177-93-6]).

The electron blocking compound in particular a triarylamine compound may have a LUMO level closer to vacuum level than the LUMO level of the hole transport layer. The electron blocking compound may have a HOMO level that is further away from vacuum level compared to the HOMO level of the hole transport layer.

The electron blocking compound in particular a triarylamine compound may have a LUMO level closer to vacuum level than the LUMO level of the electron donor compound in the emission layer.

The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

In case the display comprises at least one organic photodetector and at least one organic light-emittting device, it is one embodiment of the present invention that at least one electron blocking layer is shared by at least one organic photodetector and by at least one organic light-emitting diode

### Photoconversion unit

The photoconversion unit converts photons into an electrical current.

The photoconversion unit may be formed by vacuum deposition, spin coating, slot-die coat-ing, printing, casting, LB deposition, or the like. When the photoconversion unit is formed using vacuum deposition or spin coating, the conditions for deposition and coating may be similar to those for the formation of the HIL. However, the conditions for deposition and coating may vary, according to the compound that is used to form the PAL.

### Emission layer (EML)

The emission layer (EML) converts an electrical current into photons.

According to an embodiment, the emission layer is arranged between the anode layer and the cathode layer, preferably the emission layer is arranged between the organic semiconductor layer and the cathode layer.

The EML may be formed by vacuum deposition, spin coating, slot-die coat-ing, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emission layer (EML) may comprise an organic emitter host and a light-emitting compound dopant. Examples of the organic emitter host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

According to a preferred embodiment of the present invention, the emission layer comprises a light-emitting compound of formula (IV): 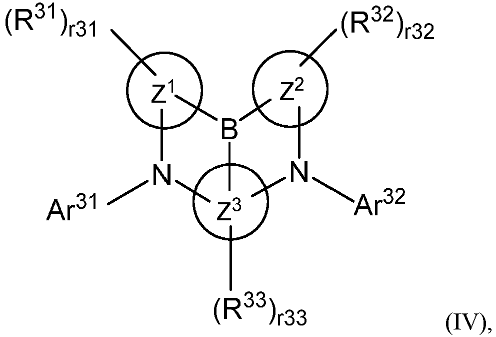 wherein
Z¹, Z² and Z³ are the same as or different from each other, and are each independently selected from the group comprising a monocyclic to polycyclic aromatic hydrocarbon ring or monocyclic to polycyclic aromatic hetero ring;
Ar³¹ and Ar³² are the same as or selected different from each other, and are each independently a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;
R³¹, R³² and R³³ are the same as or different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,
wherein one or more substituents selected from the group consisting of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;
r³¹, r³² and r³³ are each an integer from 0, 1, 2, 3 or 4, and when r³¹ to r³³ are 2 or higher, substituents in the parenthesis are the same as or different from each other.

According to one embodiment, for formula (III):
Z¹, Z² and Z³ are the same as or selected different from each other, and are each independently selected from the group comprising a monocyclic to bicyclic aromatic hydrocarbon ring, or a monocyclic to bicyclic aromatic hetero ring containing O, N or S;
Ar³¹ and Ar³² are the same as or selected different from, and are each independently selected from the group comprising an alkyl group having 1 to 10 carbon atoms, which is unsubstituted or substituted with an aryl group, an aryl group having 6 to 30 carbon atoms, which is unsubstituted or substituted with an aryl group, or a heteroaryl group having 2 to 30 carbon atoms;
R³¹, R³² and R³³ are the same as or selected different from each other, and are each independently selected from the group comprising hydrogen, deuterium, a substituted or unsubstituted alkyl group, a substituted or unsubstituted cycloalkyl group, a substituted or unsubstituted silyl group, a substituted or unsubstituted aryl group, or a substituted or unsubstituted heteroaryl group.

According to one embodiment, wherein for formula (III):
Z¹, Z² and Z³ are the same as or selected different from each other, and are each independently selected from the group comprising a benzene ring or a thiophene ring;
Ar³¹ and Ar³² are the same as or selected different from each other, and are each independently selected from the group comprising phenyl group, a biphenyl group, a naphthyl group, a dimethyl fluorenyl group, a diphenyl fluorenyl group, a dibenzofuran group, or a dibenzothiophene group;
R³¹, R³² and R³³ are the same as or selected different from each other, and are each independently selected from the group comprising hydrogen, deuterium, a substituted or unsubstituted alkyl group having 1 to 10 carbon atoms, a substituted or unsubstituted cycloalkyl group having 5 to 30 carbon atoms, a substituted or unsubstituted silyl group having 1 to 10 carbon atoms, a substituted or unsubstituted aryl group having 6 to 30 carbon atoms, or a substituted or unsubstituted heteroaryl group having 2 to 30 carbon atoms.

According to a preferred embodiment of the present invention, the emission layer comprises a light-emitting compound of formula (IV) is selected from formulae (BD1) to (BD9):

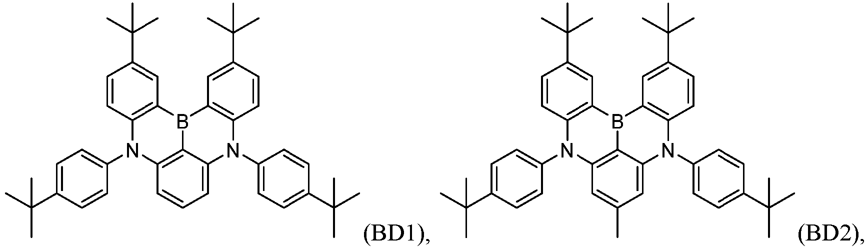

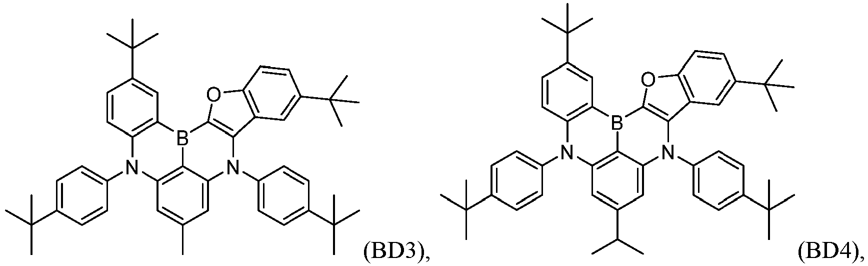

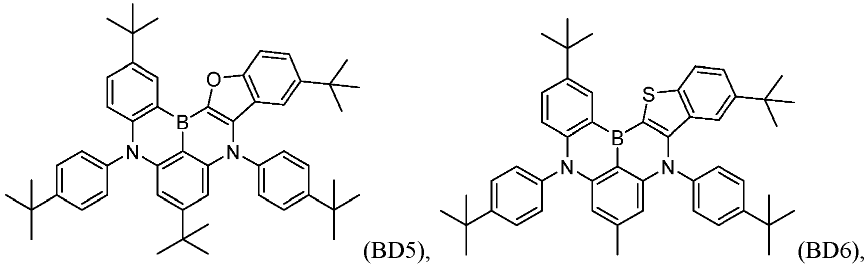

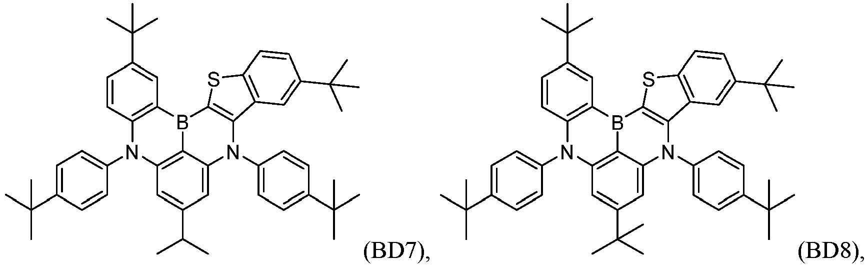

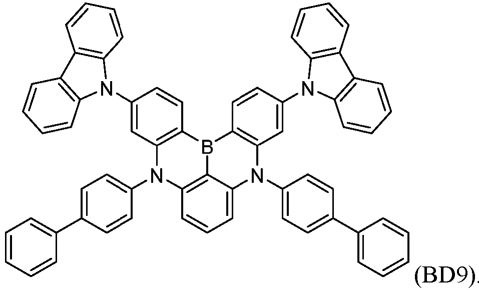

According to a preferred embodiment of the present invention, the emission layer comprises an organic emitter host compound, wherein the organic emitter host compound comprises
- at least one condensed aromatic ring system consisting of 3 to 5 rings, and
- 3 to 7 aromatic or heteroaromatic rings, wherein one or more sub-groups of the aromatic and/or heteroaromatic rings may be condensed to form fused aromatic or heteroaromatic ring systems;
wherein the molecular weight Mw of the organic emitter host compound is in the range of ≥ 400 and ≤ 2000 g/mol.

According to a preferred embodiment of the present invention, the organic emitter host compound has the formula (V) 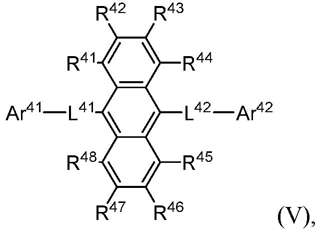 wherein
Ar⁴¹ and Ar⁴² are independently selected from substituted or unsubstituted C₆ to C₂₄ aryl, substituted or unsubstituted C₃ to C₂₄ heteroaryl;
L⁴¹ and L⁴² are independently selected from a direct bond or substituted or unsubstituted C₆ to C₂₄ arylene, substituted or unsubstituted C₃ to C₂₄ heteroarylene;
R⁴¹ to R⁴¹ are independently selected from H, D, substituted or unsubstituted C₁ to C₁₂ alkyl, substituted or unsubstituted C₆ to C₁₉ aryl, substituted or unsubstituted C₃ to C₁₂ heteroaryl;
wherein
the substituents on Ar⁴¹, Ar⁴², L⁴¹, L⁴², R⁴¹ to R⁴⁸ are independently selected from D, C₆ to C₁₀ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, halogen, F or CN.

According to a preferred embodiment of the present invention, the organic emitter host and/or compound of formula (V) is selected from formulae (BH1) to (BH13):

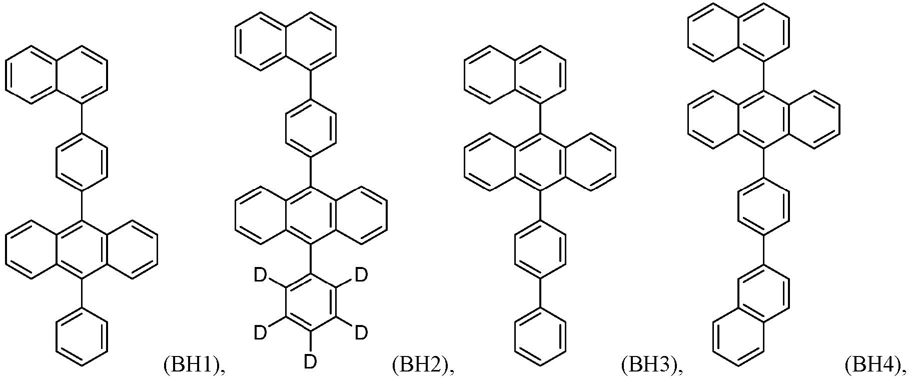

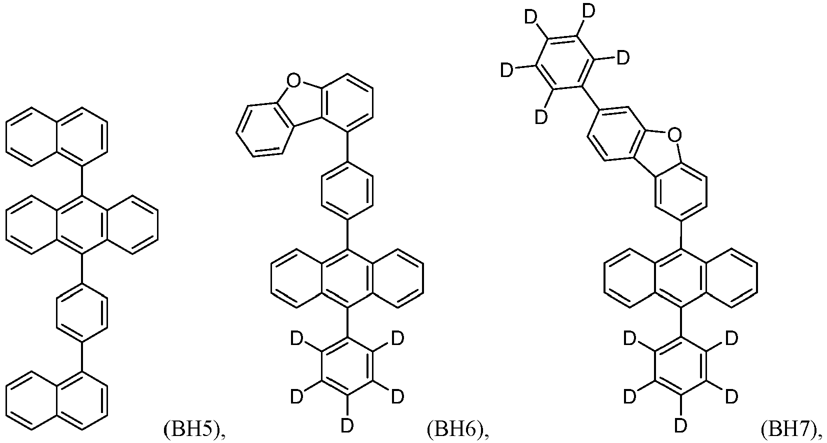

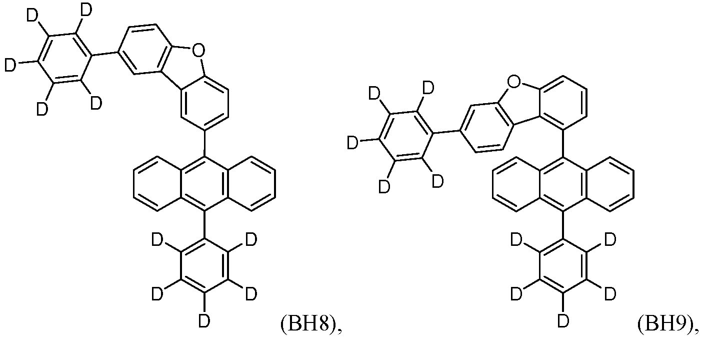

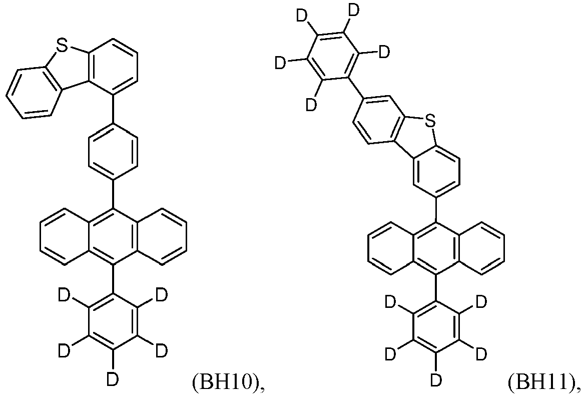

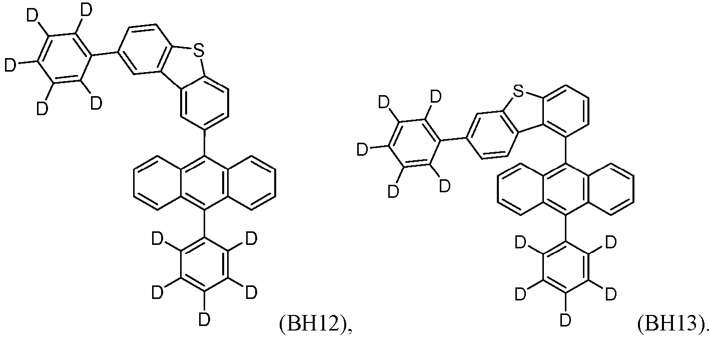

According to a preferred embodiment of the present invention, the light-emitting layer comprises a light-emitting dopant of formula (IV) and an organic emitter host of formula (V).

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and triazine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The display according to the present invention may further comprise an electron transport layer (ETL), wherein the electron transport layer is arranged between the anode layer and the cathode layer, preferably between the organic semiconductor layer and the cathode layer.

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EII, is within this range, the ETL may have satisfactory electron-injecting properties, without a substantial penalty in driving voltage.

According to another embodiment of the present invention, the display may further comprise a hole blocking layer and an electron transport layer, wherein the hole blocking layer and the electron transport layer comprise an azine compound. Preferably, the azine compound is a triazine compound.

### Electron injection layer (EIL)

An optional EIL, which may facilitates injection of electrons from the cathode, may be formed on the ETL, preferably directly on the electron transport layer. Examples of materials for forming the EII, include lithium 8-hydroxyquinolinolate (LiQ), LiF, NaCl, CsF, Li2O, BaO, Ca, Ba, Yb, Mg which are known in the art. Deposition and coating conditions for forming the EII, are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EII, is within this range, the EII, may have satisfactory electron-injecting properties, without a substantial penalty in driving voltage.

### Cathode layer

The cathode layer is formed on the ETL or optional EIL. The cathode layer may be formed of a metal, an alloy, an electrically conductive compound, or a mixture thereof. The cathode layer may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode layer may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

It is to be understood that the cathode layer is not part of an electron injection layer or the electron transport layer.

### Pixel definition layer

According to an embodiment of the invention, the display may comprise a pixel definition layer by which the organic photodetector and/or the organic-light emitting device are separated from each other.

The pixel definition layer preferably is in direct contact with the substrate.

According to one embodiment, the pixel definition layer is not positive charged and/or is not an anode or comprises an anode material, preferably the pixel definition layer comprises Si based compound, SiN, a non-positive charged oligomer and/or polymer material. Preferred oligomer material include a polyacrylate-based resin or a polyimide-based resin. Also, the pixel definition layer may futher include an inorganic matteri in addition to the polymer material as well as an light absorbing material, such a black pigment and/or a black dye, such as carbon black.

### Pixel

It goes without saying the that the device according to the present invention will comprise a plurality of first and second pixels.

According to one embodiment the ratio of first pixels (containing the photodetector) to second pixels (containing the light emitting device) will be around 1:3.

In case the organic photodetector(s) and the organic light emitting devices have a common semiconductor layer, it is especially preferred that the organic light emitting devices emits light in the red or green wavelight area.

According to an embodiment of the present invention, with a display according to the invention in operation a positive voltage is applied both on the first and second pixel.

Hereinafter, the embodiments are illustrated in more detail with reference to examples. However, the present disclosure is not limited to the following examples. Reference will now be made in detail to the exemplary aspects.

A further aspect of the present invention is related to a compound of formula (X) 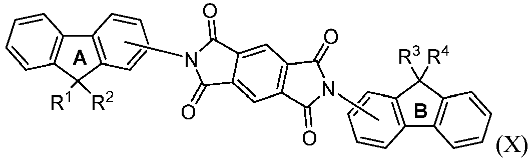 wherein
R¹, R², R³, R⁴ are independently selected from C₁ to C₄ alkyl, C₆ to C₁₂ aryl, C₂ to C₁₂ heteroaryl;
R¹ and R² together; and/or R³ and R⁴ together can form a fused ring system; and
fluorene A and/or fluorene B can be independently substituted with one or more substituents.

According to an embodiment, the compound of formula (X) is selected from formula (X-2):

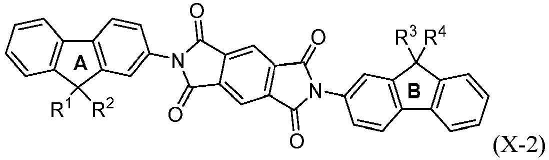

According to an embodiment, wherein the one or more substituents on fluorene A and/or fluorene B of formula (X) or (X-2) are independently selected from the substituents are selected from C₆ to C₁₈ aryl, C₃ to C₂₅ heteroaryl, D, F or CN, C₁ to C₁₆ alkyl, partially or perfluorinated C₁ to C₁₆ alkyl, partially or perdeuterated C₁ to C₁₆ alkyl, C₁ to C₁₆ alkoxy, partially or perfluorinated C₁ to C₁₆ alkoxy, partially or perdeuterated C₁ to C₁₆ alkoxy.

According to an embodiment, wherein R¹, R², R³, R⁴ of formula (X) or (X-2) are independently selected from C₁ to C₄ alkyl, C₆ to C₁₂ aryl, C₂ to C₁₂ heteroaryl; and wherein R¹ and R² together; and/or R³ and R⁴ together cannot form a fused ring system.

According to an embodiment, wherein R¹, R², R³, R⁴ of formula (X) or (X-2) are independently selected from C₁ to C₂ alkyl, C₆ to C₁₀ aryl, C₂ to C₉ heteroaryl; R¹ and R² together; and/or R³ and R⁴ together can form a fused ring system.

According to an embodiment, wherein R¹, R², R³, R⁴ of formula (X) or (X-2) are independently selected from C₁ to C₂ alkyl, C₆ to C₁₀ aryl, C₂ to C₉ heteroaryl; R¹ and R² together; and/or R³ and R⁴ together cannot form a fused ring system.

According to an embodiment, wherein fluorene A and fluorene B of formula (X) or formula (X-2) are unsubstituted.

According to an embodiment, wherein R¹, R², R³, R⁴ of formula (X) or (X-2) are independently selected from C₁ to C₄ alkyl, C₆ to C₁₂ aryl, C₂ to C₁₂ heteroaryl; and wherein R¹ and R² together; and/or R³ and R⁴ together cannot form a fused ring system, and wherein fluorene A and fluorene B of formula (X) or formula (X-2) are unsubstituted.

According to an embodiment, wherein R¹, R², R³, R⁴ of formula (X) or (X-2) are independently selected from C₁ to C₂ alkyl, C₆ to C₁₀ aryl, C₂ to C₉ heteroaryl; R¹ and R² together; and/or R³ and R⁴ together can form a fused ring system; and wherein fluorene A and fluorene B of formula (X) or formula (X-2) are unsubstituted.

According to an embodiment, wherein R¹, R², R³, R⁴ of formula (X) or (X-2) are independently selected from C₁ to C₂ alkyl, C₆ to C₁₀ aryl, C₂ to C₉ heteroaryl; R¹ and R² together; and/or R³ and R⁴ together cannot form a fused ring system; and wherein fluorene A and fluorene B of formula (X) or formula (X-2) are unsubstituted.

According to an embodiment, wherein the compound of formula (X) is selected from compound E1:

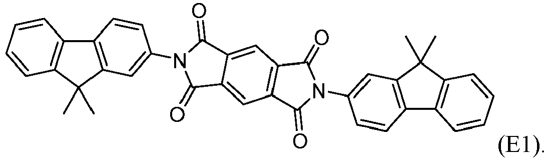

According to an embodiment, wherein the compound of formula (X) or the compound of formula (X-2) has a molecular mass in the range of ≥600 g/mol to ≤2000 g/mol, preferably from ≥600 g/mol to ≤1750 g/mol, more preferably from ≥600 g/mol to ≤1500 g/mol, and most preferably from ≥600 g/mol to ≤1250 g/mol.

Another aspect of the present invention is related to the use of a compound of formula (X) in an organic electronic device especially in a display, an organic electroluminescent device or organic photodetector.

All restrictions and/or embodiments for the compound formula (X) may apply *mutatis mutandis.*

### Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

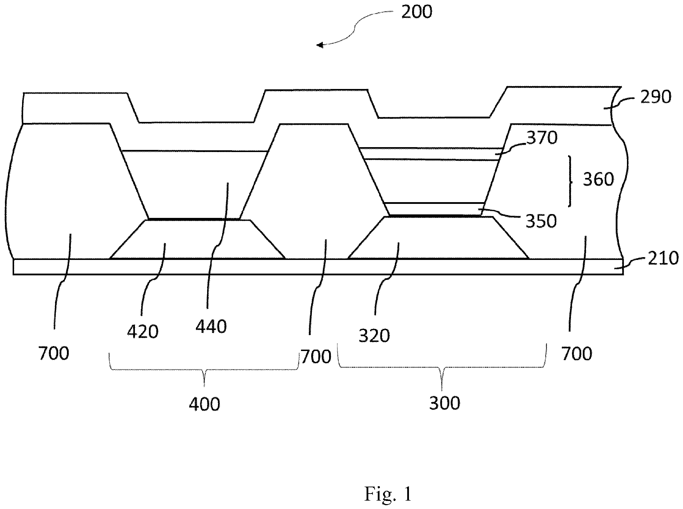

Figs 1 to 15 show each a schematic view of the display according to an exemplary embodiment of the present invention

Hereinafter, the figures 1 to 15 are illustrated in more detail with reference to examples. However, the present disclosure is not limited to the following figures, which are of exemplary nature only.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

Hereinafter, one or more exemplary embodiments of the present invention will be described in detail with reference to the following examples. However, these examples are not intended to limit the purpose and scope of the one or more exemplary embodiments of the present invention.

Referring to Fig. 1, the display 200 includes a substrate 210, an organic photodetector 300, and an organic light-emitting device 400, which are separated by a pixel definition layer 700.

The organic photodetector 300 includes a first electrode 320, a first semiconductor layer 350, a intermediate layer structure 360, a second semiconductor layer 370, and a second electrode 290.

The first semiconductor layer 350 comprises the first compound.

The intermediate layer structure 360 comprises one or more layers, the third compound and the fourth compound and a photoconversion unit (not shown), wherein the photoconversion unit can comprise one or more layers.

The photoconversion unit comprises an electron donor compound and an electron acceptor compound.

The electron acceptor compound can be the third compound or the electron acceptor compound cannot be the third compound; and the electron donor compound can be the fourth compound or the electron compound cannot be the fourth compound.

The second semiconductor layer 370 comprises the second compound.

The organic light-emitting device 400 includes a first electrode 420, a light-emitting layer 440, and a second electrode 290.

The second electrode 290 of the organic photodetector 300 and the second electrode 290 of the organic light-emitting device 400 can form a common second electrode 290 (shown); or, not shown, the organic photodetector 300; and the organic light-emitting device 400 can each have its own second electrode which are separated from each other.

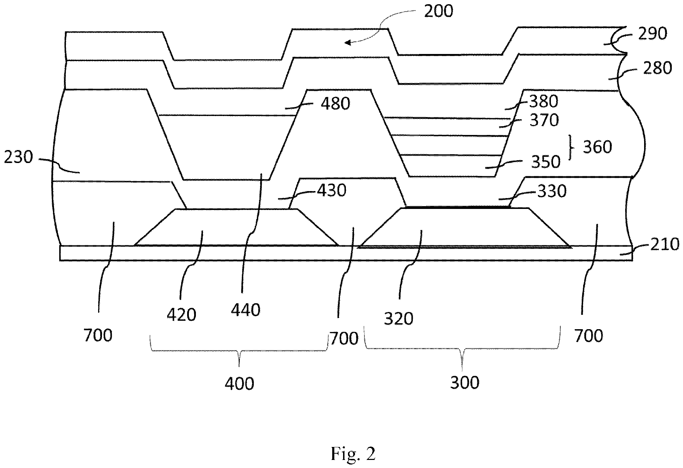

Referring to Fig. 2, the display 200 includes a substrate 210, an organic photodetector 300, and an organic light-emitting device 400, which are separated by a pixel definition layer 700.

The organic photodetector 300 includes a first electrode 320, a hole transport region 330, a first semiconductor layer 350, a intermediate layer structure 360, a second semiconductor layer 370, an electron transport layer 380, and a second electrode 290.

The first semiconductor layer 350 comprises the first compound.

The intermediate layer structure 360 comprises one or more layers, the third compound and the fourth compound and a photoconversion unit (not shown), wherein the photoconversion unit can comprise one or more layers.

The photoconversion unit comprises an electron donor compound and an electron acceptor compound.

The electron acceptor compound can be the third compound or the electron acceptor compound cannot be the third compound; and the electron donor compound can be the fourth compound or the electron compound cannot be the fourth compound.

The second semiconductor layer 370 comprises the second compound.

The organic light-emitting device 400 includes a first electrode 420, a hole transport region 430, a light-emitting layer 440, an electron transport layer 480, and a second electrode 290.

The hole transport region 330 of the organic photodetector 300, and the hole transport region 430 of the organic light-emitting device 400 form a common hole transport region 230 shared by the organic photodetector 300 and the organic light-emitting device 400.

The electron transport layer 380 of the organic photodetector 300, and the electron transport layer 480 of the organic light-emitting device 400 form a common electron transport layer 280 shared by the organic photodetector 300 and the organic light-emitting device 400.

The second electrode 290 of the organic photodetector 300 and the second electrode 290 of the organic light-emitting device 400 can form a common second electrode 290 (shown); or, not shown, the organic photodetector 300; and the organic light-emitting device 400 can each have its own second electrode which are separated from each other.

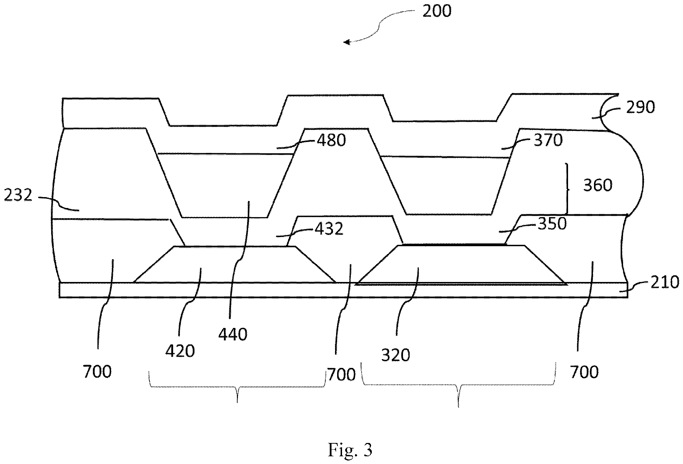

Referring to Fig. 3, the display 200 includes a substrate 210, an organic photodetector 300, and an organic light-emitting device 400, which are separated by a pixel definition layer 700.

The organic photodetector 300 includes a first electrode 320, a first semiconductor layer 350, a intermediate layer structure 360, a second semiconductor layer 370, and a second electrode 290.

The first semiconductor layer 350 comprises the first compound.

The intermediate layer structure 360 comprises one or more layers, the third compound and the fourth compound and a photoconversion unit (not shown), wherein the photoconversion unit can comprise one or more layers.

The photoconversion unit comprises an electron donor compound and an electron acceptor compound.

The electron acceptor compound can be the third compound or the electron acceptor compound cannot be the third compound; and the electron donor compound can be the fourth compound or the electron compound cannot be the fourth compound.

The second semiconductor layer 370 comprises the second compound.

The organic light-emitting device 400 includes a first electrode 420, a hole transport layer 432, a light-emitting layer 440, an electron transport layer 480, and a second electrode 290.

The first semiconductor layer 350 of the organic photodetector 300, and the hole transport layer 432 of the organic light-emitting device 400 form a common hole transport region 230 shared by the organic photodetector 300 and the organic light-emitting device 400.

The second semiconductor layer 370 of the organic photodetector 300, and the electron transport layer 480 of the organic light-emitting device 400 form a common electron transport layer 280 shared by the organic photodetector 300 and the organic light-emitting device 400.

The second electrode 290 of the organic photodetector 300 and the second electrode 290 of the organic light-emitting device 400 can form a common second electrode 290 (shown); or, not shown, the organic photodetector 300; and the organic light-emitting device 400 can each have its own second electrode which are separated from each other.

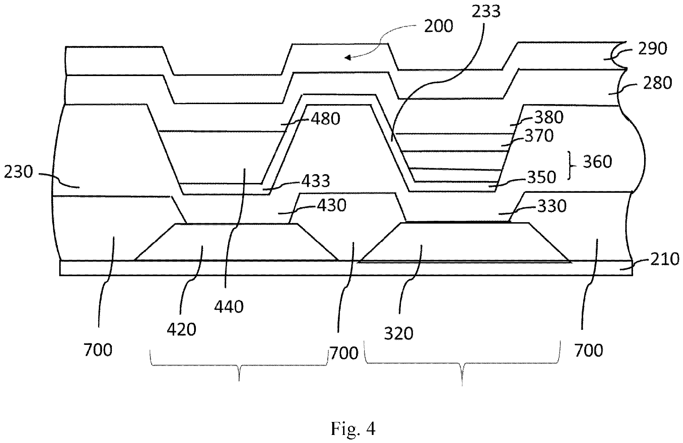

Referring to Fig. 4, the display 200 includes a substrate 210, an organic photodetector 300, and an organic light-emitting device 400, which are separated by a pixel definition layer 700.

The organic photodetector 300 includes a first electrode 320, a hole transport region 330, a first semiconductor layer 350, a intermediate layer structure 360, a second semiconductor layer 370, an electron transport layer 380, and a second electrode 290.

The first semiconductor layer 350 comprises the first compound.

The intermediate layer structure 360 comprises one or more layers, the third compound and the fourth compound and a photoconversion unit (not shown), wherein the photoconversion unit can comprise one or more layers.

The photoconversion unit comprises an electron donor compound and an electron acceptor compound.

The electron acceptor compound can be the third compound or the electron acceptor compound cannot be the third compound; and the electron donor compound can be the fourth compound or the electron compound cannot be the fourth compound.

The second semiconductor layer 370 comprises the second compound.

The organic light-emitting device 400 includes a first electrode 420, a hole transport region 430, a light-emitting layer 440, an electron transport layer 480, and a second electrode 290.

The first semiconductor layer 350 of the organic photodetector and the electron blocking layer 433 of the organic light-emitting device 400 form a common electron blocking layer 233 shared by the organic photodetector 300 and the organic light-emitting device 400.

The hole transport region 330 of the organic photodetector 300, and the hole transport region 430 of the organic light-emitting device 400 form a common hole transport region 230 shared by the organic photodetector 300 and the organic light-emitting device 400.

The electron transport layer 380 of the organic photodetector 300, and the electron transport layer 480 of the organic light-emitting device 400 form a common electron transport layer 280 shared by the organic photodetector 300 and the organic light-emitting device 400.

The second electrode 290 of the organic photodetector 300 and the second electrode 290 of the organic light-emitting device 400 can form a common second electrode 290 (shown); or, not shown, the organic photodetector 300; and the organic light-emitting device 400 can each have its own second electrode which are separated from each other.

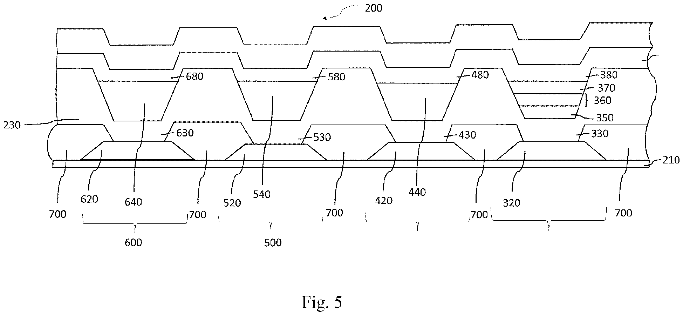

Referring to Fig. 5, the display 200 includes a substrate 210, an organic photodetector 300, an organic light-emitting device 400, and organic light-emitting device 500, and an organic light-emitting device 600, which are separated by a pixel definition layer 700.

The organic photodetector 300 includes a first electrode 320, a hole transport region 330, a first semiconductor layer 350, a intermediate layer structure 360, a second semiconductor layer 370, an electron transport layer 380, and a second electrode 290.

The first semiconductor layer 350 comprises the first compound.

The intermediate layer structure 360 comprises one or more layers, the third compound and the fourth compound and a photoconversion unit (not shown), wherein the photoconversion unit can comprise one or more layers.

The photoconversion unit comprises an electron donor compound and an electron acceptor compound.

The electron acceptor compound can be the third compound or the electron acceptor compound cannot be the third compound; and the electron donor compound can be the fourth compound or the electron compound cannot be the fourth compound.

The second semiconductor layer 370 comprises the second compound.

The organic light-emitting device 400 includes a first electrode 420, a hole transport region 430, a light-emitting layer 440, an electron transport layer 480, and a second electrode 290, wherein the organic light-emitting device 400 emits green light.

The organic light-emitting device 500 includes a first electrode 520, a hole transport region 530, a light-emitting layer 540, an electron transport layer 580, and a second electrode 290, wherein the organic light-emitting device 500 emits blue light.

The organic light-emitting device 600 includes a first electrode 620, a hole transport region 630, a light-emitting layer 640, an electron transport layer 680, and a second electrode 290, wherein the organic light-emitting device 600 emits red light.

The hole transport region 330 of the organic photodetector 300, the hole transport region 430 of the organic light-emitting device 400, the hole transport region 530 of the organic light-emitting device 500, and the hole transport region 630 of the organic light-emitting device 600 form a common hole transport region 230 shared by the organic photodetector 300, the organic light-emitting device 400, the organic light-emitting device 500, and the organic light-emitting device 600.

The electron transport layer 380 of the organic photodetector 300, the electron transport layer 480 of the organic light-emitting device 400, the electron transport layer 580 of the organic light-emitting device 500, and the electron transport layer 680 of the organic light-emitting device 600 form a common electron transport layer 280 shared by the organic photodetector 300, the organic light-emitting device 400, the organic light-emitting device 500, and the organic light-emitting device 600.

The second electrode 290 of the organic photodetector 300, the second electrode 290 of the organic light-emitting device 400, the second electrode 290 of the organic light-emitting device 500, and the second electrode 290 of the organic light-emitting device 600 can form a common second electrode 290 (shown); or, not shown, the organic photodetector 300; the organic light-emitting device 400, the organic light-emitting device 500, and the organic light-emitting device 600 can each have its own second electrode which are separated from each other.

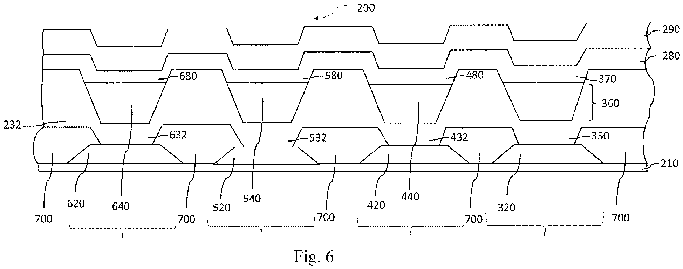

Referring to Fig. 6, the display 200 includes a substrate 210, an organic photodetector 300, and an organic light-emitting device 400, which are separated by a pixel definition layer 700.

The organic photodetector 300 includes a first electrode 320, a first semiconductor layer 350, a intermediate layer structure 360, a second semiconductor layer 370, and a second electrode 290.

The first semiconductor layer 350 comprises the first compound.

The intermediate layer structure 360 comprises one or more layers, the third compound and the fourth compound and a photoconversion unit (not shown), wherein the photoconversion unit can comprise one or more layers.

The photoconversion unit comprises an electron donor compound and an electron acceptor compound.

The electron acceptor compound can be the third compound or the electron acceptor compound cannot be the third compound; and the electron donor compound can be the fourth compound or the electron compound cannot be the fourth compound.

The second semiconductor layer 370 comprises the second compound.

The organic light-emitting device 400 includes a first electrode 420, a hole transport layer 432, a light-emitting layer 440, an electron transport layer 480, and a second electrode 290, wherein the organic light-emitting device 400 emits green light.

The organic light-emitting device 500 includes a first electrode 520, a hole transport layer 532, a light-emitting layer 540, an electron transport layer 580, and a second electrode 290, wherein the organic light-emitting device 500 emits blue light.

The organic light-emitting device 600 includes a first electrode 620, a hole transport layer 632, a light-emitting layer 640, an electron transport layer 680, and a second electrode 290, wherein the organic light-emitting device 600 emits red light.

The first semiconductor layer 350 of the organic photodetector 300, the hole transport layer 432 of the organic light-emitting device 400, the hole transport layer 532 of the organic light-emitting device 500, and the hole transport layer 632 of the organic light-emitting device 600 form a common hole transport region 230 shared by the organic photodetector 300, the organic light-emitting device 400, the organic light-emitting device 500, and the organic light-emitting device 600.

The second semiconductor layer 370 of the organic photodetector 300, the electron transport layer 480 of the organic light-emitting device 400, the electron transport layer 580 of the organic light-emitting device 500, the electron transport layer 680 of the organic light-emitting device 400,
form a common electron transport layer 280 shared by the organic photodetector 300 and the organic light-emitting device 400, the organic light-emitting device 500, and the organic light-emitting device 600.

The second electrode 290 of the organic photodetector 300, the second electrode 290 of the organic light-emitting device 400, the second electrode 290 of the organic light-emitting device 500, and the second electrode 290 of the organic light-emitting device 600 can form a common second electrode 290 (shown); or, not shown, the organic photodetector 300; the organic light-emitting device 400, the organic light-emitting device 500, and the organic light-emitting device 600 can each have its own second electrode which are separated from each other.

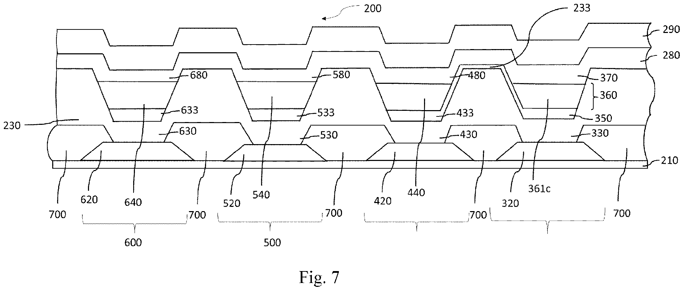

Referring to Fig. 7, the display 200 includes a substrate 210, an organic photodetector 300, an organic light-emitting device 400, and organic light-emitting device 500, and an organic light-emitting device 600, which are separated by a pixel definition layer 700.

The organic photodetector 300 includes a first electrode 320, a hole transport region 330, a first semiconductor layer 350, a intermediate layer structure 360, a second semiconductor layer 370, an electron transport layer 380, and a second electrode 290.

The first semiconductor layer 350 comprises the first compound.

The intermediate layer structure 360 comprises one or more layers, the third compound and the fourth compound and a photoconversion unit (not shown), wherein the photoconversion unit can comprise one or more layers.

The photoconversion unit comprises an electron donor compound and an electron acceptor compound.

The electron acceptor compound can be the third compound or the electron acceptor compound cannot be the third compound; and the electron donor compound can be the fourth compound or the electron compound cannot be the fourth compound.

The second semiconductor layer 370 comprises the second compound.

The organic light-emitting device 400 includes a first electrode 420, a hole transport region 430, an electron blocking layer 433, a light-emitting layer 440, an electron transport layer 480, and a second electrode 290, wherein the organic light-emitting device 400 emits green light.

The organic light-emitting device 500 includes a first electrode 520, a hole transport region 530, an electron blocking layer 533, a light-emitting layer 540, an electron transport layer 580, and a second electrode 290, wherein the organic light-emitting device 500 emits blue light.

The organic light-emitting device 600 includes a first electrode 620, a hole transport region 630, an electron blocking layer 633, a light-emitting layer 640, an electron transport layer 680, and a second electrode 290, wherein the organic light-emitting device 600 emits red light.

The first semiconductor layer 350 of the organic photodetector and the electron blocking layer 433 of the organic light-emitting device 400 form a common electron blocking layer 233 shared by the organic photodetector 300 and the organic light-emitting device 400.

The hole transport region 330 of the organic photodetector 300, the hole transport region 430 of the organic light-emitting device 400, the hole transport region 530 of the organic light-emitting device 500, and the hole transport region 630 of the organic light-emitting device 600 form a common hole transport region 230 shared by the organic photodetector 300, the organic light-emitting device 400, the organic light-emitting device 500, and the organic light-emitting device 600.

The second semiconductor layer 370 of the organic photodetector 300, the electron transport layer 480 of the organic light-emitting device 400, the electron transport layer 580 of the organic light-emitting device 500, and the electron transport layer 680 of the organic light-emitting device 600 form a common electron transport layer 280 shared by the organic photodetector 300, the organic light-emitting device 400, the organic light-emitting device 500, and the organic light-emitting device 600.

The second electrode 290 of the organic photodetector 300, the second electrode 290 of the organic light-emitting device 400, the second electrode 290 of the organic light-emitting device 500, and the second electrode 290 of the organic light-emitting device 600 can form a common second electrode 290 (shown); or, not shown, the organic photodetector 300; the organic light-emitting device 400, the organic light-emitting device 500, and the organic light-emitting device 600 can each have its own second electrode which are separated from each other.

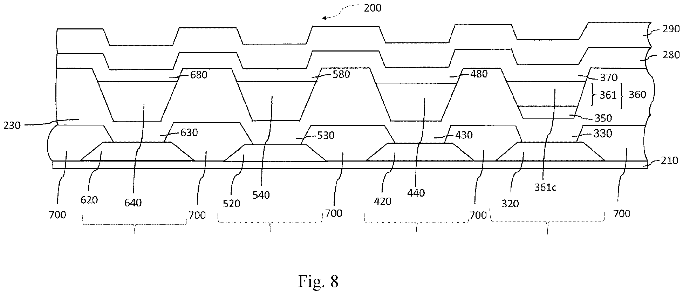

Referring to Fig. 8, the display 200 includes a substrate 210, an organic photodetector 300, an organic light-emitting device 400, and organic light-emitting device 500, and an organic light-emitting device 600, which are separated by a pixel definition layer 700.

The organic photodetector 300 includes a first electrode 320, a hole transport region 330, a first semiconductor layer 350, a intermediate layer structure 360, a second semiconductor layer 370, an electron transport layer 380, and a second electrode 290.

The first semiconductor layer 350 comprises the first compound.

The intermediate layer structure 360 comprises a photoconversion unit 361.

The photoconversion unit comprises a layer 361c.

The photoconversion unit comprises an electron donor compound and an electron acceptor compound.

The electron acceptor compound is the third compound; and the electron donor compound is the fourth compound.

The second semiconductor layer 370 comprises the second compound.

The organic light-emitting device 400 includes a first electrode 420, a hole transport region 430, an electron blocking layer 433, a light-emitting layer 440, an electron transport layer 480, and a second electrode 290, wherein the organic light-emitting device 400 emits green light.

The organic light-emitting device 500 includes a first electrode 520, a hole transport region 530, an electron blocking layer 533, a light-emitting layer 540, an electron transport layer 580, and a second electrode 290, wherein the organic light-emitting device 500 emits blue light.

The organic light-emitting device 600 includes a first electrode 620, a hole transport region 630, an electron blocking layer 633, a light-emitting layer 640, an electron transport layer 680, and a second electrode 290, wherein the organic light-emitting device 600 emits red light.

The hole transport region 330 of the organic photodetector 300, the hole transport region 430 of the organic light-emitting device 400, the hole transport region 530 of the organic light-emitting device 500, and the hole transport region 630 of the organic light-emitting device 600 form a common hole transport region 230 shared by the organic photodetector 300, the organic light-emitting device 400, the organic light-emitting device 500, and the organic light-emitting device 600.

The second semiconductor layer 370 of the organic photodetector 300, the electron transport layer 480 of the organic light-emitting device 400, the electron transport layer 580 of the organic light-emitting device 500, and the electron transport layer 680 of the organic light-emitting device 600 form a common electron transport layer 280 shared by the organic photodetector 300, the organic light-emitting device 400, the organic light-emitting device 500, and the organic light-emitting device 600.

The second electrode 290 of the organic photodetector 300, the second electrode 290 of the organic light-emitting device 400, the second electrode 290 of the organic light-emitting device 500, and the second electrode 290 of the organic light-emitting device 600 can form a common second electrode 290 (shown); or, not shown, the organic photodetector 300; the organic light-emitting device 400, the organic light-emitting device 500, and the organic light-emitting device 600 can each have its own second electrode which are separated from each other.

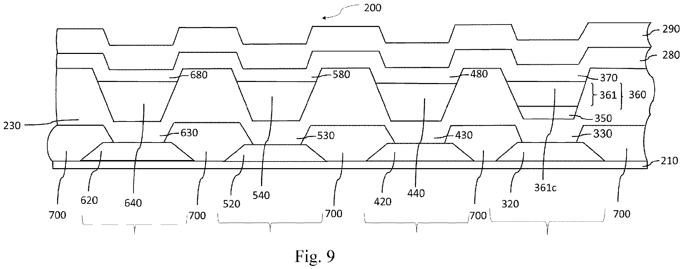

Referring to Fig. 9, the display 200 includes a substrate 210, an organic photodetector 300, an organic light-emitting device 400, and organic light-emitting device 500, and an organic light-emitting device 600, which are separated by a pixel definition layer 700.

The organic photodetector 300 includes a first electrode 320, a hole transport region 330, a first semiconductor layer 350, a intermediate layer structure 360, a second semiconductor layer 370, an electron transport layer 380, and a second electrode 290.

The first semiconductor layer 350 comprises the first compound.

The intermediate layer structure 360 comprises a photoconversion unit 361, and a layer 362, wherein the layer 362 comprises the third compound.

The photoconversion unit comprises a layer 361c.

The photoconversion unit comprises an electron donor compound and an electron acceptor compound.

The electron acceptor compound is not the third compound; and the electron donor compound is the fourth compound.

The second semiconductor layer 370 comprises the second compound.

The organic light-emitting device 400 includes a first electrode 420, a hole transport region 430, an electron blocking layer 433, a light-emitting layer 440, an electron transport layer 480, and a second electrode 290, wherein the organic light-emitting device 400 emits green light.

The organic light-emitting device 500 includes a first electrode 520, a hole transport region 530, an electron blocking layer 533, a light-emitting layer 540, an electron transport layer 580, and a second electrode 290, wherein the organic light-emitting device 500 emits blue light.

The organic light-emitting device 600 includes a first electrode 620, a hole transport region 630, an electron blocking layer 633, a light-emitting layer 640, an electron transport layer 680, and a second electrode 290, wherein the organic light-emitting device 600 emits red light.

The hole transport region 330 of the organic photodetector 300, the hole transport region 430 of the organic light-emitting device 400, the hole transport region 530 of the organic light-emitting device 500, and the hole transport region 630 of the organic light-emitting device 600 form a common hole transport region 230 shared by the organic photodetector 300, the organic light-emitting device 400, the organic light-emitting device 500, and the organic light-emitting device 600.

The second semiconductor layer 370 of the organic photodetector 300, the electron transport layer 480 of the organic light-emitting device 400, the electron transport layer 580 of the organic light-emitting device 500, and the electron transport layer 680 of the organic light-emitting device 600 form a common electron transport layer 280 shared by the organic photodetector 300, the organic light-emitting device 400, the organic light-emitting device 500, and the organic light-emitting device 600.

The second electrode 290 of the organic photodetector 300, the second electrode 290 of the organic light-emitting device 400, the second electrode 290 of the organic light-emitting device 500, and the second electrode 290 of the organic light-emitting device 600 can form a common second electrode 290 (shown); or, not shown, the organic photodetector 300; the organic light-emitting device 400, the organic light-emitting device 500, and the organic light-emitting device 600 can each have its own second electrode which are separated from each other.

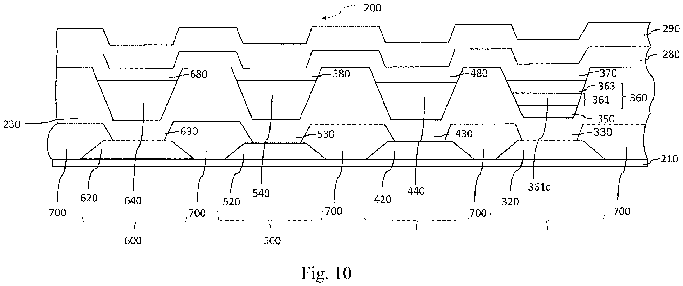

Referring to Fig. 10, the display 200 includes a substrate 210, an organic photodetector 300, an organic light-emitting device 400, and organic light-emitting device 500, and an organic light-emitting device 600, which are separated by a pixel definition layer 700.

The organic photodetector 300 includes a first electrode 320, a hole transport region 330, a first semiconductor layer 350, a intermediate layer structure 360, a second semiconductor layer 370, an electron transport layer 380, and a second electrode 290.

The first semiconductor layer 350 comprises the first compound.

The intermediate layer structure 360 comprises a photoconversion unit 361, and a layer 363, wherein the layer 363 comprises the fourth compound.

The photoconversion unit comprises a layer 361c.

The photoconversion unit comprises an electron donor compound and an electron acceptor compound.

The electron acceptor compound is the third compound; and the electron donor compound is not the fourth compound.

The second semiconductor layer 370 comprises the second compound.

The organic light-emitting device 400 includes a first electrode 420, a hole transport region 430, an electron blocking layer 433, a light-emitting layer 440, an electron transport layer 480, and a second electrode 290, wherein the organic light-emitting device 400 emits green light.

The organic light-emitting device 500 includes a first electrode 520, a hole transport region 530, an electron blocking layer 533, a light-emitting layer 540, an electron transport layer 580, and a second electrode 290, wherein the organic light-emitting device 500 emits blue light.

The organic light-emitting device 600 includes a first electrode 620, a hole transport region 630, an electron blocking layer 633, a light-emitting layer 640, an electron transport layer 680, and a second electrode 290, wherein the organic light-emitting device 600 emits red light.

The hole transport region 330 of the organic photodetector 300, the hole transport region 430 of the organic light-emitting device 400, the hole transport region 530 of the organic light-emitting device 500, and the hole transport region 630 of the organic light-emitting device 600 form a common hole transport region 230 shared by the organic photodetector 300, the organic light-emitting device 400, the organic light-emitting device 500, and the organic light-emitting device 600.

The second semiconductor layer 370 of the organic photodetector 300, the electron transport layer 480 of the organic light-emitting device 400, the electron transport layer 580 of the organic light-emitting device 500, and the electron transport layer 680 of the organic light-emitting device 600 form a common electron transport layer 280 shared by the organic photodetector 300, the organic light-emitting device 400, the organic light-emitting device 500, and the organic light-emitting device 600.

The second electrode 290 of the organic photodetector 300, the second electrode 290 of the organic light-emitting device 400, the second electrode 290 of the organic light-emitting device 500, and the second electrode 290 of the organic light-emitting device 600 can form a common second electrode 290 (shown); or, not shown, the organic photodetector 300; the organic light-emitting device 400, the organic light-emitting device 500, and the organic light-emitting device 600 can each have its own second electrode which are separated from each other.

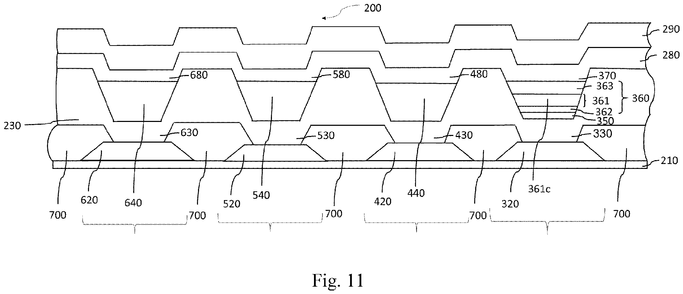

Referring to Fig. 11, the display 200 includes a substrate 210, an organic photodetector 300, an organic light-emitting device 400, and organic light-emitting device 500, and an organic light-emitting device 600, which are separated by a pixel definition layer 700.

The organic photodetector 300 includes a first electrode 320, a hole transport region 330, a first semiconductor layer 350, a intermediate layer structure 360, a second semiconductor layer 370, an electron transport layer 380, and a second electrode 290.

The first semiconductor layer 350 comprises the first compound.

The intermediate layer structure 360 comprises a photoconversion unit 361, a layer 362, and a layer 363; wherein the layer 362 comprises the third compound, and the layer 363 comprises the fourth compound.

The photoconversion unit comprises a layer 361c.

The photoconversion unit comprises an electron donor compound and an electron acceptor compound.

The electron acceptor compound is not the third compound; and the electron donor compound is not the fourth compound.

The second semiconductor layer 370 comprises the second compound.

The organic light-emitting device 400 includes a first electrode 420, a hole transport region 430, an electron blocking layer 433, a light-emitting layer 440, an electron transport layer 480, and a second electrode 290, wherein the organic light-emitting device 400 emits green light.

The organic light-emitting device 500 includes a first electrode 520, a hole transport region 530, an electron blocking layer 533, a light-emitting layer 540, an electron transport layer 580, and a second electrode 290, wherein the organic light-emitting device 500 emits blue light.

The organic light-emitting device 600 includes a first electrode 620, a hole transport region 630, an electron blocking layer 633, a light-emitting layer 640, an electron transport layer 680, and a second electrode 290, wherein the organic light-emitting device 600 emits red light.

The hole transport region 330 of the organic photodetector 300, the hole transport region 430 of the organic light-emitting device 400, the hole transport region 530 of the organic light-emitting device 500, and the hole transport region 630 of the organic light-emitting device 600 form a common hole transport region 230 shared by the organic photodetector 300, the organic light-emitting device 400, the organic light-emitting device 500, and the organic light-emitting device 600.

The second semiconductor layer 370 of the organic photodetector 300, the electron transport layer 480 of the organic light-emitting device 400, the electron transport layer 580 of the organic light-emitting device 500, and the electron transport layer 680 of the organic light-emitting device 600 form a common electron transport layer 280 shared by the organic photodetector 300, the organic light-emitting device 400, the organic light-emitting device 500, and the organic light-emitting device 600.

The second electrode 290 of the organic photodetector 300, the second electrode 290 of the organic light-emitting device 400, the second electrode 290 of the organic light-emitting device 500, and the second electrode 290 of the organic light-emitting device 600 can form a common second electrode 290 (shown); or, not shown, the organic photodetector 300; the organic light-emitting device 400, the organic light-emitting device 500, and the organic light-emitting device 600 can each have its own second electrode which are separated from each other.

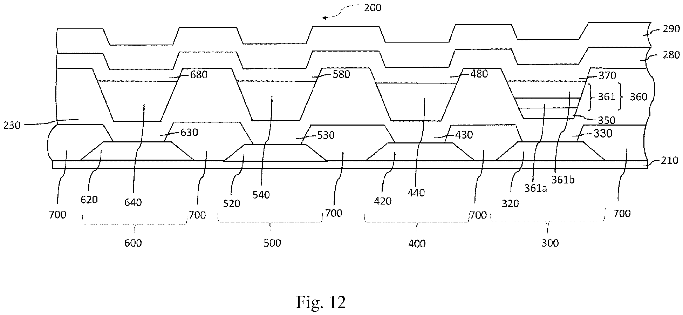

Referring to Fig. 12 the display 200 includes a substrate 210, an organic photodetector 300, an organic light-emitting device 400, and organic light-emitting device 500, and an organic light-emitting device 600, which are separated by a pixel definition layer 700.

The organic photodetector 300 includes a first electrode 320, a hole transport region 330, a first semiconductor layer 350, a intermediate layer structure 360, a second semiconductor layer 370, an electron transport layer 380, and a second electrode 290.

The first semiconductor layer 350 comprises the first compound.

The intermediate layer structure 360 comprises a photoconversion unit 361.

The photoconversion unit comprises an acceptor layer 361a, and a donor layer 361b.

The acceptor layer comprises an electron acceptor compound.

The donor layer comprises an electron donor compound.

The electron acceptor compound is the third compound; and the electron donor compound is the fourth compound.

The second semiconductor layer 370 comprises the second compound.

The organic light-emitting device 400 includes a first electrode 420, a hole transport region 430, an electron blocking layer 433, a light-emitting layer 440, an electron transport layer 480, and a second electrode 290, wherein the organic light-emitting device 400 emits green light.

The organic light-emitting device 500 includes a first electrode 520, a hole transport region 530, an electron blocking layer 533, a light-emitting layer 540, an electron transport layer 580, and a second electrode 290, wherein the organic light-emitting device 500 emits blue light.

The organic light-emitting device 600 includes a first electrode 620, a hole transport region 630, an electron blocking layer 633, a light-emitting layer 640, an electron transport layer 680, and a second electrode 290, wherein the organic light-emitting device 600 emits red light.

The hole transport region 330 of the organic photodetector 300, the hole transport region 430 of the organic light-emitting device 400, the hole transport region 530 of the organic light-emitting device 500, and the hole transport region 630 of the organic light-emitting device 600 form a common hole transport region 230 shared by the organic photodetector 300, the organic light-emitting device 400, the organic light-emitting device 500, and the organic light-emitting device 600.

The second semiconductor layer 370 of the organic photodetector 300, the electron transport layer 480 of the organic light-emitting device 400, the electron transport layer 580 of the organic light-emitting device 500, and the electron transport layer 680 of the organic light-emitting device 600 form a common electron transport layer 280 shared by the organic photodetector 300, the organic light-emitting device 400, the organic light-emitting device 500, and the organic light-emitting device 600.

The second electrode 290 of the organic photodetector 300, the second electrode 290 of the organic light-emitting device 400, the second electrode 290 of the organic light-emitting device 500, and the second electrode 290 of the organic light-emitting device 600 can form a common second electrode 290 (shown); or, not shown, the organic photodetector 300; the organic light-emitting device 400, the organic light-emitting device 500, and the organic light-emitting device 600 can each have its own second electrode which are separated from each other.

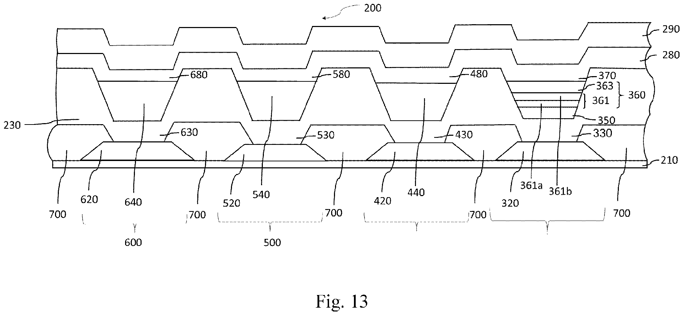

Referring to Fig. 13 the display 200 includes a substrate 210, an organic photodetector 300, an organic light-emitting device 400, and organic light-emitting device 500, and an organic light-emitting device 600, which are separated by a pixel definition layer 700.

The organic photodetector 300 includes a first electrode 320, a hole transport region 330, a first semiconductor layer 350, a intermediate layer structure 360, a second semiconductor layer 370, an electron transport layer 380, and a second electrode 290.

The first semiconductor layer 350 comprises the first compound.

The intermediate layer structure 360 comprises a photoconversion unit 361, and a layer 362, wherein the layer 362 comprises the third compound.

The photoconversion unit comprises an acceptor layer 361a, and donor layer 361b.

The acceptor layer comprises an electron acceptor compound.

The donor layer comprises an electron donor compound.

The electron acceptor compound is not the third compound; and the electron donor compound is the fourth compound.

The second semiconductor layer 370 comprises the second compound.

The organic light-emitting device 400 includes a first electrode 420, a hole transport region 430, an electron blocking layer 433, a light-emitting layer 440, an electron transport layer 480, and a second electrode 290, wherein the organic light-emitting device 400 emits green light.

The organic light-emitting device 500 includes a first electrode 520, a hole transport region 530, an electron blocking layer 533, a light-emitting layer 540, an electron transport layer 580, and a second electrode 290, wherein the organic light-emitting device 500 emits blue light.

The organic light-emitting device 600 includes a first electrode 620, a hole transport region 630, an electron blocking layer 633, a light-emitting layer 640, an electron transport layer 680, and a second electrode 290, wherein the organic light-emitting device 600 emits red light.

The hole transport region 330 of the organic photodetector 300, the hole transport region 430 of the organic light-emitting device 400, the hole transport region 530 of the organic light-emitting device 500, and the hole transport region 630 of the organic light-emitting device 600 form a common hole transport region 230 shared by the organic photodetector 300, the organic light-emitting device 400, the organic light-emitting device 500, and the organic light-emitting device 600.

The second semiconductor layer 370 of the organic photodetector 300, the electron transport layer 480 of the organic light-emitting device 400, the electron transport layer 580 of the organic light-emitting device 500, and the electron transport layer 680 of the organic light-emitting device 600 form a common electron transport layer 280 shared by the organic photodetector 300, the organic light-emitting device 400, the organic light-emitting device 500, and the organic light-emitting device 600.

The second electrode 290 of the organic photodetector 300, the second electrode 290 of the organic light-emitting device 400, the second electrode 290 of the organic light-emitting device 500, and the second electrode 290 of the organic light-emitting device 600 can form a common second electrode 290 (shown); or, not shown, the organic photodetector 300; the organic light-emitting device 400, the organic light-emitting device 500, and the organic light-emitting device 600 can each have its own second electrode which are separated from each other.

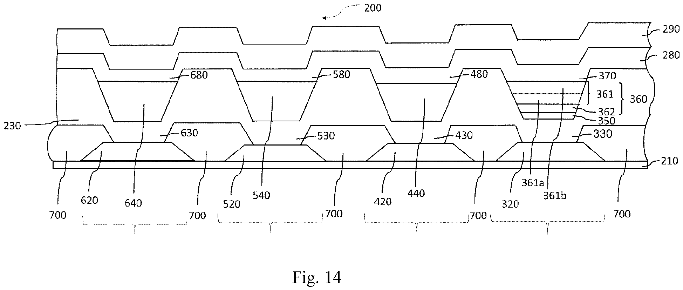

Referring to Fig. 14, the display 200 includes a substrate 210, an organic photodetector 300, an organic light-emitting device 400, and organic light-emitting device 500, and an organic light-emitting device 600, which are separated by a pixel definition layer 700.

The organic photodetector 300 includes a first electrode 320, a hole transport region 330, a first semiconductor layer 350, a intermediate layer structure 360, a second semiconductor layer 370, an electron transport layer 380, and a second electrode 290.

The first semiconductor layer 350 comprises the first compound.

The intermediate layer structure 360 comprises a photoconversion unit 361, and a layer 363, wherein the layer 363 comprises the fourth compound.

The photoconversion unit comprises an acceptor layer 361a, and donor layer 361b.

The acceptor layer comprises an electron acceptor compound.

The donor layer comprises an electron donor compound.

The electron acceptor compound is the third compound; and the electron donor compound is not the fourth compound.

The second semiconductor layer 370 comprises the second compound.

The organic light-emitting device 400 includes a first electrode 420, a hole transport region 430, an electron blocking layer 433, a light-emitting layer 440, an electron transport layer 480, and a second electrode 290, wherein the organic light-emitting device 400 emits green light.

The organic light-emitting device 500 includes a first electrode 520, a hole transport region 530, an electron blocking layer 533, a light-emitting layer 540, an electron transport layer 580, and a second electrode 290, wherein the organic light-emitting device 500 emits blue light.

The organic light-emitting device 600 includes a first electrode 620, a hole transport region 630, an electron blocking layer 633, a light-emitting layer 640, an electron transport layer 680, and a second electrode 290, wherein the organic light-emitting device 600 emits red light.

The hole transport region 330 of the organic photodetector 300, the hole transport region 430 of the organic light-emitting device 400, the hole transport region 530 of the organic light-emitting device 500, and the hole transport region 630 of the organic light-emitting device 600 form a common hole transport region 230 shared by the organic photodetector 300, the organic light-emitting device 400, the organic light-emitting device 500, and the organic light-emitting device 600.

The second semiconductor layer 370 of the organic photodetector 300, the electron transport layer 480 of the organic light-emitting device 400, the electron transport layer 580 of the organic light-emitting device 500, and the electron transport layer 680 of the organic light-emitting device 600 form a common electron transport layer 280 shared by the organic photodetector 300, the organic light-emitting device 400, the organic light-emitting device 500, and the organic light-emitting device 600.

The second electrode 290 of the organic photodetector 300, the second electrode 290 of the organic light-emitting device 400, the second electrode 290 of the organic light-emitting device 500, and the second electrode 290 of the organic light-emitting device 600 can form a common second electrode 290 (shown); or, not shown, the organic photodetector 300; the organic light-emitting device 400, the organic light-emitting device 500, and the organic light-emitting device 600 can each have its own second electrode which are separated from each other.

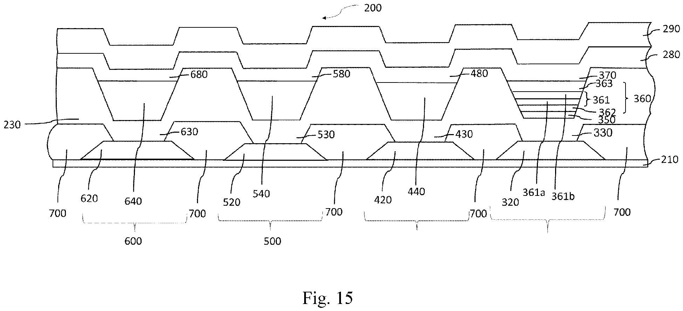

Referring to Fig. 15, the display 200 includes a substrate 210, an organic photodetector 300, an organic light-emitting device 400, and organic light-emitting device 500, and an organic light-emitting device 600, which are separated by a pixel definition layer 700.

The organic photodetector 300 includes a first electrode 320, a hole transport region 330, a first semiconductor layer 350, an intermediate layer structure 360, a second semiconductor layer 370, an electron transport layer 380, and a second electrode 290.

The first semiconductor layer 350 comprises the first compound.

The intermediate layer structure 360 comprises a photoconversion unit 361, a layer 362, and a layer 363; wherein the layer 362 comprises the third compound, and the layer 363 comprises the fourth compound.

The photoconversion unit comprises an acceptor layer 361a, and donor layer 361b.

The acceptor layer comprises an electron acceptor compound.

The donor layer comprises an electron donor compound.

The electron acceptor compound is not the third compound; and the electron donor compound is not the fourth compound.

The second semiconductor layer 370 comprises the second compound.

The organic light-emitting device 400 includes a first electrode 420, a hole transport region 430, an electron blocking layer 433, a light-emitting layer 440, an electron transport layer 480, and a second electrode 290, wherein the organic light-emitting device 400 emits green light.

The organic light-emitting device 500 includes a first electrode 520, a hole transport region 530, an electron blocking layer 533, a light-emitting layer 540, an electron transport layer 580, and a second electrode 290, wherein the organic light-emitting device 500 emits blue light.

The organic light-emitting device 600 includes a first electrode 620, a hole transport region 630, an electron blocking layer 633, a light-emitting layer 640, an electron transport layer 680, and a second electrode 290, wherein the organic light-emitting device 600 emits red light.

The hole transport region 330 of the organic photodetector 300, the hole transport region 430 of the organic light-emitting device 400, the hole transport region 530 of the organic light-emitting device 500, and the hole transport region 630 of the organic light-emitting device 600 form a common hole transport region 230 shared by the organic photodetector 300, the organic light-emitting device 400, the organic light-emitting device 500, and the organic light-emitting device 600.

The second semiconductor layer 370 of the organic photodetector 300, the electron transport layer 480 of the organic light-emitting device 400, the electron transport layer 580 of the organic light-emitting device 500, and the electron transport layer 680 of the organic light-emitting device 600 form a common electron transport layer 280 shared by the organic photodetector 300, the organic light-emitting device 400, the organic light-emitting device 500, and the organic light-emitting device 600.

The second electrode 290 of the organic photodetector 300, the second electrode 290 of the organic light-emitting device 400, the second electrode 290 of the organic light-emitting device 500, and the second electrode 290 of the organic light-emitting device 600 can form a common second electrode 290 (shown); or, not shown, the organic photodetector 300; the organic light-emitting device 400, the organic light-emitting device 500, and the organic light-emitting device 600 can each have its own second electrode which are separated from each other.

### Detailed discussion

The invention is furthermore illustrated by the following examples which are illustrative only and non-binding.

Table 1 (see below) shows references, structures and further data of structures of some of the compounds used in the experimental section

### Experimental data

### Calculated HOMO and LUMP

The energy of the highest occupied molecular orbital (HOMO), lowest unoccupied molecular orbital (LUMO) of compoundsand comparative compounds were calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany). The HOMO and LUMO energy levels of the molecular structures are determined by applying the hybrid functional B3LYP with a Def2-TZVP basis set and the Stuttgart/Dresden (SDD) effective core potential (ECP) for the metals from the optimized geometries obtained by applying the functional BP86 with a Def2-SVP basis set the Stuttgart/Dresden (SDD) effective core potential (ECP) for the metals. All the calculations were performed in the gas phase. If more than one conformation is viable, the conformation with the lowest total energy is selected. Depending on the metal cation different multiplicities may be applied. For the following metal cations the multiplicity is shown in brackets: Li⁺ (singlet), Zn²⁺ (singlet), Cu²⁺ (dublet), Sn²⁺ (singlet), Ir²⁺ (singlet), Al³⁺ (singlet), Si⁴⁺ (singlet). The HOMO, LUMO and Energy Gap (difference of LUMO and HOMO) values in Table 1 were calculated by this method unless noted otherwise.

### Rate onset temperature

The rate onset temperature (T_{RO}) is determined by loading 100 mg compound into a VTE source. As VTE source a point source for organic materials may be used as supplied by Kurt J. Lesker Com-pany (www.lesker.com) or CreaPhys GmbH (http://www.creaphys.com). The VTE source is heated at a constant rate of 15 K/min at a pressure of less than 10⁻⁵ mbar and the temperature inside the source measured with a thermocouple. Evaporation of the compound is detected with a QCM detector which detects deposition of the compound on the quartz crystal of the detector. The deposition rate on the quartz crystal is measured in Ångstrom per second. To determine the rate onset temperature, the deposition rate is plotted against the VTE source temperature. The rate onset is the temperature at which noticeable deposition on the QCM detector occurs. For accurate results, the VTE source is heated and cooled three time and only results from the second and third run are used to determine the rate onset temperature.

To achieve good control over the evaporation rate of a compound, the rate onset temperature may be in the range of 200 to 300 °C. If the rate onset temperature is substantially below 200 °C the evaporation may be too rapid and therefore difficult to control. If the rate onset temperature is above 300 °C the evaporation rate may be too low which may result in low tact time and decomposition of the compound in VTE source may occur due to prolonged exposure to elevated temperatures.

### General procedure for fabrication of OPDs

For inventive examples and comparative examples in Tables 2 to 9, a glass substrate with an anode layer comprising a first anode sub-layer of 8 nm ITO, a second anode sub-layer of 120 nm Ag, and a third anode sub-layer of 7 nm ITO was cut to a size of 25 mm x 25 mm x 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen.

Then the respective further layers are vacuum deposited as shown below.

Ag:Mg (90 vol% Ag) was vacuum deposited at a rate of 0.01 to 1 Å/s at 10⁻⁷ mbar to form a cathode layer having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

Substrate temperature during deposition process is at room temperature. Waiting time in between individual layers is less than 60 minutes. Deposition is done in the dark.

The device stack is protected from ambient conditions by encapsulation of the device with a glass lid. The glass lid provides a cavity, which includes a getter material for further protection.

The structures of some of the compounds used can be seen in Table 1 below.

### Measurement of the photocurrent density by illumination of the organic photodetector

The photocurrent density by illumination of the organic photodetector having an area size of 6.35 mm² is measured in a box under illumination by applying a voltage of +3V±0.05V at 22°C or -3V±0.05V at 22°C.

The voltage is applied by means of Keithley SM2635B and the current density is determined by means of Keithley SM2635B. The high terminal of current-voltage measuring device (source measure unit) Keithley SM2635B is connected to the anode layer of the organic photodetector, and the low terminal of source measure unit Keithley SM2635B is connected to the cathode layer of the organic photodetector. The voltage is applied for a period (duration) of at least one second before the current is measured with a measurement time of 5 NPLC (Number of Power Line-Cycles).

For device illumination, 2 sets of RGB LEDs (Cree CLX6F-FKC-CKNNQDGBB7A363) are used. In total 6 LEDs: 2x red, 2x blue, 2x green, while each is driven with 0.63mA. LEDs are circular arranged and have lateral distance of 7.6mm to each other. Distance each diode to center is 3.8mm, respectively. Vertical distance from center to organic photodetector is 13mm. The area size of the organic photodetector is determined by the area wherein the anode layer, cathode layer, and the layers between the anode layer and the cathode layer overlaps.

In the overlap of the area anode layer, cathode layer, and the layer between the anode layer and cathode layer are stacked on top of each other. The anode layer area may be defined by a pixel definition layer aperture like shown in the figures.

### Measurement of the dark current (current under dark conditions) of the organic photodetector

The dark current of the organic photodetector having an area size of 6.35 mm² is measured in a box in dark conditions by applying a voltage of +3V±0.05V at 22°C or -3V±0.05V at 22°C.. The voltage is applied by means of Keithley SM2635B and the current density is determined by means of Keithley SM2635B. The high terminal of source measure unit Keithley SM2635B is connected to the anode layer of the organic photodetector, and the low terminal of source measure unit Keithley SM2635B is connected to the cathode layer of the organic photodetector. The voltage is applied for a period (duration) of at least one second before the current is measured with a measurement time of 5 NPLC (Number of Power Line-Cycles).

### Setup of the devices as shown in Table 2:

In the following, the preparation of the four comparative and the inventive device as shown in Table 2 is further described in greater detail:
Comparative example I as in Table 2

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 140 nm.

Then N-(9,9-diphenyl-9H-fluoren-2-yl)-N,9-diphenyl-9H-carbazol-2-amine ([1607480-22-7]) was vacuum co-deposited with 0.5 vol% Bis((Z)-2,2,2-trifluoro-1-(3-methyl-5-oxo-1-phenyl-1,5-dihydro-4H-pyrazol-4-ylidene)ethoxy)copper ([81714-07-0]) on the hole transport layer, to form a charge extraction layer having a thickness of 5 nm.

Then ZnPc (Zinc Phthalocyanine; [14320-04-8]) as the first compound was vacuum deposited on the charge extraction layer, to form the first semiconductor layer having a thickness of 10 nm.

Then Fullerene-C60 ([99685-96-8]) as the electron acceptor compound was vacuum deposited on the first semiconductor layer, to form an acceptor layer of the photoconversion unit having a thickness of 20 nm, wherein Fullerene-C60 is third compound and the electron acceptor compound, i.e. here the electron acceptor compound is the third compound.

Then Boron subphthalocyanine chloride (SubPb; [36530-06-0]) as the electron donor compound was vacuum deposited on the acceptor layer, to form a donor layer of the photoconversion unit having a thickness of 20 nm; wherein Boron subphthalocyanine chloride (SubPb; [36530-06-0]) is the electron donor compound and the fourth compound, i.e. here the electron donor compound is the fourth compound.

Then 2,9-dimethyl-4,7-diphenyl-1,10-phenanthroline (BCP; [4733-39-5]) as the second compound was vacuum deposited to form the second semiconductor layer which is a hole blocking layer having a thickness of 30 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Comparative example II as in Table 2

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 140 nm.

Then N-(9,9-diphenyl-9H-fluoren-2-yl)-N,9-diphenyl-9H-carbazol-2-amine ([1607480-22-7]) was vacuum co-deposited with 0.5 vol% Bis((Z)-2,2,2-trifluoro-1-(3-methyl-5-oxo-1-phenyl-1,5-dihydro-4H-pyrazol-4-ylidene)ethoxy)copper ([81714-07-0]) on the hole transport layer, to form a charge extraction layer having a thickness of 5 nm.

Then N-(9,9-diphenyl-9H-fluoren-2-yl)-N,9-diphenyl-9H-carbazol-2-amine ([1607480-22-7]) as the first compound was vacuum deposited on the charge extraction layer, to form the first semiconductor layer having a thickness of 10 nm.

Then Fullerene-C60 ([99685-96-8]) as the electron acceptor compound was vacuum deposited on the first semiconductor layer, to form an acceptor layer of the photoconversion unit having a thickness of 20 nm, wherein Fullerene-C60 is third compound and the electron acceptor compound, i.e. here the electron acceptor compound is the third compound.

Then Boron subphthalocyanine chloride (SubPb; [36530-06-0]) as the electron donor compound was vacuum deposited on the acceptor layer, to form a donor layer of the photoconversion unit having a thickness of 20 nm; wherein Boron subphthalocyanine chloride (SubPb; [36530-06-0]) is the electron donor compound and the fourth compound, i.e. here the electron donor compound is the fourth compound.

Then 2,9-dimethyl-4,7-diphenyl-1,10-phenanthroline (BCP; [4733-39-5]) as the second compound was vacuum deposited to form the second semiconductor layer which is a hole blocking layer having a thickness of 30 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Comparative Example III as in Table 2

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 140 nm.

Then N-(9,9-diphenyl-9H-fluoren-2-yl)-N,9-diphenyl-9H-carbazol-2-amine ([1607480-22-7]) was vacuum co-deposited with 0.5 vol% Bis((Z)-2,2,2-trifluoro-1-(3-methyl-5-oxo-1-phenyl-1,5-dihydro-4H-pyrazol-4-ylidene)ethoxy)copper ([81714-07-0]) on the hole transport layer, to form a charge extraction layer having a thickness of 5 nm.

Then N-(9,9-diphenyl-9H-fluoren-2-yl)-N,9-diphenyl-9H-carbazol-2-amine ([1607480-22-7]) as the first compound was vacuum deposited on the charge extraction layer, to form the first semiconductor layer having a thickness of 10 nm.

Then Fullerene-C60 ([99685-96-8]) as the electron acceptor compound was vacuum deposited on the first semiconductor layer, to form an acceptor layer of the photoconversion unit having a thickness of 20 nm. wherein Fullerene-C60 is third compound and the electron acceptor compound, i.e. here the electron acceptor compound is the third compound.

Then Boron subphthalocyanine chloride (SubPb; [36530-06-0]) as the electron donor compound was vacuum deposited on the acceptor layer, to form a donor layer of the photoconversion unit having a thickness of 20 nm; wherein Boron subphthalocyanine chloride (SubPb; [36530-06-0]) is the electron donor compound and the fourth compound, i.e. here the electron donor compound is the fourth compound.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 30 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Comparative example IV as in Table 2

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 140 nm.

Then N-(9,9-diphenyl-9H-fluoren-2-yl)-N,9-diphenyl-9H-carbazol-2-amine ([1607480-22-7]) was vacuum co-deposited with 0.5 vol% Bis((Z)-2,2,2-trifluoro-1-(3-methyl-5-oxo-1-phenyl-1,5-dihydro-4H-pyrazol-4-ylidene)ethoxy)copper ([81714-07-0]) on the hole transport layer, to form a charge extraction layer having a thickness of 5 nm.

Then N-(9,9-diphenyl-9H-fluoren-2-yl)-N,9-diphenyl-9H-carbazol-2-amine ([1607480-22-7]) as the first compound was vacuum deposited on the charge extraction layer, to form the first semiconductor layer having a thickness of 10 nm.

Then Fullerene-C60 ([99685-96-8]) as the electron acceptor compound was vacuum deposited on the first semiconductor layer, to form an acceptor layer of the photoconversion unit having a thickness of 20 nm, wherein Fullerene-C60 is third compound and the electron acceptor compound, i.e. here the electron acceptor compound is the third compound.

Then N-(9,9-diphenyl-9H-fluoren-2-yl)-N,9-diphenyl-9H-carbazol-2-amine ([1607480-22-7]) as the electron donor compound was vacuum deposited on the acceptor layer, to form a donor layer of the photoconversion unit having a thickness of 20 nm; wherein N-(9,9-diphenyl-9H-fluoren-2-yl)-N,9-diphenyl-9H-carbazol-2-amine ([1607480-22-7]) is the electron donor compound and the fourth compound, i.e. here the electron donor compound is the fourth compound.

Then 2,9-dimethyl-4,7-diphenyl-1,10-phenanthroline (BCP; [4733-39-5]) as the second compound was vacuum deposited to form the second semiconductor layer which is a hole blocking layer having a thickness of 30 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Inventive example I as in Table 2

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 140 nm.

Then N-(9,9-diphenyl-9H-fluoren-2-yl)-N,9-diphenyl-9H-carbazol-2-amine ([1607480-22-7]) was vacuum co-deposited with 0.5 vol% Bis((Z)-2,2,2-trifluoro-1-(3-methyl-5-oxo-1-phenyl-1,5-dihydro-4H-pyrazol-4-ylidene)ethoxy)copper ([81714-07-0]) on the hole transport layer, to form a charge extraction layer having a thickness of 5 nm.

Then N-(9,9-diphenyl-9H-fluoren-2-yl)-N,9-diphenyl-9H-carbazol-2-amine ([1607480-22-7]) as the first compound was vacuum deposited on the charge extraction layer, to form the first semiconductor layer having a thickness of 10 nm.

Then Fullerene-C60 ([99685-96-8]) as the electron acceptor compound was vacuum deposited on the first semiconductor layer, to form an acceptor layer of the photoconversion unit having a thickness of 20 nm, wherein Fullerene-C60 is third compound and the electron acceptor compound, i.e. here the electron acceptor compound is the third compound.

Then N-(9,9-diphenyl-9H-fluoren-2-yl)-N,9-diphenyl-9H-carbazol-2-amine ([1607480-22-7]) as the electron donor compound was vacuum deposited on the acceptor layer, to form a donor layer of the photoconversion unit having a thickness of 20 nm; wherein N-(9,9-diphenyl-9H-fluoren-2-yl)-N,9-diphenyl-9H-carbazol-2-amine ([1607480-22-7]) is the electron donor compound and the fourth compound, i.e. here the electron donor compound is the fourth compound.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 30 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Setup of the devices as shown in Table 3:

In the following, the preparation of the three comparative and the inventive device as shown in Table 3 is further described in greater detail:

### Comparative example V as in Table 3

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 150 nm.

Then N-(9,9-diphenyl-9H-fluoren-2-yl)-N,9-diphenyl-9H-carbazol-2-amine ([1607480-22-7]) as first compound was vacuum co-deposited with 0.5 vol% Bis((Z)-2,2,2-trifluoro-1-(3-methyl-5-oxo-1-phenyl-1,5-dihydro-4H-pyrazol-4-ylidene)ethoxy)copper ([81714-07-0]) on the hole transport layer, to form a first semiconductor layer having a thickness of 5 nm.

Then Fullerene-C60 ([99685-96-8]) as the electron acceptor compound was vacuum deposited on the first semiconductor layer, to form an acceptor layer of the photoconversion unit having a thickness of 20 nm, wherein Fullerene-C60 is third compound and the electron acceptor compound, i.e. here the electron acceptor compound is the third compound.

Then Boron subphthalocyanine chloride (SubPb; [36530-06-0]) as the electron donor compound was vacuum deposited on the acceptor layer, to form a donor layer of the photoconversion unit having a thickness of 20 nm; wherein Boron subphthalocyanine chloride (SubPb; [36530-06-0]) is the electron donor compound and the fourth compound, i.e. here the electron donor compound is the fourth compound.

Then 2,9-dimethyl-4,7-diphenyl-1,10-phenanthroline (BCP; [4733-39-5]) as the second compound was vacuum deposited to form the second semiconductor layer which is a hole blocking layer having a thickness of 30 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Comparative example VI as in Table 3

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 150 nm.

Then N-(9,9-diphenyl-9H-fluoren-2-yl)-N,9-diphenyl-9H-carbazol-2-amine ([1607480-22-7]) as first compound was vacuum co-deposited with 0.5 vol% Bis((Z)-2,2,2-trifluoro-1-(3-methyl-5-oxo-1-phenyl-1,5-dihydro-4H-pyrazol-4-ylidene)ethoxy)copper ([81714-07-0]) on the hole transport layer, to form a first semiconductor layer having a thickness of 5 nm.

Then Fullerene-C60 ([99685-96-8]) as the electron acceptor compound was vacuum deposited on the first semiconductor layer, to form an acceptor layer of the photoconversion unit having a thickness of 20 nm, wherein Fullerene-C60 is third compound and the electron acceptor compound, i.e. here the electron acceptor compound is the third compound.

Then Boron subphthalocyanine chloride (SubPb; [36530-06-0]) as the electron donor compound was vacuum deposited on the acceptor layer, to form a donor layer of the photoconversion unit having a thickness of 20 nm; wherein Boron subphthalocyanine chloride (SubPb; [36530-06-0]) is the electron donor compound and the fourth compound, i.e. here the electron donor compound is the fourth compound.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 30 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Comparative example VII as in Table 3

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 150 nm.

Then N-(9,9-diphenyl-9H-fluoren-2-yl)-N,9-diphenyl-9H-carbazol-2-amine ([1607480-22-7]) as first compound was vacuum co-deposited with 0.5 vol% Bis((Z)-2,2,2-trifluoro-1-(3-methyl-5-oxo-1-phenyl-1,5-dihydro-4H-pyrazol-4-ylidene)ethoxy)copper ([81714-07-0]) on the hole transport layer, to form a first semiconductor layer having a thickness of 5 nm.

Then Fullerene-C60 ([99685-96-8]) as the electron acceptor compound was vacuum deposited on the first semiconductor layer, to form an acceptor layer of the photoconversion unit having a thickness of 20 nm, wherein Fullerene-C60 is third compound and the electron acceptor compound, i.e. here the electron acceptor compound is the third compound.

Then N-(9,9-diphenyl-9H-fluoren-2-yl)-N,9-diphenyl-9H-carbazol-2-amine ([1607480-22-7]) as the electron donor compound was vacuum deposited on the acceptor layer, to form a donor layer of the photoconversion unit having a thickness of 20 nm; wherein N-(9,9-diphenyl-9H-fluoren-2-yl)-N,9-diphenyl-9H-carbazol-2-amine ([1607480-22-7]) is the electron donor compound and the fourth compound, i.e. here the electron donor compound is the fourth compound.

Then 2,9-dimethyl-4,7-diphenyl-1,10-phenanthroline (BCP; [4733-39-5]) as the second compound was vacuum deposited to form the second semiconductor layer which is a hole blocking layer having a thickness of 30 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Inventive example II as in Table 3

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 150 nm.

Then N-(9,9-diphenyl-9H-fluoren-2-yl)-N,9-diphenyl-9H-carbazol-2-amine ([1607480-22-7]) as first compound was vacuum co-deposited with 0.5 vol% Bis((Z)-2,2,2-trifluoro-1-(3-methyl-5-oxo-1-phenyl-1,5-dihydro-4H-pyrazol-4-ylidene)ethoxy)copper ([81714-07-0]) on the hole transport layer, to form a first semiconductor layer having a thickness of 5 nm.

Then Fullerene-C60 ([99685-96-8]) as the electron acceptor compound was vacuum deposited on the first semiconductor layer, to form an acceptor layer of the photoconversion unit having a thickness of 20 nm, wherein Fullerene-C60 is third compound and the electron acceptor compound, i.e. here the electron acceptor compound is the third compound.

Then N-(9,9-diphenyl-9H-fluoren-2-yl)-N,9-diphenyl-9H-carbazol-2-amine ([1607480-22-7]) as the electron donor compound was vacuum deposited on the acceptor layer, to form a donor layer of the photoconversion unit having a thickness of 20 nm; wherein N-(9,9-diphenyl-9H-fluoren-2-yl)-N,9-diphenyl-9H-carbazol-2-amine ([1607480-22-7]) is the electron donor compound and the fourth compound, i.e. here the electron donor compound is the fourth compound.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 30 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Setup of the device as shown in Table 4:

In the following, the preparation of one inventive device as shown in Table 4 is further described in greater detail.

### Inventive example III as in Table 4:

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 126 nm.

Then N-(9,9-diphenyl-9H-fluoren-2-yl)-N,9-diphenyl-9H-carbazol-2-amine ([1607480-22-7]) as first compound was vacuum co-deposited with 1 vol% bis((Z)-2,2,2-trifluoro-1-(3-methyl-5-oxo-1-phenyl-1,5-dihydro-4H-pyrazol-4-ylidene)ethoxy)copper (81714-07-0) on the hole transport layer, to form the first semiconductor layer which is an electron blocking layer/charge extraction layer having a thickness of 15 nm.

Then Fullerene-C60 ([99685-96-8]) was vacuum deposited to form an acceptor layer of the photoconversion unit having a thickness of 30 nm; wherein Fullerene-C60 is the electron acceptor compound and the third compound, i.e. here the electron acceptor compound is the third compound.

Then N-(9,9-diphenyl-9H-fluoren-2-yl)-N,9-diphenyl-9H-carbazol-2-amine ([1607480-22-7]) was vacuum deposited on the acceptor layer of the photoconversion unit, to form a donor layer of the photoconversion unit having a thickness of 25 nm; wherein N-(9,9-diphenyl-9H-fluoren-2-yl)-N,9-diphenyl-9H-carbazol-2-amine is the electron donor compound and the fourth compound, i.e. here the electron donor compound is the fourth compound.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited on the donor layer of the photoconversion unit to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) ([2244287-14-5]) and 50 vol-% LiQ ([850918-68-2]) were vacuum co-deposited on the second semiconductor layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Setup of the device as shown in Table 5:

In the following, the preparation of one inventive device as shown in Table 5 is further described in greater detail.

### Inventive Example IV as in Table 5:

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 108 nm.

Then N-([1,1'-biphenyl]-4-yl)-9,9-dimethyl-N-(3-(9-phenyl-9H-fluoren-9-yl)phenyl)-9H-fluoren-2-amine ([2226747-62-0]] was vacuum deposited on the hole transport layer to form an electron blocking layer having a thickness of 32 nm.

Then N-(9,9-diphenyl-9H-fluoren-2-yl)-N,9-diphenyl-9H-carbazol-2-amine ([1607480-22-7]) as the first compound was vacuum co-deposited with 0.5 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the electron blocking layer, to form the first semiconductor layer which is a charge extraction layer having a thickness of 5 nm.

Then Boron subphthalocyanine chloride ([36530-06-0], SubPc) was vacuum co-deposited with 30 vol% Fullerene-C60 ([99685-96-8]) to form a photoconversion unit consisting of one layer having a thickness of 50 nm; wherein Fullerene-C60 ([99685-96-8]) is the third compound and the electron acceptor compound, i.e. here the third compound is the electron acceptor compound; and wherein Boron subphthalocyanine chloride ([36530-06-0], SubPc) is the electron donor compound.

Then N-([1,1'-biphenyl]-4-yl)-9,9-dimethyl-N-(4-(9-phenyl-9H-carbazol-3-yl)phenyl)-9H-fluoren-2-amine [1242056-42-3]) as the fourth compound was vacuum deposited on the photoconversion unit, to form a layer having a thickness of 10 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Setup of the devices as shown in Table 6:

In the following, the preparation of five inventive device as shown in Table 6 is further described in greater detail.

### Inventive Example V as in Table 6:

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 108 nm.

Then N-([1,1'-biphenyl]-4-yl)-9,9-dimethyl-N-(3-(9-phenyl-9H-fluoren-9-yl)phenyl)-9H-fluoren-2-amine ([2226747-62-0]) as the first compound was vacuum deposited on the hole transport layer to form the first semiconductor layer which is an electron blocking layer having a thickness of 32 nm.

Then 2,2'-(anthracene-9,10-diylidene)dimalononitrile ([70359-39-6], TCNAQ) was vacuum deposited on the first semiconductor layer to form an acceptor layer of the photoconversion unit having a thickness of 10 nm, wherein 2,2'-(anthracene-9,10-diylidene)dimalononitrile ([70359-39-6], TCNAQ) is the third compound and the electron acceptor compound, i.e. here the third compound is the electron acceptor compound.

Then Boron subphthalocyanine chloride ([36530-06-0], SubPc) as electron donor compound was vacuum co-deposited with 30 vol% of 2,2'-(anthracene-9,10-diylidene)dimalononitrile ([70359-39-6], TCNAQ) on the acceptor layer of the photoconversion unit to form a donor layer of the photoconversion unit having a thickness of 50 nm.

Then N-([1,1'-biphenyl]-4-yl)-9,9-dimethyl-N-(4-(9-phenyl-9H-carbazol-3-yl)phenyl)-9H-fluoren-2-amine ([1242056-42-3]) as the fourth compound was vacuum deposited on the donor layer of the photoconversion unit to form a layer having a thickness of 10 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the second semiconductor layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Inventive Example VI as in Table 6:

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 108 nm.

Then N-([1,1'-biphenyl]-4-yl)-9,9-dimethyl-N-(3-(9-phenyl-9H-fluoren-9-yl)phenyl)-9H-fluoren-2-amine ([2226747-62-0]] was vacuum deposited on the hole transport layer to form an electron blocking layer having a thickness of 32 nm.

Then N-(9,9-diphenyl-9H-fluoren-2-yl)-N,9-diphenyl-9H-carbazol-2-amine ([1607480-22-7]) as first compound was vacuum co-deposited with 0.5 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the electron blocking layer, to form the first semiconductor layer which is a charge extraction layer having a thickness of 5 nm.

Then Fullerene-C60 ([99685-96-8]) was vacuum deposited on the first semiconductor layer, to form an acceptor layer having a thickness of 10 nm, wherein Fullerene-C60 is the third compound and the electron acceptor compound, i.e. here the third compound is the electron acceptor compound;

Then Boron subphthalocyanine chloride ([36530-06-0], SubPc) as electron donor compound was vacuum co-deposited with 30 vol% Fullerene-C60 ([99685-96-8]) as electron acceptor compound to form a donor layer of a photoconversion unit having a thickness of 50 nm.

Then N-([1,1'-biphenyl]-4-yl)-9,9-dimethyl-N-(4-(9-phenyl-9H-carbazol-3-yl)phenyl)-9H-fluoren-2-amine [1242056-42-3]) as fourth compound was vacuum deposited on the donor layer of the photoconversion unit, to form a layer having a thickness of 10 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Inventive Example VII as in Table 6:

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 108 nm.

Then N-([1,1'-biphenyl]-4-yl)-9,9-dimethyl-N-(3-(9-phenyl-9H-fluoren-9-yl)phenyl)-9H-fluoren-2-amine ([2226747-62-0]) as the first compound was vacuum deposited on the hole transport layer to form the first semiconductor layer which is an electron blocking layer having a thickness of 32 nm.

Then 2,2'-(anthracene-9,10-diylidene)dimalononitrile ([70359-39-6], TCNAQ) was vacuum deposited on the first semiconductor layer to form an acceptor layer of the photoconversion unit having a thickness of 10 nm, wherein 2,2'-(anthracene-9,10-diylidene)dimalononitrile ([70359-39-6], TCNAQ) is the third compound and the electron acceptor compound, i.e. here the third compound is the electron acceptor compound.

Then Boron subphthalocyanine chloride ([36530-06-0], SubPc) as electron donor compound was vacuum co-deposited with 30 vol% Fullerene-C60 ([99685-96-8]) as electron acceptor compound on the acceptor layer of the photoconversion unit to form a donor layer of the photoconversion unit having a thickness of 50 nm.

Then N-([1,1'-biphenyl]-4-yl)-9,9-dimethyl-N-(4-(9-phenyl-9H-carbazol-3-yl)phenyl)-9H-fluoren-2-amine ([1242056-42-3]) as the fourth compound was vacuum deposited on the donor layer of the photoconversion unit to form a layer having a thickness of 10 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the second semiconductor layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Inventive Example VIII as in Table 6

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 126 nm.

Then N-(9,9-diphenyl-9H-fluoren-2-yl)-N,9-diphenyl-9H-carbazol-2-amine ([1607480-22-7]) was vacuum co-deposited with 1 vol% Bis((Z)-2,2,2-trifluoro-1-(3-methyl-5-oxo-1-phenyl-1,5-dihydro-4H-pyrazol-4-ylidene)ethoxy)copper ([81714-07-0]) on the hole transport layer, to form a charge extraction layer having a thickness of 7 nm.

Then N-(9,9-diphenyl-9H-fluoren-2-yl)-N,9-diphenyl-9H-carbazol-2-amine ([1607480-22-7]) as the first compound was vacuum co-deposited with 50 vol% of Fullerene-C60 ([99685-96-8]) on the charge extraction layer, to form the first semiconductor layer having a thickness of 5 nm.

Then Fullerene-C60 ([99685-96-8]) was vacuum deposited on the first semiconductor layer, to form an acceptor layer of the photoconversion unit having a thickness of 30 nm, wherein Fullerene-C60 is third compound and the electron acceptor compound.

Then N-(9,9-diphenyl-9H-fluoren-2-yl)-N,9-diphenyl-9H-carbazol-2-amine ([1607480-22-7]) as the electron donor compound was vacuum co-deposited with 50vol% of Fullerene-C60 ([99685-96-8]) on the acceptor layer, to form a donor layer of the photoconversion unit having a thickness of 5 nm.

Then N-(9,9-diphenyl-9H-fluoren-2-yl)-N,9-diphenyl-9H-carbazol-2-amine ([1607480-22-7]) as the fourth compound was vacuum deposited on the donor layer, to form a layer having a thickness of 25 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Inventive Example IX as in Table 6:

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 140 nm.

Then N-(9,9-diphenyl-9H-fluoren-2-yl)-N,9-diphenyl-9H-carbazol-2-amine ([1607480-22-7]) as first compound was vacuum co-deposited with 1 vol% bis((Z)-2,2,2-trifluoro-1-(3-methyl-5-oxo-1-phenyl-1,5-dihydro-4H-pyrazol-4-ylidene)ethoxy)copper (81714-07-0) on the hole transport layer, to form the first semiconductor layer which is an electron blocking layer/charge extraction layer having a thickness of 5 nm.

Then Fullerene-C60 ([99685-96-8]) was vacuum deposited to form an acceptor layer of the photoconversion unit having a thickness of 30 nm; wherein Fullerene-C60 is the electron acceptor compound and the third compound, i.e. here the electron acceptor compound is the third compound.

Then Boron subphthalocyanine chloride ([36530-06-0], SubPc) as electron donor compound was vacuum deposited on the acceptor layer, to form an donor layer of the photoconversion unit having a thickness of 10 nm.

Then N-(9,9-diphenyl-9H-fluoren-2-yl)-N,9-diphenyl-9H-carbazol-2-amine ([1607480-22-7]) as the fourth compound was vacuum deposited on the donor layer of the photoconversion unit, to form a layer having a thickness of 25 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the second semiconductor layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Setup of the device as shown in Table 7:

In the following, the preparation of one inventive device as shown in Table 7 is further described in greater detail.

### Inventive Example X as in Table 7:

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 108 nm.

Then N-([1,1'-biphenyl]-4-yl)-9,9-dimethyl-N-(3-(9-phenyl-9H-fluoren-9-yl)phenyl)-9H-fluoren-2-amine ([2226747-62-0]] as the first compound was vacuum deposited on the hole transport layer to form the first semiconductor layer which is an electron blocking layer having a thickness of 32 nm.

Then Fullerene-C60 ([99685-96-8]) ([1607480-22-7]) as third compound was vacuum co-deposited with 4 vol% bis((Z)-2,2,2-trifluoro-1-(3-methyl-5-oxo-1-phenyl-1,5-dihydro-4H-pyrazol-4-ylidene)ethoxy)copper (81714-07-0) on the electron blocking layer, to form a charge extraction layer having a thickness of 5 nm.

Then Fullerene-C60 ([99685-96-8]) as the electron acceptor compound was vacuum deposited to form an acceptor layer of the photoconversion unit having a thickness of 30 nm.

Then N-(9,9-diphenyl-9H-fluoren-2-yl)-N,9-diphenyl-9H-carbazol-2-amine ([1607480-22-7]) was vacuum deposited on the acceptor layer of the photoconversion unit, to form a donor layer of the photoconversion unit having a thickness of 10 nm; wherein N-(9,9-diphenyl-9H-fluoren-2-yl)-N,9-diphenyl-9H-carbazol-2-amine is the electron donor compound and the fourth compound, i.e. here the electron donor compound is the fourth compound.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited on the donor layer of the photoconversion unit to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the second semiconductor layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Setup of the devices as shown in Table 8:

In the following, the preparation of four inventive devices as shown in Table 8 is further described in greater detail.

### Inventive Example XI as in Table 8

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 126 nm.

Then N-(9,9-diphenyl-9H-fluoren-2-yl)-N,9-diphenyl-9H-carbazol-2-amine ([1607480-22-7]) was vacuum co-deposited with 1 vol% Bis((Z)-2,2,2-trifluoro-1-(3-methyl-5-oxo-1-phenyl-1,5-dihydro-4H-pyrazol-4-ylidene)ethoxy)copper ([81714-07-0]) on the hole transport layer, to form a charge extraction layer having a thickness of 5 nm.

Then N-(9,9-diphenyl-9H-fluoren-2-yl)-N,9-diphenyl-9H-carbazol-2-amine ([1607480-22-7]) as the first compound was vacuum deposited on the charge extraction layer, to form the first semiconductor layer having a thickness of 5 nm.

Then Fullerene-C60 ([99685-96-8]) as the third compound was vacuum deposited on the first semiconductor layer, to form layer having a thickness of 20 nm.

Then N-(9,9-diphenyl-9H-fluoren-2-yl)-N,9-diphenyl-9H-carbazol-2-amine ([1607480-22-7]) as the electron donor compound was vacuum co-deposited with 50vol% of Fullerene-C60 ([99685-96-8]) as electron acceptor compound, to form a photoconversion unit consisting of one layer having a thickness of 5 nm.

Then N-(9,9-diphenyl-9H-fluoren-2-yl)-N,9-diphenyl-9H-carbazol-2-amine ([1607480-22-7]) as the fourth compound was vacuum deposited on the donor layer, to form a layer having a thickness of 25 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Inventive Example XII as in Table 8

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 108 nm.

Then N-([1,1'-biphenyl]-4-yl)-9,9-dimethyl-N-(3-(9-phenyl-9H-fluoren-9-yl)phenyl)-9H-fluoren-2-amine ([2226747-62-0]] was vacuum deposited on the hole transport layer to form an electron blocking layer having a thickness of 32 nm.

Then N-(9,9-diphenyl-9H-fluoren-2-yl)-N,9-diphenyl-9H-carbazol-2-amine ([1607480-22-7]) as first compound was vacuum co-deposited with 0.5 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the hole transport layer, to form the first semiconductor layer which is a charge extraction layer having a thickness of 5 nm.

Then Fullerene-C60 ([99685-96-8]) as the third compound was vacuum deposited on the first semiconductor layer, to form a layer having a thickness of 10 nm.

Then Boron subphthalocyanine chloride ([36530-06-0], SubPc) as electron donor compound was vacuum co-deposited with 30 vol% Fullerene-C60 ([99685-96-8]) as electron acceptor compound to form a photoconversion unit consisting of one layer having a thickness of 50 nm.

Then N-([1,1'-biphenyl]-4-yl)-9,9-dimethyl-N-(4-(9-phenyl-9H-carbazol-3-yl)phenyl)-9H-fluoren-2-amine [1242056-42-3]) as fourth compound was vacuum deposited on the photoconversion unit, to form a layer having a thickness of 10 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited on the photoconversion unit to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Inventive Example XIII as in Table 8

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 108 nm.

Then N-([1,1'-biphenyl]-4-yl)-9,9-dimethyl-N-(3-(9-phenyl-9H-fluoren-9-yl)phenyl)-9H-fluoren-2-amine ([2226747-62-0]) as the first compound was vacuum deposited on the hole transport layer to form the first semiconductor layer which is an electron blocking layer having a thickness of 32 nm.

Then 2,2'-(anthracene-9,10-diylidene)dimalononitrile ([70359-39-6], TCNAQ) as third compound was vacuum deposited on the first semiconductor layer to form a layer having a thickness of 10 nm.

Then Boron subphthalocyanine chloride ([36530-06-0], SubPc) as electron donor compound was vacuum co-deposited with 30 vol% Fullerene-C60 ([99685-96-8]) as electron acceptor compound to form a photoconversion unit consisting of one layer having a thickness of 50 nm.

Then N-([1,1'-biphenyl]-4-yl)-9,9-dimethyl-N-(4-(9-phenyl-9H-carbazol-3-yl)phenyl)-9H-fluoren-2-amine ([1242056-42-3]) as the fourth compound was vacuum deposited on the photoconversion unit to form a layer having a thickness of 10 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the second semiconductor layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Inventive Example XIV as in Table 8

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 126 nm.

Then N-(9,9-diphenyl-9H-fluoren-2-yl)-N,9-diphenyl-9H-carbazol-2-amine ([1607480-22-7]) was vacuum co-deposited with 1 vol% Bis((Z)-2,2,2-trifluoro-1-(3-methyl-5-oxo-1-phenyl-1,5-dihydro-4H-pyrazol-4-ylidene)ethoxy)copper ([81714-07-0]) on the hole transport layer, to form a charge extraction layer having a thickness of 7 nm.

Then N-(9,9-diphenyl-9H-fluoren-2-yl)-N,9-diphenyl-9H-carbazol-2-amine ([1607480-22-7]) as the first compound was vacuum co-deposited with 50 vol% of Fullerene-C60 ([99685-96-8]) on the charge extraction layer, to form the first semiconductor layer having a thickness of 5 nm.

Then Fullerene-C60 ([99685-96-8]) as third compound was vacuum deposited on the first semiconductor layer, to form a layer having a thickness of 30 nm.

Then N-(9,9-diphenyl-9H-fluoren-2-yl)-N,9-diphenyl-9H-carbazol-2-amine ([1607480-22-7]) as the electron donor compound was vacuum co-deposited with 50vol% of Fullerene-C60 ([99685-96-8]) on the photoconversion unit, to form a photoconversion unit consisting of one layer having a thickness of 5 nm.

Then N-(9,9-diphenyl-9H-fluoren-2-yl)-N,9-diphenyl-9H-carbazol-2-amine ([1607480-22-7]) as the fourth compound was vacuum deposited on the photoconversion unit, to form a layer having a thickness of 25 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the hole blocking layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Setup of the devices as shown in Table 9:

In the following, the preparation of three inventive devices as shown in Table 9 is further described in greater detail.

### Inventive Example XV as in Table 9:

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 108 nm.

Then N-([1,1'-biphenyl]-4-yl)-9,9-dimethyl-N-(3-(9-phenyl-9H-fluoren-9-yl)phenyl)-9H-fluoren-2-amine ([2226747-62-0]] as the first compound was vacuum deposited on the hole transport layer to form the first semiconductor layer which is an electron blocking layer having a thickness of 32 nm.

Then Fullerene-C60 ([99685-96-8]) ([1607480-22-7]) as third compound was vacuum co-deposited with 1 vol% 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the electron blocking layer, to form a charge extraction layer having a thickness of 5 nm.

Then Fullerene-C60 ([99685-96-8]) as the electron acceptor compound was vacuum deposited to form an acceptor layer of the photoconversion unit having a thickness of 10 nm.

Then Fullerene-C60 ([99685-96-8]) as the electron acceptor compound was vacuum co-deposited with 30 vol% N-(9,9-diphenyl-9H-fluoren-2-yl)-N,9-diphenyl-9H-carbazol-2-amine ([1607480-22-7]) as electron donor compound on the acceptor layer of the photoconversion unit, to form a donor layer of the photoconversion unit having a thickness of 50 nm.

Then N-(9,9-diphenyl-9H-fluoren-2-yl)-N,9-diphenyl-9H-carbazol-2-amine ([1607480-22-7]) as a fourth compound was vacuum deposited on the donor layer, to form a layer having a thickness of 10 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as second compound was vacuum deposited to form a second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the second semiconductor layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Inventive Example XVI as in Table 9

A substrate and anode layer treated according to "General procedure for fabrication of OPDs" was provided.Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 108 nm.

Then N-([1,1'-biphenyl]-4-yl)-9,9-dimethyl-N-(3-(9-phenyl-9H-fluoren-9-yl)phenyl)-9H-fluoren-2-amine ([2226747-62-0]] as the first compound was vacuum deposited on the hole transport layer to form the first semiconductor layer which is an electron blocking layer having a thickness of 32 nm.

Then Fullerene-C60 ([99685-96-8]) ([1607480-22-7]) as third compound was vacuum co-deposited with 1 vol% 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the electron blocking layer, to form a charge extraction layer having a thickness of 5 nm.

Then Fullerene-C60 ([99685-96-8]) as the electron acceptor compound was vacuum deposited to form an acceptor layer of the photoconversion unit having a thickness of 10 nm.

Then Fullerene-C60 ([99685-96-8]) as the electron acceptor compound was vacuum co-deposited with 30 vol% Boron subphthalocyanine chloride ([36530-06-0], SubPc) as electron donor compound on the acceptor layer of the photoconversion unit, to form a donor layer of the photoconversion unit having a thickness of 50 nm.

Then N-([1,1'-biphenyl]-4-yl)-9,9-dimethyl-N-(4-(9-phenyl-9H-carbazol-3-yl)phenyl)-9H-fluoren-2-amine [1242056-42-3]) as a fourth compound was vacuum deposited on the donor layer, to form a layer having a thickness of 10 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as second compound was vacuum deposited to form a second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the second semiconductor layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Inventive Example XVII as in Table 9

A substrate and anode layer treated according to "General procedure for fabrication of OPDs" was provided.

Then N-(9,9-diphenyl-9H-fluoren-2-yl)-N,9-diphenyl-9H-carbazol-2-amine ([1607480-22-7]) was vacuum co-deposited with 3 vol% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the anode layer to form a hole injection layer having a thickness of 10 nm.

Then N-(9,9-diphenyl-9H-fluoren-2-yl)-N,9-diphenyl-9H-carbazol-2-amine ([1607480-22-7]) as first was vacuum deposited on the hole injection layer, to form the first semiconductor layer which is a hole transport layer having a thickness of 158 nm.

Then Boron subphthalocyanine chloride ([36530-06-0], SubPc) as the third compound was vacuum deposited on the electron blocking layer, to form a layer having a thickness 10 nm.

Then 2,2'-(anthracene-9,10-diylidene)dimalononitrile ([70359-39-6], TCNAQ) as electron acceptor compound was vacuum deposited on the first semiconductor layer to form an acceptor layer of the photoconversion unit having a thickness of 30 nm.

Then Boron subphthalocyanine chloride ([36530-06-0], SubPc) as electron donor compound was vacuum deposited on the acceptor layer of the photoconversion unit to form a donor layer of the photoconversion unit having a thickness of 10 nm.

Then N-(9,9-diphenyl-9H-fluoren-2-yl)-N,9-diphenyl-9H-carbazol-2-amine ([1607480-22-7]) as the fourth compound was vacuum deposited on the donor layer of the photoconversion unit to form a layer having a thickness of 20 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) as the second compound was vacuum deposited to form the second semiconductor layer which is a hole blocking layer having a thickness of 5 nm.

Then, 50 vol% 6,6'-(naphthalene-1,2-diylbis(4,1-phenylene))bis(2,4-diphenyl-1,3,5-triazine) and 50 vol-% LiQ ([850918-68-2]) were vacuum co-deposited on the second semiconductor layer to form an electron transport layer having a thickness of 31 nm.

Then Yb was vacuum deposited at a rate of 0.01 to 1 Å/s at 10⁻⁷ mbar on the electron transport layer to form an electron injection layer having a thickness of 1.3 nm.

Ag/Mg (90 vol% Ag) was vacuum deposited at a rate of 0.01 to 1 Å/s at 10⁻⁷ mbar to form a cathode having a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

### Technical effect

In Table 2, the dark current density, photocurrent density by illumination (under exposure of light or irradtion or when exposed to light or irradiation) and signal to noise ratio (SNR) of inventive and comparative devices are shown.

The OPD of comparative example I comprising ZnPc as first compound in the first semiconductor layer instead of a compound comprising an arylamine moiety, C60 as the third compound and as electron acceptor compound, SubPc as the fourth compound and as electron donor compound instead of compound comprising an arylamine moiety, and BCP instead of a mono-6-membered heteroaryl comprising one, two, three or more nitrogen atoms as second compound in the second semiconductor layer exhibits at an applied voltage of +3 V a dark current density of 3.9E-04 mA/cm², and a photocurrent density by illumination of 2.1E-03 mA/cm², and a SNR of 6.

The OPD of comparative example II comprising N-4 (a compound comprising an arylamine moiety) as first compound in the first semiconductor layer, C60 as the third compound and as electron acceptor compound, SubPc as the fourth compound and as electron donor compound instead of compound comprising an arylamine moiety, and BCP instead of a mono-6-membered heteroaryl comprising one, two, three or more nitrogen atoms as second compound in the second semiconductor layer exhibits at an applied voltage of +3 V a dark current density of 2.9E-03 mA/cm², and a photocurrent density by illumination of 4.5E-03 mA/cm², and a SNR of 2.

The OPD of comparative example III comprising N-4 (a compound comprising an arylamine moiety) as first compound in the first semiconductor layer, C60 as the third compound and as electron acceptor compound, SubPc instead of compound comprising an arylamine moiety as the fourth compound and as electron donor compound, and N-11 (a mono-6-membered heteroaryl comprising one, two, three or more nitrogen atoms) as second compound in the second semiconductor layer exhibits at an applied voltage of +3 V a dark current density of 2.6E-02 mA/cm², and a photocurrent density by illumination of 1.7E-01 mA/cm², and a signal to noise ratio of 7.

The OPD of comparative example IV comprising N-4 (a compound comprising an arylamine moiety) as first compound in the first semiconductor layer, C60 as the third compound and as electron acceptor compound, N-4 (a compound comprising an arylamine moiety) as the fourth compound and as electron donor compound, and BCP instead of a mono-6-membered heteroaryl comprising one, two, three or more nitrogen atoms as second compound in the second semiconductor layer exhibits at an applied voltage of +3 V a dark current density of 2.9E-03 mA/cm², and a photocurrent density by illumination of 6.5E-03 mA/cm², and a SNR of 2.

The OPD of inventive example I comprising N-4 (a compound comprising an arylamine moiety) as first compound in the first semiconductor layer, C60 as the third compound and as electron acceptor compound, N-4 (a compound comprising an arylamine moiety) as as the fourth compound and as electron donor compound, and N-11 (a mono-6-membered heteroaryl comprising one, two, three or more nitrogen atoms) as second compound in the second semiconductor layer exhibits at an applied voltage of +3 V a dark current density of 1.0E-05 mA/cm², and a photocurrent density by illumination of 2.4E-02 mA/cm², and a SNR of 2380.

The OPD of inventive example I exhibits a remarkably lower dark current density, a remarkably higher photocurrent density under illumination, and a remarkably higher signal to noise ratio compared to any of the OPDs of comparative example I to IV.

It can be shown that an OPD (comparative example I) comprising ZnPc as the first compound was used instead of a compound comprising an arylamine moiety, SubPc as the fourth compound instead of a compound comprising an arylamine moiety, BCP instead of a mono-6-membered heteroaryl comprising one, two, three or more nitrogen atoms as second compound in the second semiconductor layer exhibits a high dark current density, a low photocurrent density by illumination, and low signal to noise ratio.

When using N-4 which is a compound comprising an arylamine moiety as the first compound in the first semiconductor layer (comparative example II) compared to comparative example I results in an OPD exhibiting also a high dark current density, a low photocurrent density by illumination, and low signal to noise ratio.

When using using N-4 which is a compound comprising an arylamine moiety as the first compound in the first semiconductor layer, and N-11 which is a mono-6-membered heteroaryl comprising one, two, three or more nitrogen atoms as the second compound in the second semiconductor layer (comparative example III) compared to comparative example I results in an OPD exhibiting also a high dark current density, a low photocurrent density by illumination, and low signal to noise ratio.

When using using N-4 which is a compound comprising an arylamine moiety as the first compound in the first semiconductor layer, and N-4 which is a compound comprising an arylamine moiety as the fourth compound (comparative example IV) compared to comparative example I results in an OPD exhibiting also a high dark current density, a low photocurrent density by illumination, and low signal to noise ratio.

However, when using N-4 which is a compound comprising an arylamine moiety as the first compound in the first semiconductor layer, N-4 which is a compound comprising an arylamine moiety as the fourth compound, and N-11 which is a mono-6-membered heteroaryl comprising one, two, three or more nitrogen atoms as the second compound in the second semiconductor layer (inventive example I) compared to comparative example I results in an OPD exhibiting a lower dark current density, a higher photocurrent density by illumination, and higher signal to noise ratio.

In Table 3, the dark current density, photocurrent density by illumination and signal to noise ratio of inventive and comparative devices are shown.

The difference between the device shown in Table 2 and Table 3 is that in Table 3 the first layer further comprises a metal complex N-2.

The OPD of comparative example V comprising N-4 (a compound comprising an arylamine moiety) as first compound in the first semiconductor layer, C60 as the third compound and as electron acceptor compound, SubPc as the fourth compound and as electron donor compound instead of compound comprising an arylamine moiety, and BCP instead of a mono-6-membered heteroaryl comprising one, two, three or more nitrogen atoms as second compound in the second semiconductor layer exhibits at an applied voltage of +3 V a dark current density of 1.2E-04
mA/cm2, and a photocurrent density by illumination (under exposure of light or irradtion or when exposed to light or irradiation) of 4.6E-03 mA/cm2, and a SNR of 39.

The OPD of comparative example VI comprising N-4 (a compound comprising an arylamine moiety) as first compound in the first semiconductor layer, C60 as the third compound and as electron acceptor compound, SubPc instead of compound comprising an arylamine moiety as the fourth compound and as electron donor compound, and N-11 (a mono-6-membered heteroaryl comprising one, two, three or more nitrogen atoms) as second compound in the second semiconductor layer exhibits at an applied voltage of +3 V a dark current density of 9.5E-03 mA/cm2, and a photocurrent density by illumination of 2.5E-01 mA/cm2, and a SNR of 27.

The OPD of comparative example VII comprising N-4 (a compound comprising an arylamine moiety) as first compound in the first semiconductor layer, C60 as the third compound and as electron acceptor compound, N-4 (a compound comprising an arylamine moiety) as the fourth compound and as electron donor compound, and BCP instead of a mono-6-membered heteroaryl comprising one, two, three or more nitrogen atoms as second compound in the second semiconductor layer exhibits at an applied voltage of +3 V a dark current density of 1.2E-03 mA/cm2, and a photocurrent density by illumination of 1.4E-02 mA/cm2, and a SNR of 11.

The OPD of inventive example II comprising N-4 (a compound comprising an arylamine moiety) as first compound in the first semiconductor layer, C60 as the third compound and as electron acceptor compound, N-4 (a compound comprising an arylamine moiety) as as the fourth compound and as electron donor compound, and N-11 (a mono-6-membered heteroaryl comprising one, two, three or more nitrogen atoms) as second compound in the second semiconductor layer exhibits at an applied voltage of +3 V a dark current density of 1.0E-05 mA/cm2, and a photocurrent density by illumination of 2.4E-02 mA/cm2, and a SNR of 2380.

The OPD of inventive example II exhibits a remarkably lower dark current density, a remarkably higher photocurrent density under illumination, and a remarkably higher signal to noise ratio compared to the OPD of comparative example IV to VII.

It can be shown that an OPD (comparative example V) comprising SubPc as the fourth compound was used instead of compound comprising an arylamine moiety, and BCP instead of a mono-6-membered heteroaryl comprising one, two, three or more nitrogen atoms as second compound in the second semiconductor layer exhibits a high dark current density, a low photocurrent density by illumination, and low signal to noise ratio.

When using using N-11 which is a mono-6-membered heteroaryl comprising one, two, three or more nitrogen atoms as the second compound in the second semiconductor layer (comparative example VI) compared to comparative example V results in an OPD exhibiting also a high dark current density, a low photocurrent density by illumination, and low signal to noise ratio.

When using using N-4 which is a compound comprising an arylamine moiety as the first compound in the first semiconductor layer (comparative example VII) compared to comparative example V results in an OPD exhibiting also a high dark current density, a low photocurrent density by illumination, and low signal to noise ratio.

However, when using N-4 which is a compound comprising an arylamine moiety as the fourth compound, and N-11 which is a mono-6-membered heteroaryl comprising one, two, three or more nitrogen atoms as the second compound in the second semiconductor layer (inventive example II) compared to comparative example V results in an OPD exhibiting a lower dark current density, a higher photocurrent density by illumination, and higher signal to noise ratio.

In Table 4, the dark current density, photocurrent density by illumination (under exposure of light or irradtion or when exposed to light or irradiation) and signal to noise ratio (SNR) of inventive and comparative devices are shown.

The OPD of Inventive Example III comprises a photoconversion unit two layers, namely an acceptor layer and donor layer. The third compound is the electron acceptor compound, and the fourth compound is the electron donor compound. This OPD exhibits a low dark current density, a high photocurrent, and a high signal to noise ratio.

In Table 5, the dark current density, photocurrent density by illumination (under exposure of light or irradtion or when exposed to light or irradiation) and signal to noise ratio (SNR) of inventive and comparative devices are shown.

The OPD of Inventive Example IV comprises a photoconversion unit with one layer, wherein the third compound is the electron acceptor compound, and layer comprising the fourth compound. This OPD exhibits a low dark current density, a high photocurrent, and a high signal to noise ratio.

In Table 6, the dark current density, photocurrent density by illumination (under exposure of light or irradtion or when exposed to light or irradiation) and signal to noise ratio (SNR) of inventive and comparative devices are shown.

The OPDs of inventive Examples X to IX each comprise a photoconversion unit two layers, namely an acceptor layer and donor layer, wherein the third compound is the electron acceptor compound, and layer comprising the fourth compound. This OPD exhibits a low dark current density, a high photocurrent, and a high signal to noise ratio.

In Table 7, the dark current density, photocurrent density by illumination (under exposure of light or irradtion or when exposed to light or irradiation) and signal to noise ratio (SNR) of inventive and comparative devices are shown.

The OPD of inventive Example X comprises a photoconversion unit two layers, namely an acceptor layer and donor layer, wherein the fourth compound is the electron donor compound, and layer comprising the third compound. This OPD exhibits a low dark current density, a high photocurrent, and a high signal to noise ratio.

In Table 6, the dark current density, photocurrent density by illumination (under exposure of light or irradtion or when exposed to light or irradiation) and signal to noise ratio (SNR) of inventive and comparative devices are shown.

The OPDs of inventive Examples XI to XIV each comprise a photoconversion unit with one layer, a layer comprising the third compound, and a layer comprising the fourth compound. This OPD exhibits a low dark current density, a high photocurrent, and a high signal to noise ratio.

In Table 9, the dark current density, photocurrent density by illumination (under exposure of light or irradtion or when exposed to light or irradiation) and signal to noise ratio (SNR) of three inventive devices are shown.

The OPDs of inventive Examples XV to XVII comprises a photoconversion unit two layers, namely an acceptor layer and donor layer, a layer comprising the third compound, and a layer comprising the fourth compound. This OPD exhibits a low dark current density, a high photocurrent, and a high signal to noise ratio.

**Table 1: Data for compounds used in comparatives and inventive devices**

| | Abb. | Structure | LUMO [eV] | HOMO [eV] | Egap [eV] |
|---|---|---|---|---|---|
| | | CAS No. | | | |
| | | Name | | | |
| N-1 | | 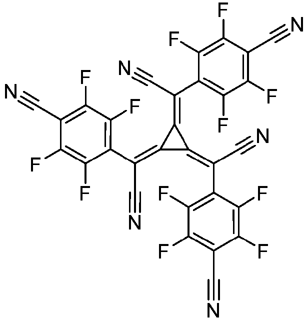 [1224447-88-4] | -5.53 | -8.04 | 2.51 |
| | | 4,4',4"-((1E,1'E,1"E)-cyclopropane-1,2,3-triylidenetris(cyanomethanylylidene))tris(2,3,5,6-tetrafluorobenzonitrile) | | | |
| N-2 | | 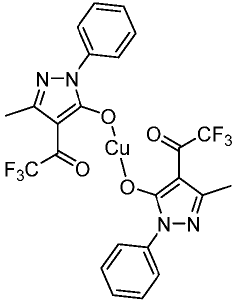 [81714-07-0] | -4.24 | -6.26 | 2.02 |
| | | Bis((Z)-2,2,2-trifluoro-1-(3-methyl-5-oxo-1-phenyl-1,5-dihydro-4H-pyrazol-4-ylidene)ethoxy)copper | | | |
| N-3 | LiQ | 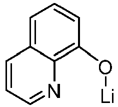 [850918-68-2] | -1.52 | -4.86 | 3.34 |
| | | (8-Hydroxyquinolinato)lithium | | | |
| N-4 | | 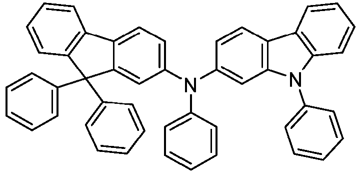 [1607480-22-7] | -1.30 | -4.90 | 3.66 |
| | | N-(9,9-diphenyl-9H-fluoren-2-yl)-N,9-diphenyl-9H-carbazol-2-amine | | | |
| N-5 | | 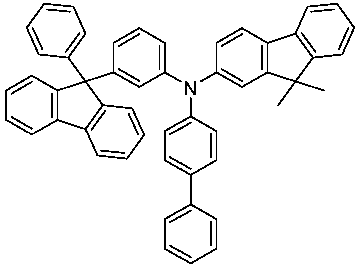 [2226747-62-0] | -1.28 | -4.98 | 3.70 |
| | | N-([1,1'-biphenyl]-4-yl)-9,9-dimethyl-N-(3-(9-phenyl-9H-fluoren-9-yl)phenyl)-9H-fluoren-2-amine | | | |
| N-6 | TCNAQ | 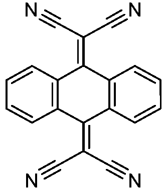 [70359-39-6] | -4.10 | -7.39 | 3.29 |
| | | 2,2'-(anthracene-9,10-diylidene)dimalononitrile | | | |
| N-7 | SubPc | 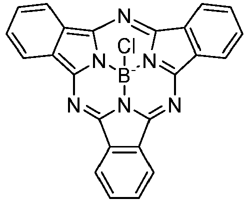 | -2.82 | -5.47 | 2.65 |
| | | [36530-06-0] | | | |
| | | Boron subphthalocyanine chloride | | | |
| N-8 | | 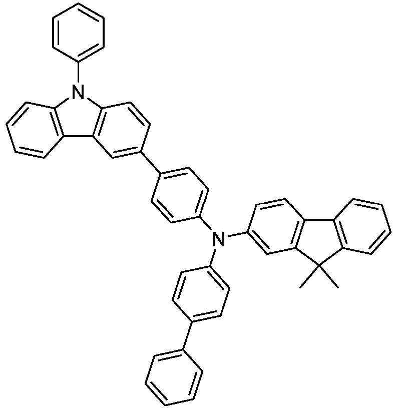 [1242056-42-3] | -1.28 | -4.89 | 3.61 |
| | | N-([1,1'-biphenyl]-4-yl)-9,9-dimethyl-N-(4-(9-phenyl-9H-carbazol-3-yl)phenyl)-9H-fluoren-2-amine | | | |
| N-9 | | 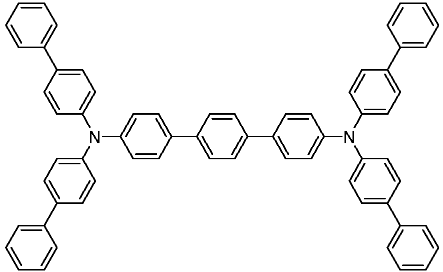 | -1.58 | -4.97 | 3.39 |
| | | [952431-34-4] | | | |
| | | N4,N4,N4",N4"-tetra([1,1'-biphenyl]-4-yl)-[1,1':4',1"-terphenyl]-4,4"-diamine | | | |
| N-10 | C60 | 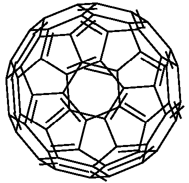 [99685-96-8] | -3.66 | -6.30 | 2.64 |
| | | Fullerence-C₆₀ | | | |
| N-11 | | 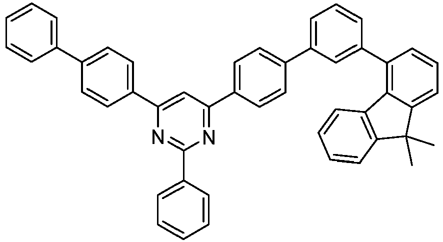 [1955546-40-3] | -2.15 | -5.74 | 3.79 |
| | | 4-([1,1'-biphenyl]-4-yl)-6-(3'-(9,9-dimethyl-9H-fluoren-4-yl)-[1,1'-biphenyl]-4-yl)-2-phenylpyrimidine | | | |
| N-12 | | 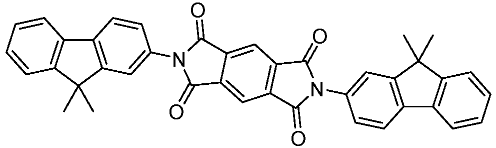 2,6-bis(9,9-dimethyl-9H-fluoren-2-yl)pyrrolo[3,4-f]isoindole-1,3,5,7(2H,6H)-tetraone | -3.49 | -5.98 | 2.49 |
| N-13 | | 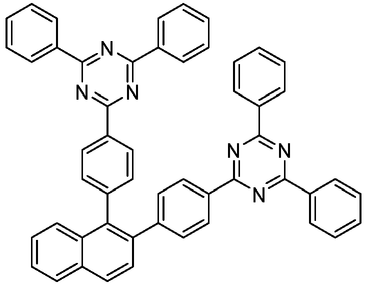 6,6'-(naphthalene-1,2-diylbis(4,1-phenylene))bis(2,4-diphenyl-1,3,5-triazine) | -2.24 | -5.91 | 3.67 |
| N-14 | BCP | 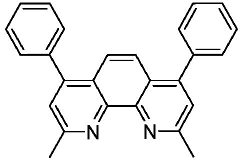 2,9-dimethyl-4,7-diphenyl-1,10-phenanthroline | -1.52 | -6.03 | 4.51 |
| | | [4733-39-5] | | | |
| N-15 | | 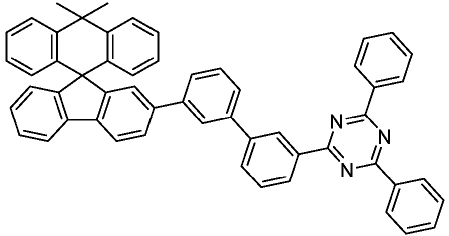 2-(3'-(10,10-dimethyl-10H-spiro[anthracene-9,9'-fluoren]-2'-yl)-[1,1'-biphenyl]-3-yl)-4,6-diphenyl-1,3,5-triazine | -2.11 | -5.74 | 3.63 |
| | | [2231618-84-9] | | | |
| N-16 | ZnPc | 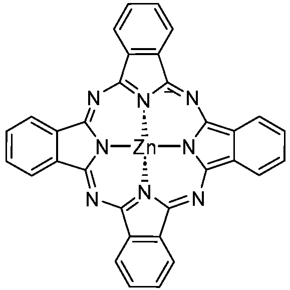 Zinc Phthalocyanine | -3.01 | -5.13 | 2.12 |
| | | [14320-04-8] | | | |
| N17 | | 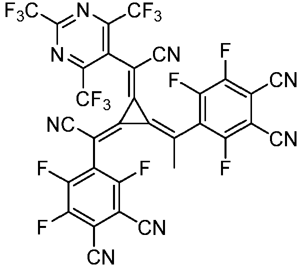 4-(cyano(2-(cyano(2,4,6-tris(trifluoromethyl)pyrimidin-5-yl)methylene)-3-(cyano(3,4-dicyano-2,5,6-trifluorophenyl)methylene)cyclopropylidene)methyl)-3,5,6-trifluorophthalonitrile | -5.71 | -8.48 | 2.77 |
| | | [2938878-54-5] | | | |
| N-18 | | 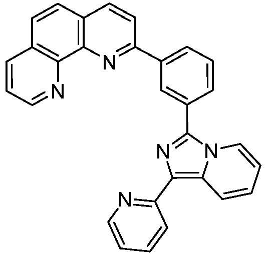 2-(3-(1-(pyridin-2-yl)imidazo[1,5-a]pyridin-3-yl)phenyl)-1,10-phenanthroline | -2.03 | -5.12 | 3.09 |
| | | [3044817-21-9] | | | |

**Table 2: Setup and data for one inventive and four comparative examples**

| | | | Photoconversion unit with two layer | | | | | | |
|---|---|---|---|---|---|---|---|---|---|
| Example | 1 stCpd in 1 stlayer | ΔHOMO - Barrier [eV] | Acceptor layer ^{3rd}Cpd= Electron acceptor compound | Donor layer ^{4th}Cpd = Electron donor compound | ΔLUMO - Barrier [eV] | ^{2nd}Cpd in 2^{nd} layer | Dark current at +3V mA/cm² | J at +3V mA/cm | SNR at +3V |
| Comparative example I | ZnPc | 1.17 | C60 | SubPc | -1.3 | BCP | 3.9E-04 | 2.1E-03 | 6 |
| Comparative example II | N-4 | 1.4 | C60 | SubPc | -1.3 | BCP | 2.9E-03 | 4.5E-03 | 2 |
| Comparative example III | N-4 | 1.4 | C60 | SubPc | -0.67 | N-11 | 2.6E-02 | 1.7E-01 | 7 |
| Comparative example IV | N-4 | 1.4 | C60 | N-4 | 0.22 | BCP | 2.9E-03 | 6.5E-03 | 2 |
| Inventive example I | N-4 | 1.4 | C60 | N-4 | 0.85 | N-11 | 1.0E-05 | 2.4E-02 | 2380 |

**Table 3: Setup and data for one inventive and three comparative devices**

| | | | Photoconversion unit with two laye | | | | | | | | | |
|---|---|---|---|---|---|---|---|---|---|---|---|---|
| Example | 1 stCpd in 1 stlayer | ΔHOMO - Barriere [eV] | Acceptor layer ^{3rd}Cpd= Electron acceptor compound | Donor layer ^{4th}Cpd = Electron donor compound | ΔLUMO - Barriere [eV] | ^{2nd}Cpd in 2^{nd} layer | Dark current at -3V mA/cm² | J at -3V mA/cm | SNR at - 3V | Dark current at +3V mA/cm² | J at +3V mA/cm | SNR at +3V |
| Comparative example V | N-4 | 1.4 | C60 | SubPc | -1.3 | BCP | 1. 8E-06 | 3.6E-03 | 2047 | 1.2E-04 | 4.6E-03 | 39 |
| Comparative example VI | N-4 | 1.4 | C60 | SubPc | -0.67 | N-11 | 1.3E-06 | 2.2E-03 | 1750 | 9.5E-03 | 2.5E-01 | 27 |
| Comparative example VII | N-4 | 1.4 | C60 | N-4 | 0.22 | BCP | 2.7E-06 | 3.5E-03 | 1321 | 1.2E-03 | 1.4E-02 | 11 |
| Inventive example II | N-4 | 1.4 | C60 | N-4 | 0.85 | N-11 | 1.2E-06 | 2.4E-03 | 2053 | 1.1E-05 | 3.5E-02 | 3153 |

**Table 4: Setup and data for one inventive device**

| | | Photoconversion unit with two layers | | | | | |
|---|---|---|---|---|---|---|---|
| Example | 1 stCpd in 1 stlayer | Acceptor layer ^{3rd}Cpd= Electron acceptor compound | Donor layer ^{4th}Cpd = Electron donor compound | ^{2nd}Cpd in 2^{nd} layer | Dark current at +3V mA/cm² | J at +3V mA/cm | SNR at +3V |
| Inventive Example III | N-4 | C60 | N-4 | N-11 | 9.9E-06 | 4.2E-02 | 4242 |

**Table 5: Setup and data for one inventive device**

| Example | ^{1st}Cpd in ^{1st}layer | Photoconversion unit with one layer | | ^{4th}Cpd | ^{2nd}Cpd in 2^{nd} layer | Dark current at +3V mA/cm² | J (exposure to light) at +3V mA/cm² | SNR at +3V |
|---|---|---|---|---|---|---|---|---|
| | | Electron acceptor compound and Electron donor Compound in a single layer | | | | | | |
| | | 3^{rd}Cpd = Electron acceptor Compound | Electron Donor Compoun | | | | | |
| Inventive Example IV | N-4 | C60 | SubPc | N-8 | N-11 | 6.9E-05 | 1.1E-01 | 1593 |

**Table 6: Setup and data for five inventive devices**

| Example | ^{1st}Cpd in ^{1st}layer | Photoconversion unit as with two layer | | ^{4th}Cpd | ^{2nd}Cpd in 2^{nd} layer | Dark current at +3V mA/cm² | J at +3V mA/cm | SNR at +3V |
|---|---|---|---|---|---|---|---|---|
| | | Acceptor Layer ^{3rd}Cpd=Electron Acceptor Compound | Donor Layer Electron Donor Compound | | | | | |
| Inventive Example V | N-5 | TCNAQ | SubPc(Donor): TCNAQ | N-8 | N-11 | 8.5E-06 | 2.5E-03 | 298 |
| Inventive Example VI | N-4 | C60 | SubPc(Donor): C60(Acceptor) | N-8 | N-11 | 6.5E-06 | 1.1E-01 | 17233 |
| Inventive Example VII | N-5 | TCNAQ | SubPc(Donor): C60(Acceptor), | N-8 | N-11 | 1.8E-05 | 1.0E-01 | 5672 |
| Inventive Example VIII | N-4: C60 | C60 | N-4(Donor): C60(Acceptor) | N-4 | N-11, | 9.2E-05 | 5.9E-02 | 641 |
| Inventive Example IX | N-4 | C60 | SubPC | N-4 | N-11 | 8.3E-06 | 7.8E-02 | 9388 |

**Table 7: Setup and data for one inventive device**

| Example | ^{1st}Cpd in ^{1st}layer | ^{3rd}Cpd | Photoconversion unit with two layer | | ^{2nd}Cpd in 2^{nd} layer | Dark current at +3V mA/cm² | J at +3V mA/cm | SNR at +3V |
|---|---|---|---|---|---|---|---|---|
| | | | Acceptor Layer | Donor Layer | | | | |
| | | | Electron Acceptor Compound | ^{4th}Cpd=Electron Donor Compound | | | | |
| Inventive Example X | N-5 | C60 | C60 | N-4 | N-11 | 9.2E-06 | 6.0E-02 | 6538 |

**Table 8: Setup and data for four inventive devices**

| Example | ^{1st}Cpd in ^{1st}layer | ^{3rd}Cpd | Photoconversion unit with one layer | | ^{4th}Cpd | ^{2nd}Cpd in 2^{nd} layer | Dark current at +3V mA/cm² | J at +3V mA/cm | SNR at +3V |
|---|---|---|---|---|---|---|---|---|---|
| | | | Electron acceptor compound and Electron donor | | | | | | |
| | | | Compound in a single layer | | | | | | |
| | | | Electron Acceptor Compound | Electron Donor Compound | | | | | |
| Intentive Example XI | N-4 | C60 | C60 | N-4 | N-4 | N-11 | 7.5E-05 | 1.1E-01 | 1467 |
| Inventive Example XII | N-4 | C60 | C60 | SubPc | N-8 | N-11 | 6.5E-06 | 1.1E-01 | 17233 |
| Inventive Example XIII | N-5 | TCNAQ | C60 | SubPc | N-8 | N-11 | 1.8E-05 | 1.0E-01 | 5672 |
| Inventive Example XIV | N-4 | C60 | C60 | N-4 | N-4 | N-11 | 9.2E-05 | 5.9E-02 | 641 |

**Table 9: Setup and data for three inventive devices**

| Example | ^{1st}Cpd in ^{1st}layer | ^{3rd}Cpd | Photoconversion unit with two layer | | ^{4th}Cpd | ^{2nd}Cpd in 2^{nd} layer | Dark current at +3V mA/cm² | J at +3V mA/cm | SNR at +3V |
|---|---|---|---|---|---|---|---|---|---|
| | | | Acceptor Layer | Donor Layer | | | | | |
| | | | Electron Acceptor Compound | Electron Donor Compound | | | | | |
| Inventive Example XV | N-5 | C60 | C60 | C60(Acceptor): N-4(Donor) | N-4 | N-11 | 4.8E-05 | 3.5E-02 | 741 |
| Inventive Example XVI | N-5 | C60 | C60 | C60(Acceptor: SubPc(Donor) | N-8 | N-11 | 6.8E-06 | 1.2E-01 | 17238 |
| Inventive Example XVII | N-4 | SubPc | TCNAQ | SubPC | N-4 | N-11 | 2.0E-05 | 2.1E-02 | 1050 |

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

1. A display comprising a substrate, a first pixel, and a second pixel,
wherein the first pixel comprises an organic photodetector,
wherein the second pixel comprises an organic light-emitting device;
wherein the organic photodetector is disposed directly on the substrate and the organic light-emitting device is disposed directly on the substrate;
wherein the organic photodetector comprises a first semiconductor layer, a second semiconductor layer, an intermediate layer system, a substrate, a first electrode, and a second electrode;
wherein the intermediate layer system is arranged between the first semiconductor layer and the second semiconductor layer and comprises one or more layers;
wherein the first semiconductor layer is arranged closer to first electrode than the second semiconductor layer;
wherein the first semiconductor layer is arranged between the first electrode and the intermediate layer system, and in direct contact to the intermediate layer system; wherein the second semiconductor layer is arranged between the second electrode and the intermediate layer system, and in direct contact to the intermediate layer system; wherein the first semiconductor layer comprises a first compound which comprises an arylamine moiety;
wherein the second semiconductor layer comprises a second compound different from the first compound which comprises a mono-6-membered heteroaryl;
wherein the mono-6-membered heteroaryl comprises one, two, three or more nitrogen atoms;
wherein the intermediate layer system comprises a third compound different from the first compound and which is either a donor or acceptor compound.
wherein the intermediate layer system comprises a fourth compound different from the second and third compound, is in direct contact to the second semiconductor layer and comprises an arylamine moiety;
wherein the intermediate layer system comprises a photoconversion unit,
wherein the photoconversion unit comprises an electron donor compound and an electron acceptor compound in direct contact to each other, wherein the LUMO energy level of the electron donor compound is larger than the LUMO energy level of the electron acceptor compound;
wherein the electron donor compound or the electron acceptor compound absorbs light in the visible and/or in the near-infrared region.

2. The display of Claim 1, whereby in operation a positive voltage is applied both on the organic photodetector, and on the organic light-emitting device.

3. The display of Claim 1 or 2, wherein the third compound has hole-blocking properties.

4. The display of any of the claims 1 to 3, wherein the fourth compound has electronblocking properties.

5. The display of any of the claims 1 to 4, whereby the first and fourth compound are identical and/or the first and/or fourth compound have an energy gap Egap of ≥ 3.3 eV.

6. The display of any of the Claim 1 to 5, whereby the second and third compound are identical.

7. The display of any of the Claim 1 to 6, whereby the first layer is a hole transport layer and/or the second layer is an electron transport layer and/or hole blocking layer.

8. The display of any of the Claim 1 to 7, whereby the first and/or fourth compound are independently selected from a compound comprising at least one arylamine moiety, diarylamine moiety, triarylamine moiety or a compound of formula (IIIa) or a compound of formula (IIIb): 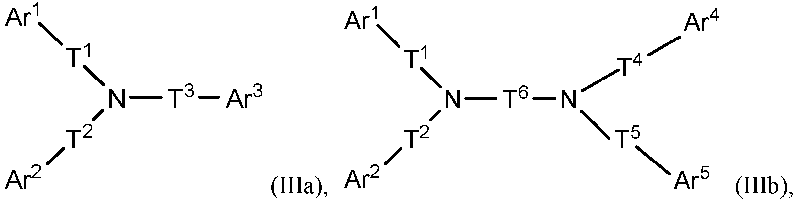 wherein:
T¹, T², T³, T⁴ and T⁵ are independently selected from a single bond, phenylene, biphenylene, terphenylene or naphthenylene, preferably a single bond or phenylene;
T⁶ is phenylene, biphenylene, terphenylene or naphthenylene;
Ar¹, Ar², Ar³, Ar⁴ and Ar⁵ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar¹, Ar², Ar³, Ar⁴ and Ar⁵ are selected the same or different from the group comprising H, D, F, C(-O)R², CN, Si(R²)₃, P(-O)(R²)₂, OR², S(-O)R², S(-O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

9. The display of any of the Claim 1 to 8, wherein the second and/or third compound independently of each other comprise a moiety selected from formula (xxa) or formula (xxb) 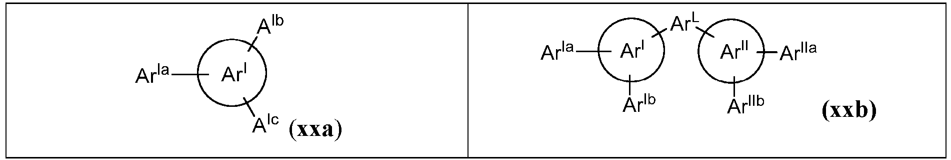
wherein Ar^{I} is a substituted or unsubstituted C₃ to C₅ heteroaromatic ring comprising at least one nitrogen atom,
wherein Ar^{II} is substituted or unsubstituted C₃ to C₄₀ heteroaromatic ring comprising at least one nitrogen atom,
wherein the substituents on Ar^{I} and Ar^{II} are, identically or differently on each occurrence, D, a monovalent aromatic or heteroaromatic ring system having 5 to 60 aromatic ring atoms, which may in each case be substituted by one or more radicals R^{a};
wherein Ar^{Ia}, Ar^{Ib}, Ar^{Ic}, Ar^{IIa}, and Ar^{IIb} are, identically or differently on each occurrence, H, D, a monovalent aromatic or heteroaromatic ring system having 5 to 60 aromatic ring atoms, which may in each case be substituted by one or more radicals R^{a};
wherein at least one of Ar^{Ia}, Ar^{Ib}, Ar^{Ic} in formula (xxa) and in case of formula (xxb) at least one of
Ar^{Ia}, Ar^{Ib}, Ar^{IIa}, and Ar^{IIb} is independently selected from a monovalent aromatic or heteroaromatic ring system having 5 to 60 aromatic ring atoms, which may in each case be substituted by one or more radicals R^{a};
wherein Ar^{L} is a divalent aromatic or heteroaromatic ring system having 5 to 60 aromatic ring atoms, which is optionally substituted by one or more radicals R^{a};
wherein R^{a} is on each occurrence, identically or differently, H, D, F, Cl, Br, I, CHO, N(R^{b})₂, N(Ar^{1s})₂, B(Ar^{1s})₂, C(=O)Ar^{1s}, P(=Y)(R^{c})₂, S(=O)Ar^{1s}, S(=O)₂Ar^{1s}, CR^{b}=CR^{b}Ar^{1s}, CN, NO₂, Si(R^{b})₃, B(OR^{b})₂, B(R^{b})₂, B(N(R^{b})₂)₂, OSO₂R^{b}, a substituted or unsubstituted straight-chain C₁ to C₂₀ alkyl, a substituted or unsubstitutedstraight-chain C₁ to C₂₀ alkenyl, a substituted or unsubstituted straight-chain C₁ to C₂₀ alkynyl, a substituted or unsubstituted straight-chain C₁ to C₂₀ alkoxy, a substituted or unsubstituted straight-chain C₁ to C₂₀ thioalkoxy, substituted or unsubstituted branched C₃ to C₂₀ alkyl, a substituted or unsubstituted branched C₃ to C₂₀ alkenyl, a substituted or unsubstituted branched C₃ to C₂₀ a substituted or unsubstituted branched C₃ to C₂₀ alkynyl, a substituted or unsubstituted branched C₃ to C₂₀ alkoxy or a substituted or unsubstituted C₃ to C₂₀ branched thioalkoxy,substituted or unsubstituted cyclic C₃ to C₄₀ alkyl, substituted or unsubstituted cyclic C₃ to C₄₀ alkenyl, substituted or unsubstituted cyclic C₃ to C₄₀ alkinyl, substituted or unsubstituted cyclic C₃ to C₄₀ alkoxy or substituted or unsubstituted cyclic C₃ to C₄₀ thioalkoxy;substituted or unsubstituted heterocyclic C₃ to C₄₀ alkyl, substituted or unsubstituted heterocyclic C₃ to C₄₀ alkenyl, substituted or unsubstituted heterocyclic C₃ to C₄₀ alkynyl, substituted or unsubstituted heterocyclic C₃ to C₄₀ alkoxy or substituted or unsubstituted heterocyclic C₃ to C₄₀ thioalkoxy; wherein the one or more substituents, if present, is selected from R^{b}, where one or more non-adjacent CH₂ groups is optionally replaced by R^{b}C=CR^{b}, C≡C, Si(R^{b})₂, Ge(R^{b})₂, Sn(R^{b})₂, C=O, C=S, C=Se, C=NR^{b}, P(=O)(R^{b}), SO, SO₂, NR^{b}, O, S or CONR^{b} and where one or more H atoms is optionally replaced by D, F, Cl, Br, I, CN or NO₂, or an aromatic or heteroaromatic ring system having 5 to 60 aromatic ring atoms, which may in each case be substituted by one or more radicals R^{b}, or an aryloxy or heteroaryloxy group having 5 to 60 aromatic ring atoms, which is optionally substituted by one or more radicals R^{b}, or a combination of these systems; two or more adjacent substituents R^{a} here optionally forms a mono- or polycyclic, aliphatic or aromatic ring system with one another;
wherein Ar^{1s} is on each occurrence, identically or differently, an aromatic or heteroaromatic ring system having 5 to 30 aromatic ring atoms, which is optionally substituted by one or more radicals R^{b}; two radicals Ar^{1s} here which are bonded to the same nitrogen, phosphorus or boron atom may also be linked to one another by a single bond or a bridge selected from B(R^{b}), C(R^{b})₂, Si(R^{b})₂, C=O, C=NR^{b}, C=C(R^{b})₂, O, S, S=O, SO₂, N(R^{b}), P(R^{b}) and P(=Y)R^{c};
wherein R^{b} is on each occurrence, identically or differently, H, D or a C₁ to C₂₀ aliphatic hydrocarbyl, a C₁ to C₂₀ aryl and/or C₁ to C₂₀ heteroaryl, in which, in addition, H atoms is optionally replaced by D or F; two or more adjacent substituents R^{b} here may also form a mono- or polycyclic, aliphatic or aromatic ring system with one another;
wherein Y is selected from O, S or Se, preferably O, and R^{c} is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy.

10. Use of a display according any of the claims 1 to 9 for photodetection and displaying by applying a positive voltage on the organic photodetector and applying a positive voltage on the organic light-emitting device.

11. A method of operating a display according to any of the claims 1 to 9, including the step of applying positive voltage on both the organic photodetector and on the organic light-emitting device.

12. An electronic device comprising a display, one or more voltage source, wherein the one or more voltage source is adapted as such that a positive voltage can be generated, wherein one of one or more voltage source out of said voltage sources that are adapted that a positive voltage can be generated is connected to the organic photodetector, and wherein one of the one or more voltage source out of said voltage sources that are adapted that a positive voltage can be generated is connected to the organic light-emitting device.

13. The electronic device of Claim 12 whereby the display is a display according to any of the claims 1 to 9.

14. A compound of formula (X): 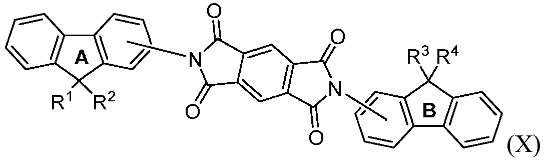 wherein
R¹, R², R³, R⁴ are independently selected from C₁ to C₄ alkyl, C₆ to C₁₂ aryl, C₂ to C₁₂ heteroaryl;
R¹ and R² together; and/or R³ and R⁴ together can form a fused ring system; and
fluorene A and/or fluorene B can be independently substituted with one or more substituents.

15. Use of a compound of formula (X) in an organic electronic device especially a display, an organic electroluminescent device or organic photodetector.
